(19) Europäisches Patentamt
European Patent Office
Office européen des brevets

(11) **EP 2 253 961 A1**

(12) **EUROPEAN PATENT APPLICATION**
published in accordance with Art. 153(4) EPC

(43) Date of publication:
**24.11.2010 Bulletin 2010/47**

(51) Int Cl.:
***G01R 1/073*** *(2006.01)*      ***H01R 11/01*** *(2006.01)*

(21) Application number: **09720004.2**

(22) Date of filing: **09.03.2009**

(86) International application number:
**PCT/JP2009/054408**

(87) International publication number:
**WO 2009/113486 (17.09.2009 Gazette 2009/38)**

(84) Designated Contracting States:
**AT BE BG CH CY CZ DE DK EE ES FI FR GB GR
HR HU IE IS IT LI LT LU LV MC MK MT NL NO PL
PT RO SE SI SK TR**
Designated Extension States:
**AL BA RS**

(30) Priority: **14.03.2008   JP 2008066484
14.03.2008   JP 2008065593
23.04.2008   JP 2008112289**

(71) Applicant: **FUJIFILM Corporation
Tokyo 106-0031 (JP)**

(72) Inventors:
• **TOMITA, Tadabumi
Haibara-gun
Shizuoka 421-0302 (JP)**
• **HOTTA, Yoshinori
Haibara-gun
Shizuoka 421-0302 (JP)**
• **UESUGI, Akio
Haibara-gun
Shizuoka 421-0302 (JP)**
• **HATANAKA, Yusuke
Haibara-gun
Shizuoka 421-0302 (JP)**

(74) Representative: **HOFFMANN EITLE
Patent- und Rechtsanwälte
Arabellastrasse 4
81925 München (DE)**

(54) **PROBE GUARD**

(57)   An object of the present invention is to provide a probe card which has good stability of the connection between testing electrodes and test electrodes even after exposure to high temperatures in the burn-in test, and is less susceptible to displacements in the positions of contact between the testing electrodes and conductive portions or between the conductive portions and probe needles or the test electrodes even after repeated use of the probe card. The probe card of the present invention is a probe card which includes a testing circuit board having the testing electrodes formed so as to correspond to the test electrodes and an anisotropic conductive member electrically connecting the test electrodes with the testing electrodes. The testing electrodes are formed so that at least ends of the testing electrodes protrude from a surface of the testing circuit board, and the anisotropic conductive member is a member which has an insulating base made of an anodized aluminum film having micropores therein and a plurality of conductive paths made of a conductive material, insulated from one another, and extending through the insulating base in a thickness direction of the insulating base.

FIG.4

**Description**

TECHNICAL FIELD

The present invention relates to a probe card that may be used to test electrical properties of a test object such as a semiconductor wafer, and a probe tester including such a probe card.

The present invention also relates to a conductive member and particularly to a laminate of an anisotropic conductive structure using an anodized aluminum film and a conductive layer.

BACKGROUND ART

In the process of manufacturing semiconductor integrated circuit devices, semiconductor chips are generally obtained by forming a large number of integrated circuits on a wafer and dicing the wafer.
In order to test the electrical properties, the semiconductor chips are subjected to a probe test or a burn-in test in the state of a wafer, in the state of a wafer diced into individual semiconductor chips, or in the state of a package before sealing with a resin.

Regarding such a test, Patent Document 1 discloses a probe card that may be used to test electrical properties of a test object by contact with test electrodes of the test object, the probe card comprising probe needles electrically contacting the test electrodes of the test object, a probe needle fixing holder for fixing the proximal ends of the probe needles so that the vicinities of the distal ends of the probe needles are exposed at the surface, a testing circuit board in which testing electrodes are formed so as to correspond to the test electrodes of the test object, and an anisotropic conductive sheet for electrically connecting the proximal ends of the probe needles exposed on the back surface side of the probe needle fixing holder with the testing electrodes of the testing circuit board;
the anisotropic conductive sheet comprising an elastic anisotropic conductive film that includes a plurality of connecting conductive portions spaced apart from each other in the planar direction and extending in the thickness direction and an insulating portion formed between the connecting conductive portions, and a frame plate supporting the elastic anisotropic conductive film.

Patent Document 2 discloses a probe card for testing electrical properties of a test object located below, comprising: a circuit board; and a testing contact structure provided between the circuit board and the test object and passing current between the test object and the circuit board,
the testing contact structure comprising: a substrate in a flat plate shape; and sheets attached to both upper and lower surfaces of the substrate to have the substrate sandwiched therebetween, each of the sheets composed of a plurality of elastic conductive portions and an insulating portion interconnecting the conductive portions,
the conductive portions being formed to extend through each of the sheets and protrude from both upper and lower surfaces of each of the sheets,
the substrate having a plurality of current-carrying paths passing from the upper surface to the lower surface of the substrate, the conductive portions of the sheets located on both surfaces of the substrate being electrically connected to corresponding current-carrying paths of the substrate,
the sheets located on both surfaces of the substrate being fixed to the substrate, and
the sheet on the upper surface side of the substrate being fixed to the circuit board.

On the other hand, Patent Document 3 discloses an anisotropic conductive substrate obtained by using a polyether imide resin as an insulating material and electric wire (copper wire) as a conductive material (Example 1).
Non-Patent Document 1 discloses a method of manufacturing a printed circuit board which involves irradiating an anodized aluminum substrate with YAG laser light to perforate the anodized film to thereby form holes reaching part of the aluminum substrate and further plating the anodized aluminum substrate with a metal.

Patent Document 1: JP 2007-225501 A;
Patent Document 2: JP 2008-39768 A;
Patent Document 3: JP 2000-31621 A;
Non-Patent Document 1: Title: Manufacture of Printed Circuit Board Making Use of Anodization of Aluminum (Hyomen Kagaku (Journal of The Surface Science Society of Japan), Vol. 22, No. 6, pp. 370-375, 2001, Takahashi)

DISCLOSURE OF THE INVENTION

PROBLEMS TO BE SOLVED BY THE INVENTION

In the probe cards described in Patent Documents 1 and 2, the conductive portions (connecting conductive portions) of the sheet (anisotropic conductive sheet) are obtained by filling conductive particles into an insulating elastic polymer material and therefore electrical conduction of the conductive portions is possible when the conductive portions are compressed in the vertical direction.

The inventors of the present invention have studied the probe cards described in Patent Documents 1 and 2 and as a result found that in these probe cards, the conductive portions are made of the elastic polymer material as described above and therefore the conductive portions exposed to high temperatures in the burn-in test may get brittle to deteriorate the stability of the connection between the testing electrodes of the testing circuit board (hereinafter referred to simply as "testing electrodes") and the test electrodes of the test object (hereinafter also referred to simply as "test electrodes"). As described above, electrical conduction is possible when the conductive portions are compressed vertically. Therefore, it has been also found that displacements in the contact positions may occur by repeating in a compressed state, the contact between the testing electrodes and the conductive portions or the contact between the probe needles and the test electrodes.

On the other hand, in the probe card described in Patent Document 1, the conductive particles filled into the conductive portions have a number-average particle size of 20 to 80 $\mu$m and the pitch of the conductive portions are therefore equal to or larger than the number-average particle size. Likewise, the pitch between adjacent conductive portions in the probe card described in Patent Document 2 is about 180 $\mu$m.

However, with the increasing trend in recent years toward higher integration, electrode (terminal) sizes in electronic components such as semiconductor devices are becoming smaller, the number of electrodes (terminals) is increasing, and the distance between terminals is becoming smaller.

Therefore, it was found that these probe cards may not be suitably used to evaluate the electrical properties of the test electrodes.

Accordingly, a first object of the present invention is to provide a probe card which has good stability of the connection between the testing electrodes and the test electrodes even after exposure to high temperatures in the burn-in test, and is less susceptible to displacements in the positions of contact between the testing electrodes and the conductive portions (hereinafter also referred to as "conductive paths" in the present invention) or between the conductive portions and the probe needles or the test electrodes even after repeated use of the probe card.

A second object of the present invention is to provide a probe tester which includes a probe card fully compatible with electronic components such as semiconductor devices even today when still higher levels of integration have been achieved.

In addition, the methods of manufacturing the anisotropic conductive members as described in these prior art documents are complicated and the methods of manufacturing electrodes for connecting to such anisotropic conductive members are also complicated. Under the circumstances, a simpler manufacturing method has been desired to provide a lot of products with constant industrial quality.

## MEANS FOR SOLVING THE PROBLEMS

The inventors of the present invention have made an intensive study to achieve the first object and as a result found that a probe card uses as the anisotropic conductive member a specific member which has an insulating base made of an anodized aluminum film having micropores therein and a plurality of conductive paths made of a conductive material, insulated from one another, and extending through the insulating base in the thickness direction of the insulating base, one end of each of the conductive paths protruding from one side of the insulating base, the other end of each of the conductive paths protruding from the other side thereof. This probe card has good stability of the connection between the testing electrodes and the test electrodes even after exposure to high temperatures in the burn-in test, and is less susceptible to displacements in the positions of contact between the testing electrodes and the conductive portions or between the conductive portions and the probe needles or the test electrodes even after repeated use. The present invention has been thus completed.

The inventors of the present invention have made an intensive study to achieve the second object and as a result found that, even today when still higher levels of integration have been achieved, the above-described specific member used as the anisotropic conductive member is fully compatible with electronic components such as semiconductor devices by appropriately adjusting the orderliness and period of micropores in the film.

The inventors of the present invention also found that by using a member in which a conductive layer is formed on an anodized aluminum film having conductive portions in micropores, the anisotropic conductive member can be easily manufactured to facilitate the manufacture of electrodes of any pattern used to connect with the anisotropic conductive member.

Specifically, the present invention provides the following (1) to (9) and (10) to (16).

(1) A probe card which is brought into contact with test electrodes of a test object to test electrical properties of the test object, the probe card comprising: a testing circuit board having testing electrodes formed so as to correspond to the test electrodes; and an anisotropic conductive member electrically connecting the test electrodes with the testing electrodes, wherein the testing electrodes are formed so that at least ends of the testing electrodes protrude from a surface of the testing circuit board, and wherein the anisotropic conductive member is a member which has an insulating base and a plurality of conductive paths made of a conductive material, insulated from one another, and extending through the insulating base in a thickness direction of the insulating base, one end of each of the conductive paths protruding from one side of the insulating base, and the other end of each of the conductive paths protruding from the other side of the insulating base, and wherein the insulating base is a structure composed of an anodized aluminum film having micropores therein.

(2) The probe card according to (1), further comprising electric contacts for electrically contacting the test electrodes, connection between the test electrodes and the anisotropic conductive member being made via the electric contacts.

(3) The probe card according to (2), wherein the electric contacts are probe needles.

(4) The probe card according to (3), wherein a fixing holder for fixing the probe needles is provided so that both tips of the probe needles protrude from surfaces of the fixing holder.

(5) The probe card according to any one of (1) to (4),
wherein the testing circuit board is made of a material with a coefficient of thermal expansion of $2.5 \times 10^{-6}$ to $10 \times 10^{-6}K^{-1}$.

(6) The probe card according to any one of (1) to (5), which is used in the test object made of a material with a coefficient of thermal expansion of $2.5 \times 10^{-6}$ to $10 \times 10^{-6}K^{-1}$.

(7) The probe card according to any one of (4) to (6),
wherein the fixing holder is made of a material with a coefficient of thermal expansion of $2.5 \times 10^{-6}$ to $10 \times 10^{-6}K^{-1}$.

(8) A testing method using the probe card according to (1), comprising:

a pretreatment step in which protrusions of the conductive paths on a side of contact with the test electrodes are brought into contact with an alkaline aqueous solution or an acidic aqueous solution before testing the electrical properties of the test object; and
a testing step in which the protrusions after the pretreatment step are brought into contact with the test electrodes to test the electrical properties of the test object.

(9) A testing method using the probe card according to any one of (2) to (7), comprising:

a pretreatment step in which the electric contacts are brought into contact with an alkaline aqueous solution or an acidic aqueous solution before testing the electrical properties of the test object; and
a testing step in which the electric contacts after the pretreatment step are brought into contact with the test electrodes to test the electrical properties of the test object.

(10) A conductive member in which an anisotropic conductive structure including an anodized film of aluminum and a plurality of conductive paths made of a conductive material and extending through the anodized film in its thickness direction and a conductive layer are laminated and the anisotropic conductive structure and the conductive layer are electrically connected to each other.

(11) The conductive member according to (10) further comprising a photosensitive resin layer on the conductive layer and/or the anisotropic conductive structure.

(12) The conductive member according to (10) or (11), wherein the conductive layer has a wiring circuit pattern.

(13) A circuit board for use in a semiconductor testing probe card comprising the conductive member according to (12).

(14) A method of manufacturing a circuit board for use in a semiconductor testing probe card, wherein the conductive layer of the conductive member according to (12) except electrodes and/or a wiring portion is removed to obtain the circuit board for use in a semiconductor testing probe card.

(15) The method of manufacturing the circuit board for used in a semiconductor testing probe card according to (14), wherein the conductive layer is removed by etching using photolithography or is thermally removed by laser ablation.

(16) The conductive member according to any one of (10) to (12), wherein the plurality of conductive paths made of a conductive material extend through an insulating base in a mutually insulated state at a density of $1 \times 10^6$ to $1000 \times 10^6$ paths/$\mu$m$^2$, and more preferably $3 \times 10^6$ to $300 \times 10^6$ paths/$\mu$m$^2$.

EFFECTS OF THE INVENTION

As will be described later, the present invention can provide a probe card which has good stability of the connection between the testing electrodes and the test electrodes even after exposure to high temperatures in the burn-in test, and is less susceptible to displacements in the positions of contact between the testing electrodes and the conductive paths or between the conductive portions and the probe needles or the test electrodes even after repeated use of the probe card.

Even today when still higher levels of integration have been achieved, the present invention can provide a probe card fully compatible with electronic components such as semiconductor devices by appropriately adjusting the period of the micropores (pitch of the conductive paths) and the density of the conductive paths.

In addition, even in cases where the anisotropic conductive member is used in combination with the probe needles, the contact therebetween is facilitated, and if these are in contact with each other, positional displacements do not easily occur and it is not necessary to join them together. Accordingly, the probe needles can be appropriately changed in accordance with the type of the test object and the size of the test electrodes and the probe card of the present invention is therefore very useful.

What is more, the testing method using the probe card according to the present invention involves bringing the portions of contact with the test electrodes (protrusions of the conductive paths, electric contacts) into contact with an alkaline aqueous solution or an acidic aqueous solution before testing the electrical properties of the test object and therefore enables substances adhering to the contact portions or an oxide film to be removed to achieve consistent testing.

On the other hand, in the conductive member of the present invention, the anisotropic conductive structure is electrically connected to the conductive layer made of a conductive material and therefore it is possible to appropriately pattern the conductive layer by using a commercially available laser marker. In addition, the insulating material of the anisotropic conductive structure is in the form of an anodized film and therefore the thermal conductivity and heat dissipation efficiency are high. The conductive member also has anisotropic conductivity and therefore it is not necessary to form through holes by patterning both surfaces. It is also possible to prepare the conductive member of the present invention in a multilayer form.

The conductive member in another aspect of the present invention can be used as an electric circuit board because the conductive layer has a wiring circuit pattern. In addition, the insulating material of the anisotropic conductive structure is in the form of an anodized film and therefore the thermal conductivity and heat dissipation efficiency are high. The conductive member also has anisotropic conductivity and therefore it is not necessary to form through holes by patterning both surfaces. It is also possible to prepare the conductive member in a multilayer form.

The conductive member according to still another embodiment in which the photosensitive resin layer is further formed on the conductive layer can be easily patterned into an arbitrary wiring layer by making use of simple exposure/development. treatment.

BRIEF DESCRIPTION OF THE DRAWINGS

[FIG. 1] FIG. 1 is a cross-sectional view showing the schematic configuration of a probe card in a preferred embodiment of the present invention.

[FIG. 2] FIG. 2 shows simplified views of a preferred embodiment of an anisotropic conductive member.

[FIG. 3] FIG. 3 illustrates a method for computing the degree of ordering of micropores.

[FIG. 4] FIG. 4 is a cross-sectional view showing the schematic arrangement of electric contacts in a preferred embodiment of the probe card of the present invention.

[FIG. 5] FIG. 5 is a cross-sectional view showing the schematic arrangement of electric contacts in another preferred embodiment of the probe card of the present invention.

[FIG. 6] FIG. 6 shows schematic end views for illustrating an exemplary anodizing treatment step in the method of manufacturing the anisotropic conductive member.

[FIG. 7] FIG. 7 shows schematic end views for illustrating an exemplary metal filling step in the method of manufacturing the anisotropic conductive member.

[FIG. 8] FIG. 8 schematically shows a preferred embodiment of a method of bonding the anisotropic conductive member to the testing circuit board by thermocompression.

[FIG. 9] FIG. 9 is a schematic view showing the schematic configuration of a probe tester in a preferred embodiment of the present invention.

[FIG. 10] FIGS. 10A to 10C are schematic end views each illustrating the structure of a conductive member of the present invention.

[FIG. 11] FIGS. 11A to 11C are schematic end views each illustrating the structure of a conductive member of the present invention.

[FIG. 12] FIGS. 12A to 12D are schematic end views each illustrating the structure of a conductive member of the present invention.

[FIG. 13] FIGS. 13A to 13D are schematic end views each illustrating the structure of a conductive member of the present invention.

[FIG. 14] FIG. 14A is a view showing the pattern of a lead electrode. FIG. 14B is a schematic view of a probe card which uses the conductive member of the present invention as a circuit board.

[FIG. 15] FIG. 15A and 15B are schematic views each showing a probe card which uses the conductive member of the present invention as a circuit board.

[FIG. 16] FIG. 16 is a view illustrating the density of conductive paths of the conductive member.

[FIG. 17] FIG. 17 is a schematic cross-sectional view illustrating how the testing electrodes, the anisotropic conductive member and the probe needles of the probe card used in Examples and Comparative Examples are in contact with (are joined to) each other.

[DESCRIPTION OF SYMBOLS]

1 probe card
2 test object

3 test electrode
4 testing electrode
5 testing circuit board
6 anisotropic conductive member (structure)
7 insulating base
8 conductive path
9 holder
10a, 10b protrusion
11 conductive portion within the base
12 thickness of the insulating base
13 width between neighboring conductive paths
14 diameter of the conductive path
15 center-to-center distance (pitch) between neighboring conductive paths
16 probe needle
17 proximal end
18 distal end
19 fixing holder
20 fixing member
21 resin material
22 bumpy contact
23 proximal end
24 distal end
32 aluminum substrate
34a, 34b, 34c, 34d anodized film
36a, 36b, 36c, 36d micropore
38a, 38b, 38c, 38d barrier layer
40 insulating base
41 precursor of anisotropic conductive member (anisotropic conductive structure)
42 anisotropic conductive member
45, 45a, 45b pressure head
51 micropore unit cell
52 conductive electrode portion
60 probe tester
61 probe card
62 interface ring
63 tester head
70 anisotropic conductive structure
71 conductive path
72 anodized film
73 conductive layer 73a foundation layer 73b plated layer
74 conductive adhesive
75 conductive bump
76 protective layer
77 photosensitive resin layer
80 conductive member
81 signal output line
82 signal output portion
83, 84 contact
85, 86, 87, 88 signal output electrode
89 wiring circuit
90, 91 patterned conductive layer
92 conductive adhesive
93 carbon fiber electrode
94 contact made of a conductive elastic material
95 contact connection portion
101, 102, 104, 105, 107, 108 micropore
103, 106, 109 circle

BEST MODE FOR CARRYING OUT THE INVENTION

The probe card according to a first aspect of the present invention (hereinafter referred to simply as "probe card of the present invention") is described below in detail.

The probe card of the present invention is a probe card which is brought into contact with test electrodes of a test object to test electrical properties of the test object, the probe card comprising:

a testing circuit board having testing electrodes formed so as to correspond to the test electrodes; and
an anisotropic conductive member electrically connecting the test electrodes with the testing electrodes,
wherein the testing electrodes are formed so that at least ends of the testing electrodes protrude from a surface of the testing circuit board, and
wherein the anisotropic conductive member is a member which has an insulating base and a plurality of conductive paths made of a conductive material, insulated from one another, and extending through the insulating base in a thickness direction of the insulating base, one end of each of the conductive paths protruding from one side of the insulating base, and the other end of each of the conductive paths protruding from the other side of the insulating base, and wherein the insulating base is a structure composed of an anodized aluminum film having micropores therein.

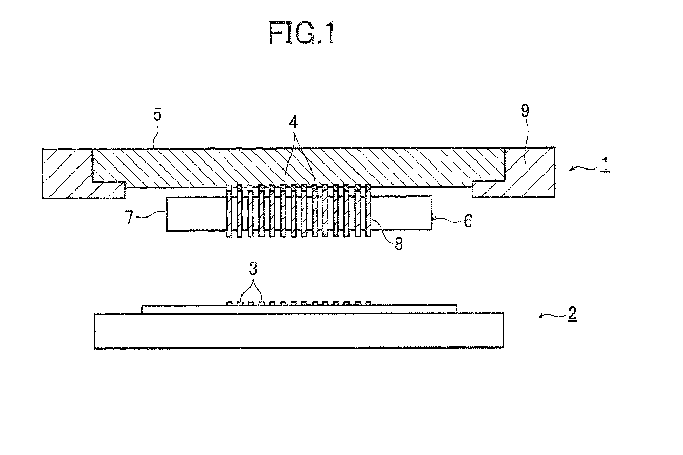

Next, the probe card of the present invention is described with reference to FIGS. 1 to 5.

FIG. 1 is a cross-sectional view showing the schematic configuration of a probe card in a preferred embodiment of the present invention.

As shown in FIG. 1, a probe card 1 of the present invention is one including a testing circuit board 5 in which testing electrodes 4 are formed so as to correspond to test electrodes 3, and an anisotropic conductive member 6 electrically connecting the test electrodes 3 with the testing electrodes 4 for the purpose of testing electrical properties of a test object 2 by bringing the testing electrodes 4 into contact with the test electrodes 3 of the test object 2.

As shown in FIG. 1, the anisotropic conductive member 6 in the probe card 1 of the present invention is a member which has an insulating base 7 and a plurality of conductive paths 8 made of a conductive material, insulated from one another, and extending through the insulating base 7 in the thickness direction of the insulating base 7, one end of each of the conductive paths 8 protruding from one side of the insulating base 7, and the other end of each of the conductive paths 8 protruding from the other side thereof. The testing circuit board 5 and the anisotropic conductive member 6 are described below in detail.

[Testing Circuit Board]

The testing circuit board is one having testing electrodes formed so as to correspond to test electrodes of a test object.

The testing circuit board is one called a "performance board" and a printed circuit board may be used as in conventionally known probe cards.

In the present invention, there is no particular limitation on the material of the testing circuit board but a material having a coefficient of thermal expansion of $2.5 \times 10^{-6}$ to $10 \times 10^{-6}K^{-1}$ is preferred. Specific examples that may be preferably used include a silicon substrate (with a coefficient of thermal expansion of $2.6 \times 10^{-6}$ to $3.5 \times 10^{-6}K^{-1}$), an alumina ceramic substrate (with a coefficient of thermal expansion of $7.5 \times 10^{-6}K^{-1}$), and a silicon carbide (ceramic) substrate (with a coefficient of thermal expansion of $4.0 \times 10^{-6}K^{-1}$).

At a coefficient of thermal expansion within the above-defined range, displacements in the positions of contact between the testing electrodes and the conductive portions are less liable to occur even after repeated use, and as a result the stability of the connection between the testing electrodes and the test electrodes are improved even after exposure to high temperatures in the burn-in test. Displacements in the positions of contact between the conductive portions and the probe needles or the test electrodes are also less liable to occur after repeated use.

Alumina substrates and ceramic substrates having excellent heat resistance and warping resistance at high temperatures are particularly preferred.

In the present invention, as shown in FIG. 1, the testing electrodes are formed in such a manner that at least ends of the testing electrodes protrude from the surface of the testing circuit board.

As will be described in connection with the probe card-manufacturing method of the present invention to be mentioned below, thermal fusion bonding between the test electrodes of the test object and the conductive paths of the anisotropic conductive member is facilitated by protruding the testing electrodes from the surface of the testing circuit board.

The method of protruding the testing electrodes is not particularly limited, and known methods may be used to protrude the testing electrodes as described below.

More specifically, as described in "Introduction to Manufacture of Printed Circuit Board" (eighth edition, The Nikkan Kogyo Shinbun, Ltd., 2004, pp. 151-157), the testing electrodes may be formed by, for example, a method in which a copper-clad laminate (JIS) is exposed, developed and etched to make part of copper (Cu) wiring remain as protruding electrodes (protruding portions). Electroless plating is preferably used to coat the protruding electrodes with nickel, then their uppermost surfaces with gold to suppress natural oxidation.

A method as described in this literature on pages 158 to 166 is also suitably used in which a solder resist layer is provided to form protruding portions by soldering. In this method, the shape of the solder depends on its surface tension in the molten state and is approximately hemispherical. Therefore, the height of the protrusions is proportional to the electrode pattern size and is generally one-eighth to half (hemisphere) the electrode pattern size.

In addition, an embodiment in which gold (Au) is used to form protrusions at copper electrode portions of a printed circuit board prepared from a copper-clad laminate is preferred in terms of improving the pressure bonding properties.

The gold protruding portions may be formed by, for example, a method in which a commercially available gold wiring ink (e.g., micro-wiring metallic paste NPG-J available from Harima Chemicals, Inc.) is used to form a pattern by an ink-jet process, or other known forming methods (see, for example, JP 2-90622 A, JP 2-98139 A, JP 5-175200 A, and JP 2004-289135 A).

The protrusions that may be formed by such methods preferably have a height tolerance of $\pm 30$ $\mu$m or less, more preferably $\pm 10$ $\mu$m or less and even more preferably $\pm 1$ $\mu$m or less in terms of ease of joining between the test electrodes of the test object and the conductive paths of the anisotropic conductive member.

In the present invention, the testing circuit board is preferably formed in an approximately disk shape and its outer periphery is preferably held by the holder (represented by reference symbol 9 in FIG. 1).

The probe card including such a testing circuit board according to the present invention is preferably used to test an object made of a material with a coefficient of thermal expansion of $2.5 \times 10^{-6}$ to $10 \times 10^{-6}$ K$^{-1}$. More specifically, a silicon substrate with a coefficient of thermal expansion of $2.6 \times 10^{-6}$ to $3.5 \times 10^{-6}$ K$^{-1}$ can be advantageously used.

[Anisotropic Conductive Member]

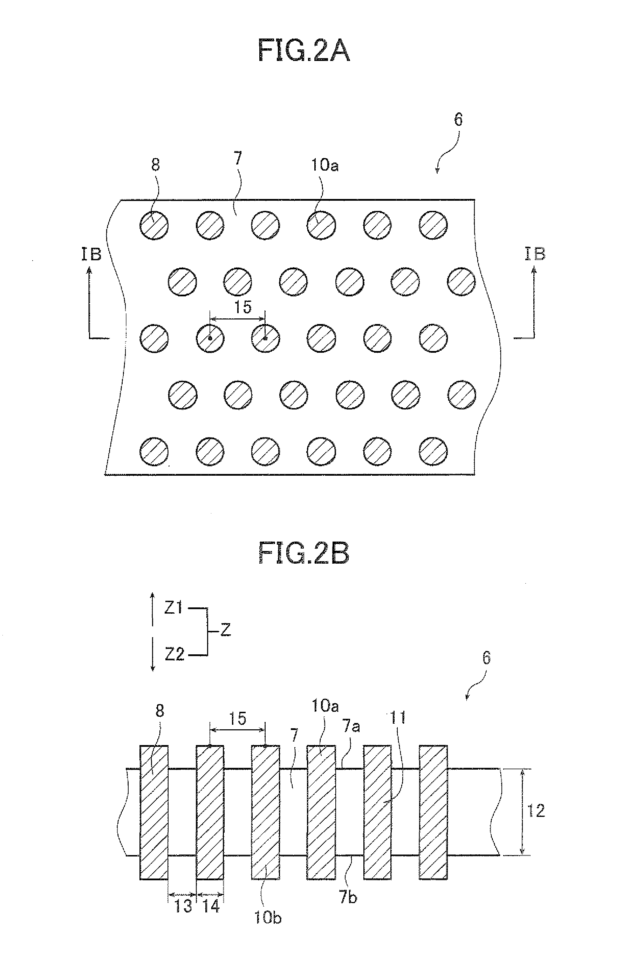

FIG. 2 shows simplified views of a preferred embodiment of an anisotropic conductive member; FIG. 2A being a plan view and FIG. 2B being a cross-sectional view taken along the line IB-IB of FIG. 2A.

The anisotropic conductive member 6 includes the insulating base 7 and the plurality of conductive paths 8 made of a conductive material.

The conductive paths 8 extend through the insulating base 7 in a mutually insulated state and the length in the axial direction of the conductive paths 8 is equal to or larger than the length (thickness) in the thickness direction Z (Z1 or Z2) of the insulating base 7.

Each conductive path 8 is formed with one end protruding from one surface of the insulating base 7 and the other end protruding from the other surface of the insulating base 7. In other words, both the ends of each conductive path 8 have protrusions 10a and 10b protruding from main surfaces 7a and 7b of the insulating base 7, respectively.

In addition, each conductive path 8 is preferably formed so that at least the portion within the insulating base 7 (hereinafter also referred to as "conductive portion 11 within the base") is substantially parallel (parallel in FIG. 2) to the thickness direction Z (Z1 or Z2) of the insulating base 7. More specifically, the ratio of the center line length of each conductive path to the thickness of the insulating base (length/thickness) is preferably from 1.0 to 1.2 and more preferably from 1.0 to 1.05.

Next, the materials and sizes of the insulating base and the conductive paths and their forming methods are described.

<Insulating Base>

The insulating base making up the anisotropic conductive member is a structure composed of an anodized aluminum film having micropores therein.

By using such a structure, the stability of the connection between the testing electrodes and the test electrodes are improved even after exposure to high temperatures in the burn-in test, and displacements in the positions of contact between the testing electrodes and the conductive portions or between the conductive portions and the probe needles or the test electrodes are less liable to occur even after repeated use.

This is presumably because the insulating base consists primarily of alumina (coefficient of thermal expansion: $4.5 \times 10^{-6}$K$^{-1}$) which is an inorganic material, and therefore the heat resistance is excellent and its coefficient of thermal expansion is close to that of a material (e.g., ceramic) used for general testing circuit boards.

In the present invention, the micropores have a degree of ordering as defined by formula (i) of preferably at least 40%, more preferably at least 70% and even more preferably at least 80%.

A degree of ordering within the above-defined range more reliably ensures the insulating properties in the planar direction of the insulating base against radio-frequency signals of particularly 100 kHz or more.

$$\text{Degree of ordering (\%) = B/A} \times 100 \quad \text{(i)}$$

In formula (i), A represents the total number of micropores in a measurement region, and B represents the number of specific micropores in the measurement region for which, when a circle is drawn so as to be centered on the center of gravity of a specific micropore and so as to be of the smallest radius that is internally tangent to the edge of another micropore, the circle includes centers of gravity of six micropores other than the specific micropore.

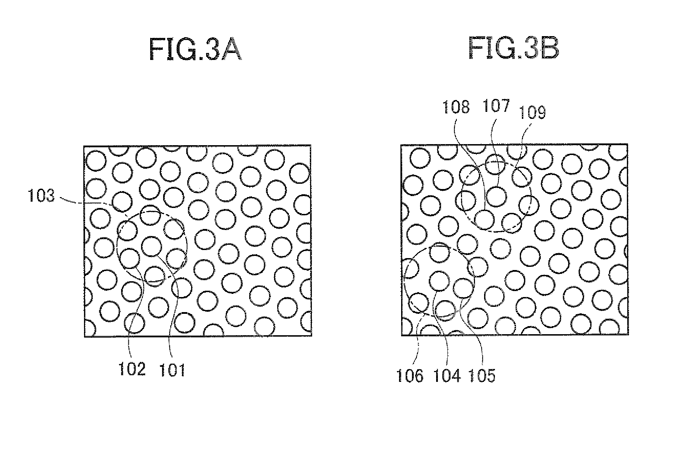

FIG. 3 illustrates a method for computing the degree of ordering of micropores. Above formula (i) is explained more fully below by reference to FIG. 3.

In the case of a first micropore 101 shown in FIG. 3A, when a circle 103 is drawn so as to be centered on the center of gravity of the first micropore 101 and so as to be of the smallest radius that is internally tangent to the edge of another micropore (inscribed in a second micropore 102), the interior of the circle 103 includes the centers of gravity of six micropores other than the first micropore 101. Therefore, the first micropore 101 is included in B.

In the case of a first micropore 104 shown in FIG. 3B, when a circle 106 is drawn so as to be centered on the center of gravity of the first micropore 104 and so as to be of the smallest radius that is internally tangent to the edge of another micropore (inscribed in a second micropore 105), the interior of the circle 106 includes the centers of gravity of five micropores other than the first micropore 104. Therefore, the first micropore 104 is not included in B.

In the case of a first micropore 107 shown in FIG. 3B, when a circle 109 is drawn so as to be centered on the center of gravity of the first micropore 107 and so as to be of the smallest radius that is internally tangent to the edge of another micropore (inscribed in a second micropore 108), the interior of the circle 109 includes the centers of gravity of seven micropores other than the first micropore 107. Therefore, the first micropore 107 is not included in B.

The micropores preferably have a period of 0.1 to 0.6 $\mu$m, more preferably 0.2 to 0.6 $\mu$m and even more preferably 0.4 to 0.6 $\mu$m.

At a period within the above-defined range, a balance is easily struck between the diameter of each of the conductive paths and the width between the conductive paths (insulating barrier thickness) to be described later to enhance the connection reliability, and the thus obtained anisotropic conductive member is particularly excellent in the transmission of radio-frequency signals of 100 kHz or more (radio-frequency properties), and is fully compatible with electronic components such as semiconductor devices even today when still higher levels of integration have been achieved.

The period refers to the center-to-center distance between neighboring micropores.

In addition, from the viewpoint that the conductive paths to be described later are of a straight-tube structure, it is preferred for the micropores not to have a branched structure. In other words, the ratio of the number of micropores X per unit area on one surface of the anodized film to the number of micropores Y per unit area on the other surface of the anodized film (X/Y) is preferably from 0.90 to 1.10. The ratio X/Y is more preferably from 0.95 to 1.05 and most preferably from 0.98 to 1.02.

In addition, alumina used as the material of the anodized aluminum film has an electric resistivity of about $10^{14} \Omega \cdot$m as in the insulating base making up a conventionally known anisotropic conductive film (e.g., thermoplastic elastomer).

In the present invention, the insulating base preferably has a thickness (as shown by reference symbol 12 in FIG. 2B) of from 1 to 1000 $\mu$m, more preferably from 5 to 500 $\mu$m and even more preferably from 10 to 300 $\mu$m. At an insulating base thickness within the foregoing range, the insulating base can be handled with ease.

In the present invention, the width between neighboring conductive paths (the portion represented by reference symbol 13 in FIG. 2B) in the insulating base is preferably at least 10 nm, and more preferably from 20 to 400 nm. At a width between neighboring conductive paths of the insulating base within the foregoing range, the insulating base functions fully as an insulating barrier.

In the present invention, the insulating base can be manufactured, for example, by anodizing the aluminum substrate and perforating the micropores formed by anodization.

The anodizing treatment step and the perforating treatment step will be described in detail in connection with the anisotropic conductive member-manufacturing method to be referred to later.

<Conductive Path>

The conductive paths making up the anisotropic conductive member are made of a conductive material.

The conductive material is not particularly limited as long as the material used has an electric resistivity of not more than $10^3$ $\Omega \cdot$cm. Illustrative examples of the conductive material that may be preferably used include gold (Au), silver (Ag), copper (Cu), aluminum (Al), magnesium (Mg), nickel (Ni), tungsten (W), cobalt (Co), rhodium (Rh), indium-doped tin oxide (ITO), molybdenum (Mo), iron (Fe), Pd (palladium), beryllium (Be) and rhenium (Re), and alloys consisting primarily of these metals.

A metal selected from the group consisting of copper, nickel and gold, or alloys consisting primarily of these metals are preferred in terms of electric conductivity.

In terms of cost, it is more preferred to use gold for only forming the surfaces of the conductive paths protruding from both the surfaces of the insulating base (hereinafter also referred to as "end faces").

By using such a conductive member, a probe card which has good stability of the connection between the testing electrodes and the test electrodes even after exposure to high temperatures in the burn-in test, and is less susceptible to displacements in the positions of contact between the testing electrodes and the conductive portions or between the conductive portions and the probe needles or the test electrodes even after repeated use of the probe card as well as a probe tester including such a probe card can be provided.

This is presumably because, unlike the conductive portions described in the foregoing Patent Documents 1 and 2, electrical conduction is made possible irrespective of the compression in the vertical direction and therefore the degree of compression of the anisotropic conductive member after repeated use is reduced.

In the present invention, the conductive paths are columnar and have a diameter (as shown by reference symbol 14 in FIG. 2B) of preferably from 5 to 500 nm, more preferably from 20 to 400 nm, even more preferably from 260 to 380 nm and most preferably from 300 to 350 nm. At a conductive path diameter within the above-defined range, a sufficient response can be obtained when an RF electric signal is passed through, and therefore the thus obtained probe card can be more advantageously used.

As described above, the ratio of the center line length of each conductive path to the thickness of the insulating base (length/thickness) is preferably from 1.0 to 1.2 and more preferably from 1.0 to 1.05. A ratio of the center line length of each conductive path to the thickness of the insulating base within the above-defined range enables the conductive path to be regarded as having a straight-tube structure and ensures a one-to-one response when an electric signal is passed through. Therefore, the thus obtained probe card can be more advantageously used.

In the present invention, when both the ends of the conductive path protrude from both the surfaces of the insulating base, the protrusions (in FIG. 2B, the portions represented by reference symbols 10a and 10b; also referred to below as "bumps") have a height of preferably from 10 to 500 nm, and more preferably from 10 to 200 nm. At a bump height in this range, connectivity with the electrode (pads) on an electronic component improves.

In the present invention, the conductive paths are mutually insulated by the insulating base and the density is preferably at least $2 \times 10^6$ conductive paths/mm², and most preferably at least $3 \times 10^6$ conductive paths/mm². At a conductive path density within the above-defined range, the thus obtained anisotropic conductive member is fully compatible with electronic components such as semiconductor devices even today when still higher levels of integration have been achieved.

In the present invention, the center-to-center distance between neighboring conductive paths (the portion represented by reference symbol 15 in FIG. 2; also referred to below as "pitch") is preferably from 0.1 to 0.6 $\mu$m, more preferably from 0.2 to 0.6 $\mu$m, and even more preferably from 0.4 to 0.6 $\mu$m. At a pitch within the above-defined range, a balance is easily struck between the diameter of the conductive paths and the width between the conductive paths (insulating barrier thickness) to enhance the connection reliability, and the thus obtained anisotropic conductive member is particularly excellent in the transmission of radio-frequency signals of 100 kHz or more (radio-frequency properties), and is fully compatible with electronic components such as semiconductor devices even today when still higher levels of integration have been achieved.

In the present invention, the conductive paths can be formed by filling a metal as a conductive material into the through micropores in the insulating base.

The metal filling treatment step will be described in detail in connection with the anisotropic conductive member-manufacturing method to be referred to later.

As described above, the anisotropic conductive member including the insulating base and the conductive paths preferably has an insulating base thickness of from 1 to 1000 $\mu$m and a conductive path diameter of from 5 to 500 nm, because electrical conduction can be confirmed at a high density while maintaining high insulating properties.

[Electric Contact]

The probe card of the present invention preferably has electric contacts for connecting the test electrodes with the anisotropic conductive member.

<Probe Needle>

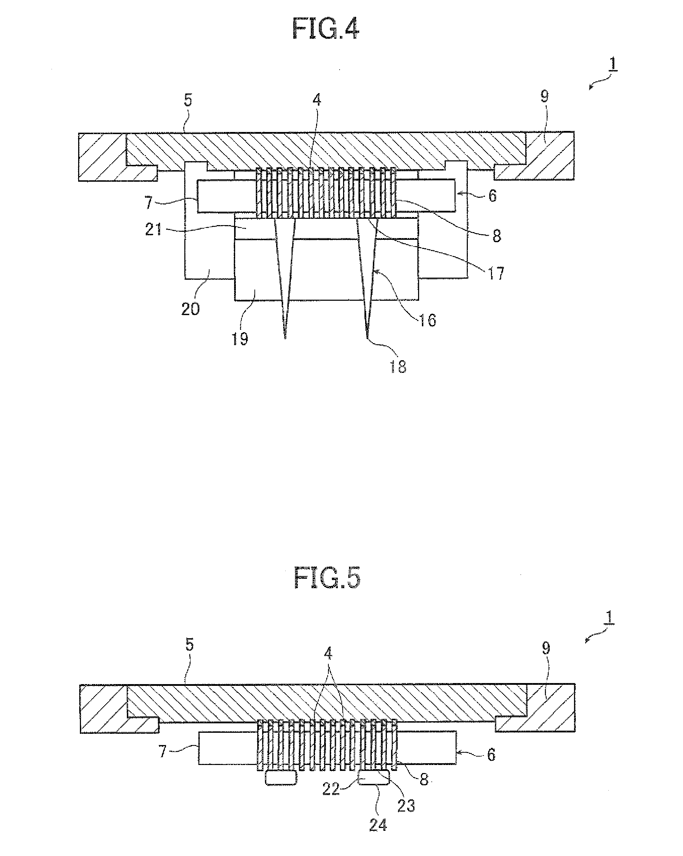

FIG. 4 is a cross-sectional view showing the schematic arrangement of electric contacts in a preferred embodiment of the probe card of the present invention.

The probe card of the present invention preferably includes probe needles 16 as shown in FIG. 4.

As in the conductive paths, the material of the probe needles is not particularly limited as long as the material used has an electric resistivity of not more than $10^3$ Ω·cm. Illustrative examples of the material that may be preferably used include gold (Au), silver (Ag), copper (Cu), aluminum (Al), magnesium (Mg), nickel (Ni), tungsten (W), cobalt (Co), rhodium (Rh), indium-doped tin oxide (ITO), molybdenum (Mo), iron (Fe), Pd (palladium), beryllium (Be) and rhenium (Re), and alloys consisting primarily of these metals.

Of these, a metal selected from the group consisting of nickel, tungsten and cobalt, or alloys consisting primarily of these metals are preferred in terms of the hardness of the material when used as the electric contact and high resistance to natural oxidation.

In cases where the probe needle in the present invention is not made of a metal selected from the group consisting of nickel, tungsten and cobalt or an alloy consisting primarily of any of these metals, at least a proximal end 17 of the probe needle is preferably made of any of these metals or an alloy thereof.

The forming method is not particularly limited and for example a forming method in which a vacuum device relying on CVD or sputtering is used, or a forming method by means of electroless plating may be used.

In terms of improving the surface hardness and wear resistance of the probe needles, the probe needles may be subjected to a known surface hardening treatment such as DLC coating or ion plating using titanium (Ti) or titanium nitride (TiN).

In cases where the probe card 1 includes the probe needles 16 as shown in FIG. 4, the proximal end 17 of each probe needle 16 is provided so as to contact the conductive paths 18 of the anisotropic conductive member 6 whereas a distal end 18 of each probe needle 16 is provided so as to contact the test electrode 3 when the probe card 1 is pressed against an integrated circuit formed on a wafer.

An electrical connection between the test electrodes 3 and the testing electrodes 4 is thus established via the probe needles 16 and the conductive paths 8 of the anisotropic conductive member 6.

Exemplary methods for fixing the probe needle 16 include a method of fixing it to a support ring with an adhesive (see, for example, JP 3-169853 A) and a method in which a Si wafer is processed by MEMS or VLS technique to prepare a probe needle array (see, for example, JP 11-190748 A).

By providing such probe needles, a test object having such a surface morphology that the test electrodes are recessed from the wafer body surface unlike the embodiment shown in FIG. 1 can be tested for the electrical properties.

In the present invention, the probe needle is preferably of a vertical spring type in terms of easy contact with each test electrode even when the wafer body surface has topographic features.

In the present invention, there is no particular limitation on the shape of the probe needle, but the probe needle is preferably in needle form and preferably has a distal end diameter of 0.2 to 200 μm, more preferably 0.8 to 100 μm and even more preferably 1 to 50 μm. At a probe needle diameter within the above-defined range, a sufficient response can be obtained when an electric signal is passed through, and therefore the thus obtained probe card can be more advantageously used.

In addition, in the present invention, the probe needle preferably has a pit formed at the surface of the proximal end thereof (this surface is the surface of contact with the conductive portions and this also applies to the following description) so that displacements in the position of contact between the conductive portions and the probe needle are less liable to occur. The pit preferably has a depth of 10 to 500 nm and the pit may be formed, for example, by a method which involves previously forming a pit at the portion corresponding to the proximal end of the probe needle in the mold of the probe needle by MEMS (micro-electro-mechanical systems) and forming the probe needle by electroforming, and a method which involves removing the portion making up a pit by laser ablation.

From the same point of view, the surface of the proximal end of the probe needle preferably has an arithmetic mean roughness $R_a$ of 0.001 to 0.5 μm, a maximum height $R_z$ of 0.01 to 0.9 μm and a ratio of the maximum height $R_z$ to the arithmetic mean roughness $R_a$ of 2 to 15.

The columnar conductive paths have extremely small diameter of 5 to 500 nm as described above and therefore the probe needle is defined so that one end (edge) of each conductive path catches on the surface of the proximal end of the probe needle upon contact between the conductive portion and the probe needle.

The probe card of the present invention more preferably includes a fixing holder 19 for fixing the probe needles 16 so that both the ends (17, 18) of the probe needles 16 protrude from the surfaces of the fixing holder 19 as shown in FIG. 4.

The fixing holder is preferably made of materials including resins such as epoxy resins (with a coefficient of thermal expansion of $18 \times C^{-6}K^{-1}$) , glass fiber reinforced epoxy resins (with a coefficient of thermal expansion of $13 \times 10^{-6}$ to $16 \times 10^{-6}K^{-1}$), glass fiber reinforced phenol resins (with a coefficient of thermal expansion of $13 \times 10^{-6}$ to $16 \times 10^{-6}K^{-1}$), glass fiber reinforced polyimide resins (with a coefficient of thermal expansion of $13 \times 10^{-6}$ to $16 \times 10^{-6}K^{-1}$) and glass fiber reinforced bismaleimide triazine resins (with a coefficient of thermal expansion of $13 \times 10^{-6}$ to $16 \times 10^{-6}K^{-1}$); and ceramic materials including alumina (with a coefficient of thermal expansion of $4.5 \times 10^{-6}$ to $7 \times 10^{-6}K^{-1}$), beryllia (with a coefficient of thermal expansion of $7 \times 10^{-6}$ to $8 \times 10^{-6}K^{-1}$) , silicon carbide (with a coefficient of thermal expansion of $4.0 \times 10^{-6}K^{-1}$), aluminum nitride (with a coefficient of thermal expansion of $4.5 \times 10^{-6}K^{-1}$) and boron nitride

(with a coefficient of thermal expansion of $3 \times 10^{-6}K^{-1}$).

Of these, materials with a coefficient of thermal expansion of $2.5 \times 10^{-6}$ to $10 \times 10^{-6}K^{-1}$ are preferably used. More specifically, silicon carbide is preferred because displacements in the positions of contact between the testing electrodes and the conductive portions are less liable to occur even after repeated use.

In the probe card of the present invention, it is further preferred that the fixing holder 19 also serve to fix the anisotropic conductive member 6 to the testing circuit board 5. For example, a fixing member 20 configured to fix the anisotropic conductive member 6 with a screw made of a metallic material such as stainless steel is preferably used to fix the anisotropic conductive member 6 to the testing circuit board 5 as shown in FIG. 4.

In addition, in the probe card of the present invention, the surface of the fixing holder 19 (the surface on the side of the anisotropic conductive member 6) is preferably coated with a resin material 21.

The resin material used is preferably a heat resistant material and preferred examples thereof include elastic rubbers (fluorine FKM, silicon rubber and acrylic rubber) and thermoplastic polyester elastomers.

Commercial products such as thin film silicone sheet (Sμ-50-50 available from IPROS CORPORATION; heatproof temperature: 200°C), a thermoplastic polyester elastomer (PELPRENE (registered trademark) type C available from Toyobo Co., Ltd.; heatproof temperature: 175°C) and an underfill resin (2274B available from TreeBond Co., Ltd.; coefficient of thermal expansion: $7.4 \times 10^{-6}K^{-1}$) may be used for the resin material.

The fixing holder 19 is coated with the resin material to the thickness which is preferably substantially the same as the distance between the proximal end 17 of the probe needle 16 and the surface of the fixing holder 19 and more preferably from 1 μm to 10 mm.

By using such a resin material, the pressure is dispersed when the fixing holder is brought into contact with the anisotropic conductive member, whereby cracking of the anisotropic conductive member can be prevented from occurring due to overload resulting from excessive tightening. The parallelism between the anisotropic conductive member and the fixing holder can be prevented from being lost due to displacements in the position of contact between the anisotropic conductive member and the fixing holder during the burn-in test.

In the present invention, in cases where such probe needles are provided, it is easy to bring the conductive paths into contact with the probe needles, and positional displacements do not easily occur and therefore it is not necessary to join them together. The probe needles may also be appropriately changed according to the type of test object and the size of test electrode.

<Bumpy Contact>

FIG. 5 is a cross-sectional view showing the schematic arrangement of electric contacts in another preferred embodiment of the probe card of the present invention.

The probe card of the present invention includes bumpy contacts 22 as shown in FIG. 5.

As in the conductive paths, the material of the bumpy contacts is not particularly limited as long as the material used has an electric resistivity of not more than $10^3$ Ω·cm. Illustrative examples of the material that may be preferably used include gold (Au), silver (Ag), copper (Cu), aluminum (Al), magnesium (Mg), nickel (Ni), tungsten (W), cobalt (Co), rhodium (Rh), indium-doped tin oxide (ITO), molybdenum (Mo), iron (Fe), Pd (palladium), beryllium (Be) and rhenium (Re), and alloys consisting primarily of these metals.

Of these, a metal selected from the group consisting of nickel, tungsten and cobalt, or alloys consisting primarily of these metals are preferred in terms of the hardness of the material when used as the electric contacts and high resistance to natural oxidation.

In cases where the bumpy contacts 22 are provided as shown in FIG. 5, a proximal end 23 of each bumpy contact 22 is provided so as to contact the conductive paths 8 of the anisotropic conductive member 6 whereas a distal end 24 thereof is provided so as to contact the test electrodes 3 when the probe card 1 is pressed against an integrated circuit formed on a wafer.

An electrical connection between the test electrodes 3 and the testing electrodes 4 is thus established via the bumpy contacts 22 and the conductive paths 8 of the anisotropic conductive member 6.

By providing such bumpy contacts, an object having such a surface morphology that the test electrodes are recessed from the wafer body surface unlike the embodiment shown in FIG. 1 can be tested for the electrical properties.

In the present invention, the bumpy contacts (conductive portions) can be formed at positions corresponding to the conductive paths of the anisotropic conductive member and the test electrodes of the test object by a method which involves forming a metal layer (e.g., copper layer) by such a process as electroless plating, vapor deposition or sputtering on the back side (on the 7b and 10b side surface in FIG. 2) of the anisotropic conductive member, and patterning by photo-etching or laser exposure as described in, for example, JP 4-126307 A.

In this method, the contact height is substantially equal to the thickness of the metal layer formed on the surface and may be set to an arbitrary value by controlling the thickness of the metal layer.

This method preferably follows the metal filling step or surface planarization treatment to be described later.

In the present invention, the bumpy contacts may also be formed by trimming or electrodeposition in the protrusion-forming step to be described layer.

In terms of improving the surface hardness and wear resistance of the bumpy contacts, the bumpy contacts may be subjected to a known surface hardening treatment such as DLC coating or ion plating using titanium (Ti) or titanium nitride (TiN).

In the present invention, there is no particular limitation on the shape of the bumpy contacts, but the bumpy contacts are preferably columnar or hemispherical and preferably have a diameter of 0.05 to 200 μm, more preferably 0.1 to 100 μm and even more preferably 1 to 50 μm. The bumpy contacts preferably have a height of 0.05 to 50 μm, more preferably 0.1 to 20 μm and even more preferably 1 to 5 μm. In addition, the size of the bumpy contacts is preferably about 1/500 to about 1/2 that of the electrodes.

When the diameter, height and size of the bumpy contacts fall within the above-defined ranges, a sufficient response can be obtained when an electric signal is passed through, and therefore the thus obtained probe card can be more advantageously used.

The method of manufacturing the probe card of the present invention which includes the above-described testing circuit board and anisotropic conductive member is described below in detail.

The method of manufacturing the anisotropic conductive member (hereinafter also referred to simply as "anisotropic conductive member-manufacturing method") is first described in detail.

The anisotropic conductive member-manufacturing method is not particularly limited, but a method is advantageously used which includes:

an anodizing treatment step in which an aluminum substrate is anodized;
a perforating treatment step in which micropores formed by anodization are perforated after the anodizing treatment step to obtain an insulating base;
a metal filling step in which a metal as a conductive material is filled into through micropores in the resulting insulating base after the perforating treatment step to form conductive paths; and
a protrusion-forming step which follows the metal filling step and in which ends of the conductive paths formed are protruded from surfaces of the insulating base to obtain an anisotropic conductive member.
Next, an aluminum substrate that may be used in the anisotropic conductive member-manufacturing method, and each treatment step carried out on the aluminum substrate are described in detail.

[Aluminum Substrate]

The aluminum substrate that may be used in the anisotropic conductive member-manufacturing method is not subject to any particular limitation. Illustrative examples include pure aluminum plate; alloy plates composed primarily of aluminum and containing trace amounts of other elements; substrates made of low-purity aluminum (e.g., recycled material) on which high-purity aluminum has been vapor-deposited; substrates such as silicon wafers, quartz or glass whose surface has been covered with high-purity aluminum by a process such as vapor deposition or sputtering; and resin substrates on which aluminum has been laminated.

Of the aluminum substrate of the invention, the surface on which an anodized film is to be formed by the anodizing treatment step to be described below has an aluminum purity of preferably at least 99.5 wt%, more preferably at least 99.9 wt% and even more preferably at least 99.99 wt%. At an aluminum purity within the above-defined range, the array of the micropores is well ordered.

In the present invention, the surface of the aluminum substrate on which the subsequently described anodizing treatment step is to be carried out is preferably subjected beforehand to degreasing treatment and mirror-like finishing treatment.

<Heat Treatment>

Heat treatment is preferably carried out at a temperature of from 200 to 350°C for a period of about 30 seconds to about 2 minutes. Such heat treatment improves the orderliness of the array of micropores formed by the subsequently described anodizing treatment step.

Following heat treatment, it is preferable to rapidly cool the aluminum substrate. The method of cooling is exemplified by a method involving direct immersion of the aluminum substrate in water or the like.

<Degreasing Treatment>

Degreasing treatment is carried out with a suitable substance such as an acid, alkali or organic solvent so as to dissolve and remove organic substances, including dust, grease and resins, adhering to the aluminum substrate surface, and thereby prevent defects due to organic substances from arising in each of the subsequent treatments.

Illustrative examples of degreasing treatment include: a method in which an organic solvent such as an alcohol (e.g., methanol), ketone (e.g., methyl ethyl ketone), petroleum benzin or volatile oil is contacted with the surface of the aluminum substrate at ambient temperature (organic solvent method); a method in which a liquid containing a surfactant such as soap or a neutral detergent is contacted with the surface of the aluminum substrate at a temperature of from ambient temperature to 80°C, after which the surface is rinsed with water (surfactant method); a method in which an aqueous sulfuric acid solution having a concentration of 10 to 200 g/L is contacted with the surface of the aluminum substrate at a temperature of from ambient temperature to 70°C for a period of 30 to 80 seconds, following which the surface is rinsed with water; a method in which an aqueous solution of sodium hydroxide having a concentration of 5 to 20 g/L is contacted with the surface of the aluminum substrate at ambient temperature for about 30 seconds while electrolysis is carried out by passing a direct current through the aluminum substrate surface as the cathode at a current density of 1 to 10 A/dm$^2$, following which the surface is contacted with an aqueous solution of nitric acid having a concentration of 100 to 500 g/L and thereby neutralized; a method in which any of various known anodizing electrolytic solutions is contacted with the surface of the aluminum substrate at ambient temperature while electrolysis is carried out by passing a direct current at a current density of 1 to 10 A/dm$^2$ through the aluminum substrate surface as the cathode or by passing an alternating current through the aluminum substrate surface as the cathode; a method in which an aqueous alkali solution having a concentration of 10 to 200 g/L is contacted with the surface of the aluminum substrate at 40 to 50°C for 15 to 60 seconds, following which an aqueous solution of nitric acid having a concentration of 100 to 500 g/L is contacted with the surface and thereby neutralized; a method in which an emulsion prepared by mixing a surfactant, water and the like into an oil such as gas oil or kerosene is contacted with the surface of the aluminum substrate at a temperature of from ambient temperature to 50°C, following which the surface is rinsed with water (emulsion degreasing method); and a method in which a mixed solution of, for example, sodium carbonate, phosphates and surfactant is contacted with the surface of the aluminum substrate at a temperature of from ambient temperature to 50°C for 30 to 180 seconds, following which the surface is rinsed with water (phosphate method).

Of these, the organic solvent method, surfactant method, emulsion degreasing method and phosphate method are preferred from the standpoint of removing grease from the aluminum surface while causing substantially no aluminum dissolution.

Known degreasers may be used in degreasing treatment. For example, degreasing treatment may be carried out using any of various commercially available degreasers by the prescribed method.

<Mirror-Like Finishing Treatment>

Mirror-like finishing treatment is carried out to eliminate surface asperities of the aluminum substrate and improve the uniformity and reproducibility of particle-forming treatment using, for example, electrodeposition. Exemplary surface asperities of the aluminum substrate include rolling streaks formed during rolling of the aluminum substrate which requires a rolling step for its manufacture.

In the present invention, mirror-like finishing treatment is not subject to any particular limitation, and may be carried out using any suitable method known in the art. Examples of suitable methods include mechanical polishing, chemical polishing, and electrolytic polishing.

Illustrative examples of suitable mechanical polishing methods include polishing with various commercial abrasive cloths, and methods that combine the use of various commercial abrasives (e.g., diamond, alumina) with buffing. More specifically, a method which is carried out with an abrasive while changing over time the abrasive used from one having coarser particles to one having finer particles is appropriately illustrated. In such a case, the final abrasive used is preferably one having a grit size of 1500. In this way, a glossiness of at least 50% (in the case of rolled aluminum, at least 50% in both the rolling direction and the transverse direction) can be achieved.

Examples of chemical polishing methods include various methods mentioned in the 6th edition of Aluminum Handbook (Japan Aluminum Association, 2001), pp. 164-165.

Preferred examples include phosphoric acid/nitric acid method, Alupol I method, Alupol V method, Alcoa R5 method, $H_3PO_4$-$CH_3COOH$-Cu method and $H_3PO_4$-$HNO_3$-$CH_3COOH$ method. Of these, the phosphoric acid/nitric acid method, the $H_3PO_4$-$CH_3COOH$-Cu method and the $H_3PO_4$-$HNO_3$-$CH_3COOH$ method are especially preferred.

With chemical polishing, a glossiness of at least 70% (in the case of rolled aluminum, at least 70% in both the rolling direction and the transverse direction) can be achieved.

Examples of electrolytic polishing methods include various methods mentioned in the 6th edition of Aluminum Handbook (Japan Aluminum Association, 2001), pp. 164-165; the method described in US 2,708,655; and the method described in Jitsumu Hyomen Gijutsu (Practice of Surface Technology), Vol. 33, No. 3, pp. 32-38 (1986).

With electrolytic polishing, a glossiness of at least 70% (in the case of rolled aluminum, at least 70% in both the rolling direction and the transverse direction) can be achieved.

These methods may be suitably combined and used. In an illustrative method that may be preferably used, mechanical polishing which is carried out by changing the abrasive over time from one having coarser particles to one having finer particles is followed by electrolytic polishing.

Mirror-like finishing treatment enables a surface having, for example, a mean surface roughness $R_a$ of 0.1 $\mu$m or less and a glossiness of at least 50% to be obtained. The mean surface roughness $R_a$ is preferably 0.03 $\mu$m or less, and more preferably 0.02 $\mu$m or less. The glossiness is preferably at least 70%, and more preferably at least 80%. The glossiness is the specular reflectance which can be determined in accordance with JIS Z8741-1997 (Method 3: 60° Specular Gloss) in a direction perpendicular to the rolling direction. Specifically, measurement is carried out using a variable-angle glossmeter (e.g., VG-1D, manufactured by Nippon Denshoku Industries Co., Ltd.) at an angle of incidence/reflection of 60° when the specular reflectance is 70% or less, and at an angle of incidence/reflection of 20° when the specular reflectance is more than 70%.

[Anodizing Treatment Step]

The anodizing treatment step is a step for anodizing the aluminum substrate to form a micropore-bearing oxide film at the surface of the aluminum substrate.

Conventionally known methods may be used for anodizing treatment in the anisotropic conductive member-manufacturing method, but a self-ordering method or a constant voltage treatment to be described below is preferably used because the insulating base preferably comprises an anodized film obtained from an aluminum substrate, the anodized film having micropores arrayed so as to have a degree of ordering as defined by formula (i) of at least 40%.

The self-ordering method is a method which enhances the orderliness by using the regularly arranging nature of micropores in an anodized film and eliminating factors that may disturb an orderly arrangement. Specifically, an anodized film is formed on high-purity aluminum at a voltage appropriate for the type of electrolytic solution and at a low speed over an extended period of time (e.g., from several hours to well over ten hours).

In this method, because the micropore size (pore size) depends on the voltage, a desired pore size can be obtained to some extent by controlling the voltage.

In order to form micropores by the self-ordering method, at least the subsequently described anodizing treatment (A) should be carried out. However, micropore formation is preferably carried out by a process in which the subsequently described anodizing treatment (A), film removal treatment (B) and re-anodizing treatment (C) are carried out in this order (self-ordering method I), or a process in which the subsequently described anodizing treatment (D) and oxide film dissolution treatment (E) are carried out in this order at least once (self-ordering method II).

Next, the respective treatments in the self-ordering method I and self-ordering method II in the preferred embodiments are described in detail.

[Self-Ordering Method I]

<Anodizing Treatment (A)>

The average flow velocity of electrolytic solution in anodizing treatment (A) is preferably from 0.5 to 20.0 m/min, more preferably from 1.0 to 15.0 m/min, and even more preferably from 2.0 to 10.0 m/min. By carrying out anodizing treatment (A) at the foregoing flow velocity, a uniform and high degree of ordering can be achieved.

The method for causing the electrolytic solution to flow under the above conditions is not subject to any particular limitation. For example, a method involving the use of a common agitator such as a stirrer may be employed. The use of a stirrer in which the stirring speed can be controlled with a digital display is particularly desirable because it enables the average flow velocity to be regulated. An example of such a stirrer is the Magnetic Stirrer ES-50D (manufactured by As One Corporation).

Anodizing treatment (A) may be carried out by, for example, a method in which current is passed through the aluminum substrate as the anode in a solution having an acid concentration of from 1 to 10 wt%.

The solution used in anodizing treatment (A) is preferably an acid solution. A solution of hydrochloric acid, sulfuric acid, phosphoric acid, chromic acid, oxalic acid, sulfamic acid, benzenesulfonic acid, amidosulfonic acid, glycolic acid, tartaric acid, malic acid or citric acid is more preferred. Of these, a solution of sulfuric acid, phosphoric acid, or oxalic acid is especially preferred. These acids may be used singly or in combination of two or more thereof.

The anodizing treatment (A) conditions vary depending on the electrolytic solution employed, and thus cannot be strictly specified. However, the following conditions are generally preferred: an electrolyte concentration of from 0.1 to 20 wt%, a solution temperature of from -10 to 30°C, a current density of from 0.01 to 20 A/dm$^2$, a voltage of from 3 to 500 V, and an electrolysis time of from 0.5 to 30 hours. An electrolyte concentration of from 0.5 to 15 wt%, a solution temperature of from -5 to 25°C, a current density of from 0.05 to 15 A/dm$^2$, a voltage of from 5 to 250 V, and an electrolysis time of from 1 to 25 hours are more preferred. An electrolyte concentration of from 1 to 10 wt%, a solution temperature of from 0 to 20°C, a current density of from 0.1 to 10 A/dm$^2$, a voltage of from 10 to 200 V, and an electrolysis time of from 2 to 20 hours are even more preferred.

The treatment time in anodizing treatment (A) is preferably from 0.5 minute to 16 hours, more preferably from 1 minute to 12 hours, and even more preferably from 2 minutes to 8 hours.

Aside from being carried out at a constant voltage, anodizing treatment (A) may be carried out using a method in which the voltage is intermittently or continuously varied. In such cases, it is preferable to have the voltage gradually decrease. It is possible in this way to lower the resistance of the anodized film, bringing about the formation of small micropores in the anodized film. As a result, this approach is preferable for improving uniformity, particularly when sealing is subsequently carried out by electrodeposition treatment.

In the present invention, the anodized film formed by such anodizing treatment (A) preferably has a thickness of 1 to 1000 $\mu$m, more preferably 5 to 500 $\mu$m, and even more preferably 10 to 300 $\mu$m.

In the present invention, the anodized film formed by such anodizing treatment (A) has an average micropore density of preferably from 50 to 1,500 micropores/$\mu$m$^2$.

It is preferable for the micropores to have a surface coverage of from 20 to 50%.

The surface coverage of the micropores is defined here as the ratio of the total surface area of the micropore openings to the surface area of the aluminum surface.

<Film Removal Treatment (B)>

In film removal treatment (B), the anodized film formed at the surface of the aluminum substrate by the above-described anodizing treatment (A) is dissolved and removed.

The subsequently described perforating treatment step may be carried out immediately after forming an anodized film at the surface of the aluminum substrate by the above-described anodizing treatment (A). However, it is preferred to additionally carry out after the above-described anodizing treatment (A), film removal treatment (B) and the subsequently described re-anodizing treatment (C) in this order, followed by the subsequently described perforating treatment step.

Given that the orderliness of the anodized film increases as the aluminum substrate is approached, by using this film removal treatment (B) to remove the anodized film that has been formed in (A), the lower portion of the anodized film remaining at the surface of the aluminum substrate emerges at the surface, affording an orderly array of pits. Therefore, in film removal treatment (B), aluminum is not dissolved; only the anodized film made of alumina (aluminum oxide) is dissolved.

The alumina dissolving solution is preferably an aqueous solution containing at least one substance selected from the group consisting of chromium compounds, nitric acid, phosphoric acid, zirconium compounds, titanium compounds, lithium salts, cerium salts, magnesium salts, sodium hexafluorosilicate, zinc fluoride, manganese compounds, molybdenum compounds, magnesium compounds, barium compounds, and uncombined halogens.

Illustrative examples of chromium compounds include chromium (III) oxide and chromium (VI) oxide.

Examples of zirconium compounds include zirconium ammonium fluoride, zirconium fluoride and zirconium chloride.

Examples of titanium compounds include titanium oxide and titanium sulfide.

Examples of lithium salts include lithium fluoride and lithium chloride.

Examples of cerium salts include cerium fluoride and cerium chloride.

Examples of magnesium salts include magnesium sulfide.

Examples of manganese compounds include sodium permanganate and calcium permanganate.

Examples of molybdenum compounds include sodium molybdate.

Examples of magnesium compounds include magnesium fluoride pentahydrate.

Examples of barium compounds include barium oxide, barium acetate, barium carbonate, barium chlorate, barium chloride, barium fluoride, barium iodide, barium lactate, barium oxalate, barium perchlorate, barium selenate, barium selenite, barium stearate, barium sulfite, barium titanate, barium hydroxide, barium nitrate, and hydrates thereof.

Of the above barium compounds, barium oxide, barium acetate and barium carbonate are preferred. Barium oxide is especially preferred.

Examples of uncombined halogens include chlorine, fluorine and bromine.

Of the above, the alumina dissolving solution is preferably an acid-containing aqueous solution. Examples of the acid include sulfuric acid, phosphoric acid, nitric acid and hydrochloric acid. A mixture of two or more acids is also acceptable.

The acid concentration is preferably at least 0.01 mol/L, more preferably at least 0.05 mol/L, and even more preferably at least 0.1 mol/L. Although there is no particular upper limit in the acid concentration, in general, the concentration is preferably 10 mol/L or less, and more preferably 5 mol/L or less. A needlessly high concentration is uneconomical, in addition to which higher concentrations may result in dissolution of the aluminum substrate.

The alumina dissolving solution has a temperature of preferably -10°C or higher, more preferably -5°C or higher, and even more preferably 0°C or higher. Carrying out treatment using a boiling alumina dissolving solution destroys or disrupts the starting points for ordering. Hence, the alumina dissolving solution is preferably used without being boiled.

The alumina dissolving solution dissolves alumina, but does not dissolve aluminum. Here, the alumina dissolving solution may dissolve a very small amount of aluminum, so long as it does not dissolve a substantial amount of aluminum.

Film removal treatment (B) is carried out by bringing an aluminum substrate at which an anodized film has been formed into contact with the above-described alumina dissolving solution. Examples of the contacting method include, but are not limited to, immersion and spraying. Of these, immersion is preferred.

Immersion is a treatment in which the aluminum substrate at which an anodized film has been formed is immersed in the alumina dissolving solution. To achieve uniform treatment, it is desirable to carry out stirring at the time of immersion treatment.

The immersion treatment time is preferably at least 10 minutes, more preferably at least 1 hour, even more preferably at least 3 hours, and most preferably at least 5 hours.

<Re-Anodizing Treatment (C)>

An anodized film having micropores with an even higher degree of ordering can be formed by carrying out anodizing treatment once again after the anodized film is removed by the above-described film removal treatment (B) to form well-ordered pits at the surface of the aluminum substrate.

Re-anodizing treatment (C) may be carried out using a method known in the art, although it is preferably carried out under the same conditions as the above-described anodizing treatment (A).

Alternatively, suitable use may be made of a method in which the current is repeatedly turned on and off while keeping the dc voltage constant, or a method in which the current is repeatedly turned on and off while intermittently varying the dc voltage. Because these methods result in the formation of small micropores in the anodized film, they are preferable for improving uniformity, particularly when sealing is to be carried out by electrodeposition treatment.

When re-anodizing treatment (C) is carried out at a low temperature, the array of micropores is well-ordered and the pore size is uniform.

On the other hand, by carrying out re-anodizing treatment (C) at a relatively high temperature, the micropore array may be disrupted or the variance in pore size may be set within a given range. The variance in pore size may also be controlled by the treatment time.

In the present invention, the anodized film formed by such re-anodizing treatment (C) has a thickness of preferably from 30 to 1,000 $\mu$m, and more preferably from 50 to 500 $\mu$m.

In the present invention, the anodized film formed by such anodizing treatment (C) has micropores with a pore size of preferably 0.01 to 0.5 $\mu$m, and more preferably 0.02 to 0.1 $\mu$m.

The average micropore density is preferably at least $10^7$ micropores/mm$^2$.

In the self-ordering method I, in place of the above-described anodizing treatment (A) and film removal treatment (B), use may be made of, for example, a physical process, a particle beam process, a block copolymer process or a resist patterning/exposure/etching process to form pits as starting points for micropore formation by the above-described re-anodizing treatment (C).

<Physical Process>

Physical processes are exemplified by processes which use imprinting (transfer processes and press patterning processes in which a plate or roll having projections thereon is pressed against the aluminum substrate to form pits at the substrate). A specific example is a process in which a plate having numerous projections on a surface thereof is pressed against the aluminum surface, thereby forming pits. For example, the process described in JP 10-121292 A may be used.

Another example is a process in which polystyrene spheres are densely arranged on the aluminum surface, SiO$_2$ is vapor-deposited onto the spheres, then the polystyrene spheres are removed and the substrate is etched using the vapor-deposited SiO$_2$ as the mask, thereby forming pits.

<Particle Beam Process>

In a particle beam process, pits are formed by irradiating the aluminum surface with a particle beam. This process has the advantage that the positions of the pits can be freely controlled.

Examples of the particle beam include a charged particle beam, a focused ion beam (FIB), and an electron beam.

An example of the particle beam process that may be used is the process described in JP 2001-105400 A.

<Block Copolymer Process>

The block copolymer process involves forming a block copolymer layer on the aluminum surface, forming an islands-in-the-sea structure in the block copolymer layer by thermal annealing, then removing the island components to form pits.

An example of the block copolymer process that may be used is the process described in JP 2003-129288 A.

<Resist Patterning/Exposure/Etching Process>

In a resist patterning/exposure/etching process, resist on the surface of an aluminum plate is exposed and developed by photolithography or electron beam lithography to form a resist pattern. The resist is then etched, forming pits which pass entirely through the resist to the aluminum surface.

[Self-Ordering Method II]

<First Step: Anodizing Treatment (D)>

Conventionally known electrolytic solutions may be used in anodizing treatment (D) but the orderliness of the pore array can be considerably improved by carrying out, under conditions of direct current and constant voltage, anodization using an electrolytic solution in which the parameter R represented by general formula (ii) wherein A is the film-forming rate during application of current and B is the film dissolution rate during non-application of current satisfies $160 \leq R \leq 200$, preferably $170 \leq R \leq 190$ and most particularly $175 \leq R \leq 185$.

$$R = A \text{ [nm/s]} / (B \text{ [nm/s]} \times \text{voltage applied [V]}) \quad \cdots \text{(ii)}$$

As in the above-described anodizing treatment (A), the average flow velocity of electrolytic solution in anodizing treatment (D) is preferably from 0.5 to 20.0 m/min, more preferably from 1.0 to 15.0 m/min, and even more preferably from 2.0 to 10.0 m/min. By carrying out anodizing treatment (D) at the flow velocity within the above-defined range, a uniform and high degree of ordering can be achieved.

As in the above-described anodizing treatment (A), the method for causing the electrolytic solution to flow under the above conditions is not subject to any particular limitation. For example, a method involving the use of a common agitator such as a stirrer may be employed. The use of a stirrer in which the stirring speed can be controlled with a digital display is particularly desirable because it enables the average flow velocity to be regulated. An example of such a stirrer is the Magnetic Stirrer HS-50D (manufactured by As One Corporation).

The anodizing treatment solution preferably has a viscosity at 25°C and 1 atm of 0.0001 to 100.0 Pa·s and more preferably 0.0005 to 80.0 Pa·s. By carrying out anodizing treatment (D) using the electrolytic solution having the viscosity within the above-defined range, a uniform and high degree of ordering can be achieved.

The electrolytic solution used in anodizing treatment (D) may be an acidic solution or an alkaline solution, but an acidic electrolytic solution is advantageously used in terms of improving the circularity of the pores.

More specifically, as in the above-described anodizing treatment (A), a solution of hydrochloric acid, sulfuric acid, phosphoric acid, chromic acid, oxalic acid, glycolic acid, tartaric acid, malic acid, citric acid, sulfamic acid, benzenesulfonic acid, or amidosulfonic acid is more preferred. Of these, a solution of sulfuric acid, phosphoric acid or oxalic acid is especially preferred. These acids may be used singly or in combination of two or more thereof by adjusting as desired the parameter in the calculating formula represented by general formula (i-L).

The anodizing treatment (D) conditions vary depending on the electrolytic solution employed, and thus cannot be strictly specified. However, as in the above-described anodizing treatment (A), the following conditions are generally preferred: an electrolyte concentration of from 0.1 to 20 wt%, a solution temperature of from -10 to 30°C, a current density of from 0.01 to 20 A/dm$^2$, a voltage of from 3 to 500 V, and an electrolysis time of from 0.5 to 30 hours. An electrolyte concentration of from 0.5 to 15 wt%, a solution temperature of from -5 to 25°C, a current density of from 0.05 to 15 A/dm$^2$, a voltage of from 5 to 250 V, and an electrolysis time of from 1 to 25 hours are more preferred. An electrolyte concentration of from 1 to 10 wt%, a solution temperature of from 0 to 20°C, a current density of from 0.1 to 10 A/dm$^2$, a voltage of from 10 to 200 V, and an electrolysis time of from 2 to 20 hours are even more preferred.

In the present invention, the anodized film formed by such anodizing treatment (D) has a thickness of preferably from 0.1 to 300 $\mu$m, more preferably from 0.5 to 150 $\mu$m and even more preferably from 1 to 100 $\mu$m.

In the present invention, the anodized film formed by such anodizing treatment (D) has an average micropore density of preferably from 50 to 1,500 micrapores/$\mu$m$^2$.

It is preferable for the micropores to have a surface coverage of from 20 to 50%.

The surface coverage of the micropores is defined here as the ratio of the total surface area of the micropore openings to the surface area of the aluminum surface.

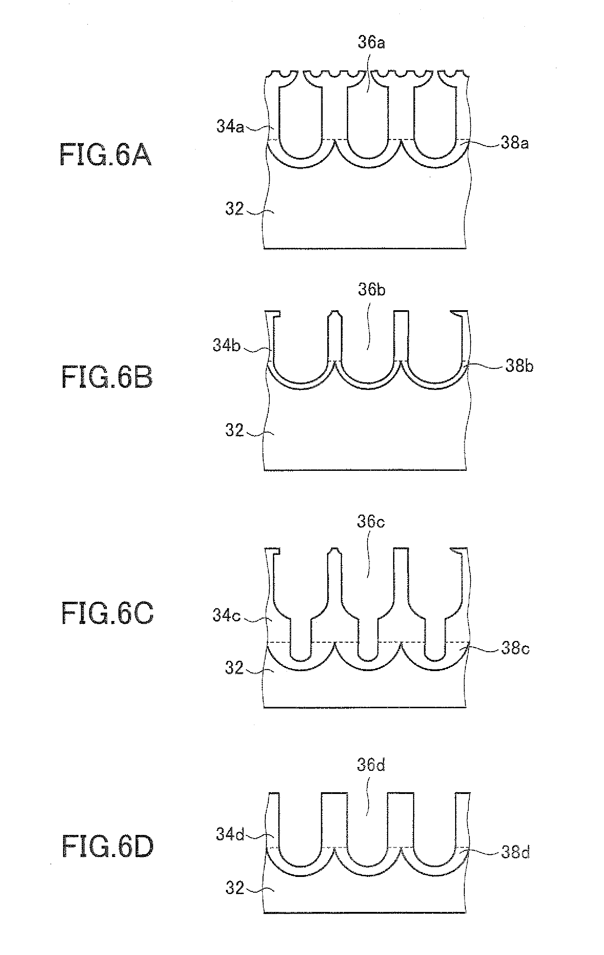

As shown in FIG. 6A, as a result of anodizing treatment (D), an anodized film 34a bearing micropores 36a is formed at a surface of an aluminum substrate 32. A barrier layer 38a is present on the aluminum substrate 32 side of the anodized film 44a.

<Second Step: Oxide Film Dissolution Treatment (E)>

Oxide film dissolution treatment (E) is a treatment for enlarging the diameter of the micropores present in the anodized film formed by the above-described anodizing treatment (D) (pore size enlarging treatment).

Oxide film dissolution treatment (E) is carried out by bringing the aluminum substrate having undergone the above-described anodizing treatment (D) into contact with an aqueous acid or alkali solution. Examples of the contacting method include, but are not limited to, immersion and spaying. Of these, immersion is preferred.

When oxide film dissolution treatment (E) is to be carried out with an aqueous acid solution, it is preferable to use an aqueous solution of an inorganic acid such as sulfuric acid, phosphoric acid, nitric acid or hydrochloric acid, or a mixture thereof. It is particularly preferable to use an aqueous solution containing no chromic acid in terms of its high degree of safety. The aqueous acid solution preferably has a concentration of 1 to 10 wt%. The aqueous acid solution preferably has a temperature of 25 to 60 °C.

When oxide film dissolution treatment (E) is to be carried out with an aqueous alkali solution, it is preferable to use an aqueous solution of at least one alkali selected from the group consisting of sodium hydroxide, potassium hydroxide and lithium hydroxide. The aqueous alkali solution preferably has a concentration of 0.1 to 5 wt%. The aqueous alkali solution preferably has a temperature of 20 to 35°C.

Specific examples of preferred solutions include a 40°C aqueous solution containing 50 g/L of phosphoric acid, a 30°C aqueous solution containing 0.5 g/L of sodium hydroxide, and a 30°C aqueous solution containing 0.5 g/L of potassium hydroxide.

The time of immersion in the aqueous acid solution or aqueous alkali solution is preferably from 8 to 120 minutes, more preferably from 10 to 90 minutes and even more preferably from 15 to 60 minutes.

In oxide film dissolution treatment (E), the degree of enlargement of the pore size varies with the conditions of anodizing treatment (D) but the ratio of after to before the treatment is preferably 1.05 to 100, more preferably 1.1 to 75 and even more preferably 1.2 to 50.

Oxide film dissolution treatment (E) dissolves the surface of the anodized film 34a and the interiors of the micropores 36a (barrier layer 38a and the porous layer) as shown in FIG. 6A to obtain an aluminum member having a micropore 36b-bearing anodized film 34b on the aluminum substrate 32 as shown in FIG. 6B. As in FIG. 6A, a barrier layer 38b is present on the aluminum substrate 32 side of the anodized film 34b.

<Third Step: Anodizing Treatment (D)>

In the self-ordering method II, it is preferred to carry out the above-described anodizing treatment (D) again after the above-described oxide film dissolution treatment (E).

By carrying out anodizing treatment (D) again, oxidation reaction of the aluminum substrate 32 shown in FIG. 6B proceeds to obtain, as shown in FIG. 6C, an aluminum member which has an anodized film 34c formed on the aluminum substrate 32, the anodized film 34c bearing micropores 36c having a larger depth than the micropores 36b. As in FIG. 6A, a barrier layer 38c is present on the aluminum substrate 32 side of the anodized film 34c.

<Fourth Step: Oxide Film Dissolution Treatment (E)>

In the self-ordering method II, it is preferred to further carry out the above-described oxide film dissolution treatment (E) after the above-described anodizing treatment (D), oxide film dissolution treatment (E) and anodizing treatment (D) have been carried out in this order.

This treatment enables the treatment solution to enter the micropores to dissolve all the anodized film formed by anodizing treatment (D) in the third step, whereby the micropores formed by anodizing treatment (D) in the third step may have enlarged diameters.

More specifically, oxide film dissolution treatment (E) carried out again dissolves the interiors of the micropores 36c on the surface side from inflection points in the anodized film 34c shown in FIG. 6C to obtain an aluminum member having an anodized film 34d bearing straight tube-shaped micropores 36d on the aluminum substrate 32 as shown in FIG. 6D. As in FIG. 6A, a barrier layer 38d is present on the aluminum substrate 32 side of the anodized film 34d.

The degree of enlargement of the pore size varies with the conditions of anodizing treatment (D) carried out in the third step but the ratio of after to before the treatment is preferably 1.05 to 100, more preferably 1.1 to 75 and even more preferably 1.2 to 50.

The self-ordering method II involves at least one cycle of the above-described anodizing treatment (D) and oxide film dissolution treatment (E). The larger the number of repetitions is, the more the degree of ordering of the pore array is increased.

The circularity of the micropores seen from the film surface side is dramatically improved by dissolving in oxide film dissolution treatment (E) all the anodized film formed by the preceding anodizing treatment (D). Therefore, this cycle is preferably repeated at least twice, more preferably at least three times and even more preferably at least four times.

In cases where this cycle is repeated at least twice, the conditions in each cycle of oxide film dissolution treatment and anodizing treatment may be the same or different. Alternatively, the treatment may be terminated by anodizing treatment.

[Constant Voltage Treatment]

In a constant voltage treatment, an anodized film is formed at a low speed over an extended period of time (e.g., from several hours to well over ten hours). The pore size depends on the voltage in this treatment method and it is therefore essential to control the voltage at a constant level in terms of preventing the micropores from being branched.

The average flow velocity of electrolytic solution in anodizing treatment is preferably from 0.5 to 20.0 m/min, more preferably from 1.0 to 15.0 m/min, and even more preferably from 2.0 to 10.0 m/min. By carrying out anodizing treatment at the flow velocity within the above-defined range, a uniform and high degree of ordering can be achieved. The method for causing the electrolytic solution to flow under the above conditions is not subject to any particular limitation. For example, a method involving the use of a common agitator such as a stirrer may be employed. The use of a stirrer in which the stirring speed can be controlled with a digital display is particularly desirable because it enables the average flow velocity to be regulated. An example of such a stirrer is the Magnetic Stirrer HS-50D (manufactured by As One Corporation).

Anodizing treatment may be carried out by, for example, a method in which current is passed through the aluminum substrate as the anode in a solution having an acid concentration of from 1 to 10 wt%.

The solution used in anodizing treatment is preferably an acid solution. A solution of sulfuric acid, phosphoric acid, chromic acid, oxalic acid, sulfamic acid, benzenesulfonic acid, amidosulfonic acid, glycolic acid, tartaric acid, malic acid or citric acid is more preferred. Of these, a solution of sulfuric acid, phosphoric acid, or oxalic acid is especially preferred. These acids may be used singly or in combination of two or more thereof.

The anodizing treatment conditions vary depending on the electrolytic solution employed, and thus cannot be strictly specified. However, the following conditions are generally preferred: an electrolyte concentration of from 0.1 to 20 wt%, a solution temperature of from -10 to 30°C, a current density of from 0.01 to 20 A/dm$^2$, a voltage of from 3 to 300 V, and an electrolysis time of from 0.5 to 50 hours. An electrolyte concentration of from 0.5 to 15 wt%, a solution temperature of from -5 to 25°C, a current density of from 0.05 to 15 A/dm$^2$, a voltage of from 5 to 250 V, and an electrolysis time of from 1 to 25 hours are more preferred. An electrolyte concentration of from 1 to 10 wt%, a solution temperature of from 0 to 20°C, a current density of from 0.1 to 10 A/dm$^2$, a voltage of from 10 to 200 V, and an electrolysis time of from 2 to 20 hours are even more preferred.

The treatment time in anodizing treatment is preferably from 0.5 minute to 16 hours, more preferably from 1 minute to 12 hours, and even more preferably from 2 minutes to 8 hours.

In the present invention, the anodized film formed by such anodizing treatment preferably has a thickness of from 1 to 1000 $\mu$m, more preferably from 5 to 500 $\mu$m, and even more preferably from 10 to 300 $\mu$m.

In the present invention, the anodized film formed by such anodizing treatment has an average micropore density of preferably from 50 to 1,500 micropores/$\mu$m$^2$.

It is preferable for the micropores to have a surface coverage of from 20 to 50%.

The surface coverage of the micropores is defined here as the ratio of the total surface area of the micropore openings to the surface area of the aluminum surface.

[Perforating Treatment Step]

The perforating treatment step is a step in which micropores formed by anodization are perforated after the above-described anodizing treatment step to obtain an insulating base.

More specifically, the perforating treatment step is carried out by, for example, a method in which the aluminum substrate (the portion represented by reference symbol 32 in FIG. 6D) is dissolved after the anodizing treatment step to remove the bottom (the portion represented by reference symbol 38d in FIG. 6D) of the anodized film, and a method in which the aluminum substrate and the anodized film in the vicinity of the aluminum substrate are cut after the anodizing treatment step.

Next, the former method which is a preferred embodiment is described in detail.

<Dissolution of Aluminum Substrate>

A treatment solution which does not readily dissolve the anodized film (alumina) but readily dissolves aluminum is used for dissolution of the aluminum substrate after the anodizing treatment step.
That is, use is made of a treatment solution which has an aluminum dissolution rate of at least 1 μm/min, preferably at least 3 μm/min, and more preferably at least 5 μm/min, and has an anodized film dissolution rate of 0.1 nm/min or less, preferably 0.05 nm/min or less, and more preferably 0.01 nm/min or less.
Specifically, a treatment solution which includes at least one metal compound having a lower ionization tendency than aluminum, and which has a pH of 4 or less or 8 or more, preferably 3 or less or 9 or more, and more preferably 2 or less or 10 or more is used for immersion treatment.

Preferred examples of such treatment solutions include solutions which are composed of, as the base, an aqueous solution of an acid or an alkali and which have blended therein a compound of, for example, manganese, zinc, chromium, iron, cadmium, cobalt, nickel, tin, lead, antimony, bismuth, copper, mercury, silver, palladium, platinum or gold (e.g., chloroplatinic acid), or a fluoride or chloride of any of these metals.
Of the above, it is preferable for the treatment solution to be based on an aqueous solution of an acid and to have blended therein a chloride compound.
Treatment solutions of an aqueous solution of hydrochloric acid in which mercury chloride has been blended (hydrochloric acid/mercury chloride), and treatment solutions of an aqueous solution of hydrochloric acid in which copper chloride has been blended (hydrochloric acid/copper chloride) are especially preferred from the standpoint of the treatment platitude.
There is no particular limitation on the composition of such treatment solutions. Illustrative examples of the treatment solutions that may be used include a bromine/methanol mixture, a bromine/ethanol mixture, and aqua regia.

Such a treatment solution preferably has an acid or alkali concentration of 0.01 to 10 mol/L and more preferably 0.05 to 5 mol/L.

In addition, such a treatment solution is used at a treatment temperature of preferably -10°C to 80°C and more preferably 0 to 60°C.

In the present invention, dissolution of the aluminum substrate is carried out by bringing the aluminum substrate having undergone the anodizing treatment step into contact with the above-described treatment solution. Examples of the contacting method include, but are not limited to, immersion and spraying. Of these, immersion is preferred. The period of contact in this process is preferably from 10 seconds to 5 hours, and more preferably from 1 minute to 3 hours.

<Removal of Bottom of Anodized Film>

The bottom of the anodized film after the dissolution of the aluminum substrate is removed by immersion in an aqueous acid or alkali solution. Removal of the bottom of the anodized film causes the micropores to extend therethrough.

The bottom of the anodized film is preferably removed by the method that involves previously immersing the anodized film in a pH buffer solution to fill the micropores with the pH buffer solution from the micropore opening side, and bringing the surface opposite from the openings (i.e., the bottom of the anodized film) into contact with an aqueous acid solution or aqueous alkali solution.

When this treatment is to be carried out with an aqueous acid solution, it is preferable to use an aqueous solution of an inorganic acid such as sulfuric acid, phosphoric acid, nitric acid or hydrochloric acid, or a mixture thereof. The aqueous acid solution preferably has a concentration of 1 to 10 wt%. The aqueous acid solution preferably has a temperature of 25 to 40°C.
When this treatment is to be carried out with an aqueous alkali solution, it is preferable to use an aqueous solution of at least one alkali selected from the group consisting of sodium hydroxide, potassium hydroxide and lithium hydroxide. The aqueous alkali solution preferably has a concentration of 0.1 to 5 wt%. The aqueous alkali solution preferably has a temperature of 20 to 35°C.

Specific examples of preferred solutions include a 40°C aqueous solution containing 50 g/L of phosphoric acid, a 30°C aqueous solution containing 0.5 g/L of sodium hydroxide, and a 30°C aqueous solution containing 0.5 g/L of potassium hydroxide.

The time of immersion in the aqueous acid solution or aqueous alkali solution is preferably from 8 to 120 minutes, more preferably from 10 to 90 minutes and even more preferably from 15 to 60 minutes.
In cases where the film is previously immersed in a pH buffer solution, a buffer solution suitable to the foregoing acids/alkalis is used.

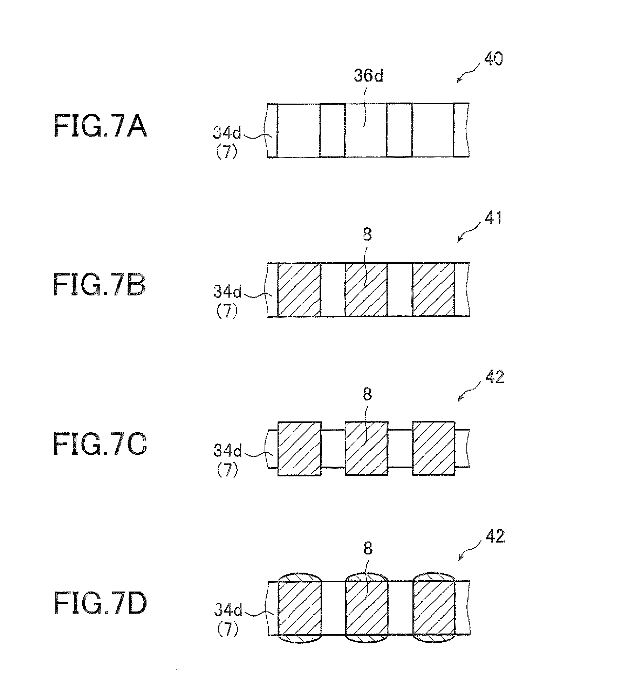

This perforating treatment step yields a structure shown in FIG. 6D after removal of the aluminum substrate 32 and the barrier layer 38d, that is, an insulating base 40 as shown in FIG. 7A.

On the other hand, an example of the latter method that may be advantageously used to cut the aluminum substrate and the anodized film in the vicinity of the aluminum substrate includes one which involves physically removing the aluminum substrate (portion represented by reference symbol 32 in FIG. 6D) and the bottom (portion represented by reference symbol 38d in FIG. 6D) of the anodized film by cutting with a laser beam or other various polishing treatments.

[Metal Filling Step]

The metal filling step is a step in which a metal as a conductive material is filled into the through micropores in the resulting insulating base after the perforating treatment step to obtain an anisotropic conductive member.
The metal to be filled makes up the conductive paths of the anisotropic conductive member. As described in connection with the anisotropic conductive member, exemplary metals that may be advantageously used include gold (Au), silver (Ag), copper (Cu), aluminum (Al), magnesium (Mg), nickel (Ni), tungsten (W), cobalt (Co), rhodium (Rh), an indium-doped tin oxide (ITO) and alloys consisting primarily of these metals.
A metal selected from the group consisting of copper, nickel and gold, or alloys consisting primarily of these metals are preferred in terms of electric conductivity and ease of filling.
In the anisotropic conductive member-manufacturing method, an electrolytic plating process or an electroless plating process may be used for the metal filling method.
In a conventionally known electrolytic plating process that is used for coloring or other purposes, it is difficult to selectively deposit (grow) metal inside micropores at a high aspect ratio, presumably because the deposited metal is consumed within the micropores and the plating does not grow even when electrolysis is carried out for at least a fixed period of time.
Therefore, in cases where an electrolytic plating process is used for metal filling, electrolytic plating is preferably carried out in the anisotropic conductive member-manufacturing method by a potential scanning process (potential scanning electrolysis) in which potential is scanned over time at a constant rate or a constant current process (controlled-potential electrolysis) in which electrolysis is carried out so that the current is always kept at a fixed value.
A rest period may be suitably provided during the electrolysis. In such a case, the rest period is preferably from a few or ten seconds to 10 minutes, and more preferably from 30 or 60 seconds to 10 minutes. By suitably providing a rest period in this way, hydrogen gas generated in the through micropores is sufficiently removed to enable an electrochemical reaction within the through micropores to proceed smoothly. It is particularly preferred for the rest period to be up to 10 minutes because damage to the anodized film making up the insulating base (e.g., chemical dissolution) is reduced.
Ultrasonic application is also desired to promote agitation of the electrolytic solution and degassing of hydrogen gas generated within the through micropores.
In addition, the electrolysis voltage is usually -20 V or less and desirably -5 V or less, but potential scanning electrolysis is preferably carried out at an initial potential of 0 V. When carrying out potential scanning electrolysis, it is desirable to use also cyclic voltammetry. To this end, use may be made of potentiostats such as those available from Solartron, BAS Inc., Hokuto Denko Corporation and Ivium Technologies. On the other hand, constant current electrolysis is preferably carried out at a current density of 0.1 to 5 A/dm$^2$ and more preferably 0.5 to 3 A/dm$^2$.
Plating may be carried out using a plating solution known in the art.
More specifically, when copper is to be deposited, an aqueous solution of copper sulfate may generally be used. The concentration of copper sulfate is preferably from 1 to 600 g/L. The copper sulfate solution is more preferably saturated. Deposition can be promoted by adding hydrochloric acid to the electrolytic solution. In such a case, the concentration of hydrochloric acid is preferably from 10 to 20 g/L.
When gold is to be deposited, it is desirable to carry out plating by direct current electrolysis using a sulfuric acid solution of a tetrachloroaurate.
On the other hand, according to the electroless plating process, it takes much time to completely fill the micropores having a high aspect ratio with a metal and it is therefore desirable to fill the metal by the electrolytic plating process in the anisotropic conductive member-manufacturing method.
For example, the method described in JP 3-266306 A, and more specifically the method in which the insulating base obtained by the perforating treatment step is immersed in a gold cyanide plating bath at 60°C to deposit the metal on the wall surfaces of the through micropores are used for the conditions of the electroless plating process.
Another exemplary method for metal filling includes the method described in JP 4-170036 A. More specifically, use may be made of the method which involves disposing the insulating base obtained by the perforating treatment step on the electrodeposition electrode and performing electrodeposition by using the electrodeposition electrode as the cathode (see FIG. 1(d) of this patent document).
This metal filling step yields a precursor 41 of the anisotropic conductive member shown in FIG. 7B.

[Surface Planarization Treatment]

In the anisotropic conductive member-manufacturing method, the metal filling step is preferably followed by mechanical polishing and particularly a surface planarization step in which the front side and the back side of the anisotropic conductive member are planarized by chemical mechanical polishing.
By carrying out chemical mechanical polishing (CMP), the front and back sides of the insulating base after metal filling (i.e., anisotropic conductive member) can be planarized while removing excess metal adhering to the surfaces. CMP treatment may be carried out by using a CMP slurry such as PNANERLITE-7000 available from Fujimi Inc., GPX HSC800 available from Hitachi Chemical Co., Ltd., or CL-1000 available from AGC Seimi Chemical Co., Ltd.

[Protrusion-Forming Step]

The protrusion-forming step is a step which follows the metal filling step (the surface planarization step if the above-described CMP treatment was carried out; this also applies to the following description) and in which the ends of the conductive paths formed are protruded from the surface of the insulating base to obtain the anisotropic conductive member.

More specifically, the ends of the conductive paths can be protruded from the surface of the insulating base by performing trimming treatment and/or electrodeposition treatment as described below, but solder portions may be formed by application to the ends of the conductive paths depending on the pitch or diameter of the conductive paths.

<Trimming Treatment>

Trimming is a treatment in which only part of the insulating base at the surfaces of the anisotropic conductive member is removed after the metal filling step to protrude the conductive paths from the anisotropic conductive member surfaces.

Trimming treatment can be carried out under the same treatment conditions as those of the above-described oxide film dissolution treatment (E) provided a metal making up the conductive paths is not dissolved. It is particularly preferred to use phosphoric.acid with which the dissolution rate is readily controlled.

Trimming treatment yields the anisotropic conductive member 42 shown in FIG. 7C.

<Electrodeposition Treatment>

In the anisotropic conductive member-manufacturing method, the trimming treatment step may be replaced or followed by electrodeposition treatment in which a conductive metal which is the same as or different from the one filled into the micropores is further deposited only on the surfaces of the conductive paths 8 shown in FIG. 7B (FIG. 7D).

In the present invention, electrodeposition is a treatment which also includes electroless plating making use of differences in the electronegativity of dissimilar metals.

Electroless plating is a step in which the insulating base is immersed in an electroless plating solution (e.g., a solution obtained by appropriately mixing a reducing agent treatment solution having a pH of 6 to 13 with a noble metal-containing treatment solution having a pH of 1 to 9).

Electrodeposition treatment yields the anisotropic conductive member 42 shown in FIG. 7D.

In the present invention, electrodeposition treatment is preferably used in the protrusion-forming step because the joint surfaces of the conductive paths to the testing electrodes may be formed of a different material from the contact surfaces between the conductive paths and the test electrodes (electric contacts if they are disposed).

More specifically, in cases where the protrusions of the conductive paths are formed by electrodeposition treatment, noble metals such as gold (Au) and copper (Cu) or alloys consisting primarily of these metals are preferably deposited to form the protrusions on the joint side to the testing electrodes in terms of ease of joining.

High hardness metals such as nickel (Ni), tungsten (W) and cobalt (Co) or alloys consisting primarily of these metals are preferably deposited to form the protrusions on the side of contact with the test electrodes (electric contacts if they are disposed) in terms of durability against the repetitive contact.

In the present invention, in consideration of the joining between the testing circuit board and the anisotropic conductive member to be described later, such joining is preferably followed by formation of the protrusions on the side of the contact surfaces with the test electrodes (electric contacts if they are disposed).

More specifically, in the embodiment in which a pressure head to be described later is used to join the testing circuit board to the anisotropic conductive member, trimming treatment and electrodeposition treatment are preferably not carried out on the surfaces of contact with the test electrodes (electrical points if they are disposed) before the end of the joining in order to protect the conductive paths (protrusions) on the side of the test electrodes from the pressure head.

In the present invention, there is also a preferred embodiment in which, in terms of protecting the conductive paths (protrusions) on the side of the test electrodes from the pressure head, an easy peeling resin layer (e.g., Teflon (registered trademark), polyimide, laminate or the like) is formed on the surfaces of the conductive paths contacting the test electrodes (electric contacts if they are disposed) to substantially the same height as the conductive paths (protrusions) on the side the test electrodes even after trimming treatment and electrodeposition treatment have been carried out.

[Surface Hardening Treatment]

In the anisotropic conductive member-manufacturing method, conventionally known surface hardening treatments such as DLC coating and ion plating using titanium (Ti), titanium nitride (TiN) or the like may be carried out in terms of improving the hardness and wear resistance of the surface of each protrusion formed by the protrusion-forming step.

[Protective Film-Forming Treatment]

In the anisotropic conductive member-manufacturing method, the micropore size changes with time due to hydration of the material of the insulating base made of alumina with moisture in the air and therefore protective film-forming treatment is preferably carried out before the metal filling step.

Illustrative examples of protective films include inorganic protective films containing elemental zirconium and/or elemental silicon, and organic protective films containing a water-insoluble polymer.

The method of forming an elemental zirconium-containing protective film is not subject to any particular limitation, although a commonly used method of treatment involves direct immersion in an aqueous solution in which a zirconium compound is dissolved. From the standpoint of the strength and stability of the protective film, the use of an aqueous solution in which a phosphorus compound has also been dissolved is preferred.

Illustrative examples of the zirconium compound that may be used include zirconium, zirconium fluoride, sodium hexafluorozirconate, calcium hexafluorozirconate, zirconium chloride, zirconium oxychloride, zirconium oxynitrate, zirconium sulfate, zirconium ethoxide, zirconium propoxide, zirconium butoxide, zirconium acetylacetonate, tetrachlorobis (tetrahydrofuran) zirconium, bis (methylcyclopentadienyl) zirconium dichloride, dicyclopentadienylzirconium dichloride and ethylenebis(indenyl)zirconium (IV) dichloride. Of these, sodium hexafluorozirconate is preferred.

From the standpoint of the uniformity of the protective film thickness, the concentration of the zirconium compound in the aqueous solution is preferably from 0.01 to 10 wt%, and more preferably from 0.05 to 5 wt%.

Illustrative examples of the phosphorus compound that may be used include phosphoric acid, sodium phosphate, calcium phosphate, sodium hydrogen phosphate and calcium hydrogen phosphate. Of these, sodium hydrogen phosphate is preferred.

From the standpoint of the uniformity of the protective film thickness, the concentration of the phosphorus compound in the aqueous solution is preferably from 0.1 to 20 wt%, and more preferably from 0.5 to 10 wt%.

The treatment temperature is preferably from 0 to 120°C, and more preferably from 20 to 100°C.

The method of forming a protective film containing elemental silicon is not subject to any particular limitation, although a commonly used method of treatment involves direct immersion in an aqueous solution in which an alkali metal silicate is dissolved.

The thickness of the protective film can be adjusted by varying the ratio between the silicate ingredients silicon dioxide $SiO_2$ and alkali metal oxide $M_2O$ (generally represented as the molar ratio $[SiO_2]/[M_2O]$) and the concentrations thereof in the aqueous solution of an alkali metal silicate.

It is especially preferable here to use sodium or potassium as M.

The molar ratio $[SiO_2]/[M_2O]$ is preferably from 0.1 to 5.0, and more preferably from 0.5 to 3.0.

The $SiO_2$ content is preferably from 0.1 to 20 wt%, and more preferably from 0.5 to 10 wt%.

The organic protective film is preferably obtained by a method which involves direct immersion in an organic solvent in which a water-insoluble polymer is dissolved, followed by heating treatment to evaporate off only the solvent. Illustrative examples of the water-insoluble polymer include polyvinylidene chloride, poly(meth)acrylonitrile, polysulfone, polyvinyl chloride, polyethylene, polycarbonate, polystyrene, polyamide and cellophane.

Illustrative examples of the organic solvent include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone and toluene.

The concentration is preferably from 0.1 to 50 wt%, and more preferably from 1 to 30 wt%.

The heating temperature during solvent volatilization is preferably from 30 to 300°C, and more preferably from 50 to 200°C.

Following protective film-forming treatment, the anodized film including the protective film has a thickness of preferably from 0.1 to 1000 μm, and more preferably from 1 to 500 μm.

In the anisotropic conductive member-manufacturing method, the hardness and the heat cycle resistance can be controlled by carrying out heating treatment.

For example, the heating temperature is preferably at least 100°C, more preferably at least 200°C and even more preferably at least 400°C. The heating time is preferably from 10 seconds to 24 hours, more preferably from 1 minute to 12 hours and even more preferably from 30 minutes to 8 hours. Such heating treatment improves the hardness while suppressing the expansion and contraction during the heat cycle of heating and cooling in the semiconductor manufacturing step.

Next, the method of manufacturing the probe card of the present invention using the anisotropic conductive member obtained by such a process is described in detail.

The probe card of the present invention can be manufactured by joining the anisotropic conductive member to the testing circuit board, more specifically by joining the conductive paths of the anisotropic conductive member to the testing electrodes of the testing circuit board.

In cases where the probe card of the present invention includes the probe needles as the electric contacts, the probe card can be manufactured by, for example, joining the anisotropic conductive member to the testing circuit board, then bringing the probe needles into contact with the conductive paths of the anisotropic conductive member.

The joining method and the contacting method are specifically described below.

[Joining]

Exemplary processes that may be preferably used to join the anisotropic conductive member to the testing circuit board include thermocompression bonding and ultrasonic connection.

<Thermocompression Bonding>

Thermocompression bonding is a process in which mutual diffusion bonding of metals between the testing electrodes of the testing circuit board and the conductive paths of the anisotropic conductive member is utilized to perform joining under application of a predetermined pressure at a temperature equal to or below the melting points of the metals. The temperature depends on the metals used in the testing electrodes and the conductive paths and is therefore not particularly limited. However, the temperature is preferably at least 150°C and more preferably from 180 to 300°C.

Likewise, the pressure depends on the metals used in the testing electrodes and the conductive paths and is therefore not particularly limited. However, the pressure is preferably from 0.2 to 1.0 MPa and more preferably from 0.4 to 0.8 MPa. A commercially available thermocompression bonding device (MODEL6000 manufactured by HiSOL Inc.) may be used for thermocompression bonding.

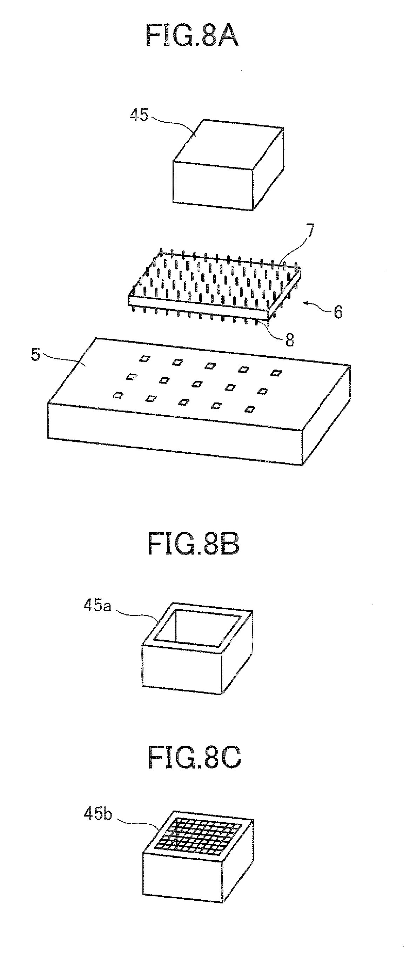

FIG. 8 schematically illustrates a preferred embodiment of a method of bonding the anisotropic conductive member to the testing circuit board by thermocompression.

In the present invention, an embodiment as shown in FIG. 8 is preferably used in which a predetermined pressure head 45 is used to press the anisotropic conductive member 6 under heating conditions against the surface of the testing circuit board 5 at which the testing electrodes 4 are provided.

A head 45a whose back surface (surface on the side of contact with the anisotropic conductive member 6) is in a frame shape and a head 45b whose back surface is in a mesh shape are preferably used for the pressure head 45.

[Ultrasonic Bonding]

Ultrasonic bonding is a process in which a pressure head is used to apply ultrasonic vibrations and appropriately apply a predetermined load to join the conductive paths of the anisotropic conductive member to the testing electrodes of the testing circuit board.

The amplitude is preferably set in a range of 2 to 10 $\mu$m corresponding to 10 to 20% of the area of the joined electrodes. Likewise, the load is preferably set to 0.1 to 10 g per electrode and 100 g to 11 kg/mm$^2$ per unit area of the joined electrodes. A commercially available ultrasonic bonding device (FC2000 manufactured by Toray Industries, Inc.) may be used for ultrasonic bonding.

[Contact]

In cases where the probe card does not have the fixing holder for fixing the probe needles, the probe needles are preferably brought into contact with the conductive paths of the anisotropic conductive member by joining them together so that the probe needles are not easily detached from the conductive paths. However, in cases where the probe card has the fixing holder, the conductive paths and the probe needles are preferably sandwiched between the fixing holder and the testing board and brought into contact with each other in an appropriately detachable manner as shown in FIG. 4.

In the testing method using the above-described probe card of the present invention, the portions of contact with the test electrodes (protrusions of the conductive paths, electric contacts) are preferably brought into contact with an alkaline aqueous solution or an acidic aqueous solution before testing the electrical properties of the test object. More specifically, a preferred embodiment of the testing method of the present invention includes a pretreatment step in which the protrusions of the conductive paths on the side of contact with the test electrodes are brought into contact with an alkaline aqueous solution or an acidic aqueous solution, and a testing step in which the protrusions after the pretreatment step are brought into contact with the test electrodes to test the electrical properties of the test object.

In cases where the probe card of the present invention has the above-described electric contacts, a preferred embodiment of the testing method of the present invention includes a pretreatment step in which the electric contacts are brought into contact with an alkaline aqueous solution or an acidic aqueous solution before testing the electrical properties of the test object, and a testing step in which the electric contacts after the pretreatment step are brought into contact with the test electrodes to test the electrical properties of the test object.

Examples of the alkaline aqueous solution or the acidic aqueous solution used for the contact with the portions of contact with the test electrodes (protrusions of the conductive paths, electric contacts) include those illustrated in the above-described trimming and oxide film dissolution treatments.

Illustrative examples of the alkaline aqueous solution that may be preferably used include 1 to 35 wt% aqueous sodium hydroxide solution, 1 to 35 wt% aqueous potassium hydroxide solution and aqueous ammonium persulfate solution. The aqueous solution preferably has a pH of 12 or more and more preferably 13 or more.

Illustrative examples of the acidic aqueous solution that may be preferably used include 0.01 to 0.05 wt% hydrogen peroxide solution, 5 to 30 wt% aqueous sulfuric acid solution and 1 to 10 wt% aqueous phosphoric acid solution.

In the present invention, these aqueous solutions may contain an alcohol such as methanol or isopropanol in an amount of 5 to 20 wt% or may contain a degreasing agent for aqueous solutions. The solutions may contain a chloride such as zinc chloride in an amount of 0.5 to 5 wt%.

In the present invention, there is no particular limitation on the treatment conditions and the treatment method used to bring the portions of contact with the test electrodes (protrusions of the conductive paths, electric contacts) into contact with the alkaline aqueous solution or the acidic aqueous solution.

The treatment temperature varies greatly with the type of solution and is preferably from about 30°C to about 85°C.

The treatment time also varies greatly with the type of solution and is preferably from about 1 second to about 600 seconds and more preferably from 30 seconds to 300 seconds.

On the other hand, as for the treatment method, an absorbent material impregnated with an alkaline aqueous solution or an acidic aqueous solution is preferably used in terms of contact efficiency.

The absorbent material is not particularly limited as long as it can be impregnated with a liquid, and examples thereof include a chemical absorbent, a gel-like substance, a glass fiber filter, a nonwoven fabric and a spongy.

More specifically, of the chemical absorbents available from 3M, a sheet type (P-110) and a folded type (C-FL550DD) are advantageously used.

Illustrative examples of the gel-like substance that may be advantageously used include a sheet-like gel such as polyacrylamide gel. The gel-like substance preferably contains sodium hydroxide in an amount of about 20 to about 30 wt% or potassium hydroxide in an amount of about 15 to 25 wt%.

For example, a glass fiber filter treated with an organic binder may be advantageously used. More specifically, a glass fiber filter treated with an acrylic resin may be used. Commercial products such as GC-90 and GS-25 available from Advantec Toyo Kaisha, Ltd. may also be used for the glass fiber filter.

Illustrative examples of the nonwoven fabric that may be advantageously used include polyolefin nonwoven fabric.

Of these absorbent materials, the chemical absorbent, gel-like substance and glass fiber filter are preferred and the chemical absorbent is particularly preferred.

The treatment method in which the portions of contact with the test electrodes (protrusions of the conductive paths, electric contacts) are immersed in a vessel containing the above-described alkaline aqueous solution or acidic aqueous solution may be used.

In this case, the portions of contact after the immersion may be washed with water, but may be washed by using a cleaning member (such as the above-described absorbent material) impregnated with water and particularly pure water, the cleaning member being capable of impregnation with the above-described alkaline aqueous solution or acidic aqueous solution (absorption of water).

According to the testing method of the present invention, it is preferred to optionally carry out polishing treatment before the portions of contact with the test electrodes and particularly the protrusions of the conductive paths are brought into contact with the alkaline aqueous solution or the acidic aqueous solution.

The same treatment as the surface planarization treatment may be carried out for polishing treatment.

Even in cases where the protrusions of the conductive paths are worn out, by bringing the protrusions into contact with the alkaline aqueous solution or the acidic aqueous solution after the end of such a polishing treatment, the same effect as that of the above-described surface planarization treatment or trimming treatment can be achieved. In other words, protrusions of the conductive paths can be regenerated.

The testing method according to this embodiment involves bringing the portions of contact with the test electrodes (protrusions of the conductive paths, electric contacts) into contact with the alkaline aqueous solution or the acidic aqueous solution before testing the electrical properties of the test object and therefore enables substances adhering to the contact portions or an oxide film to be removed to achieve consistent testing.

The testing method according to this embodiment enables the portions of contact with the test electrodes to be kept in an electrically active state and therefore the electrical properties can be tested even in a mode of use in which the load applied is low.

The present invention can also provide a probe tester including the above-described probe card of the present invention.

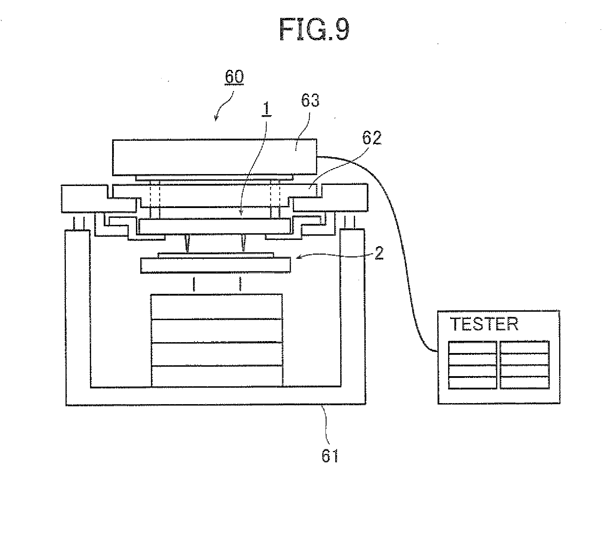

FIG. 9 is a schematic view showing the schematic configuration of a probe tester in a preferred embodiment.

The probe tester is not particularly limited as long as a conventionally known probe card is replaced by the probe card of the present invention. For example, a probe tester 60 of the present invention preferably includes a probe card 1 of the present invention, a test object 2 which includes test electrodes, a prober 61 accommodating the test object 2, an interface ring 62 connected to the prober 61 and a tester head 63 as shown in FIG. 9.

The conductive member according to a second aspect of the present invention (hereinafter referred to simply as "conductive member of the present invention") is described below in detail.

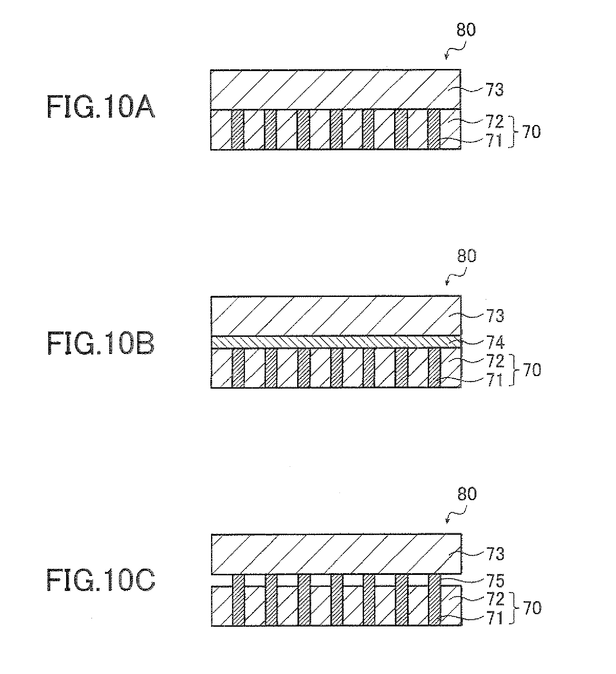

As shown in FIG. 10A, the conductive member of the present invention is a conductive member 80 including an anisotropic conductive structure 70 and a conductive layer 73 formed thereon. The anisotropic conductive structure 70 includes an anodized aluminum film 72 and conductive paths 71 made of a conductive material and extending through the anodized film in its thickness direction with the conductive paths electrically connecting to the conductive layer.

The plurality of conductive paths made of a conductive material extend through the anodized film in a mutually isolated state at a density of preferably $1 \times 10^6$ to $1000 \times 10^6$ paths/$\mu$m$^2$ and more preferably $3 \times 10^6$ to $300 \times 10^6$ paths/$\mu$m$^2$.

As for the flatness, a warpage percentage of up to 5% and a torsion percentage of up to 5% are preferred, and a warpage percentage of up to 1% and a torsion percentage of up to 1% are more preferred.

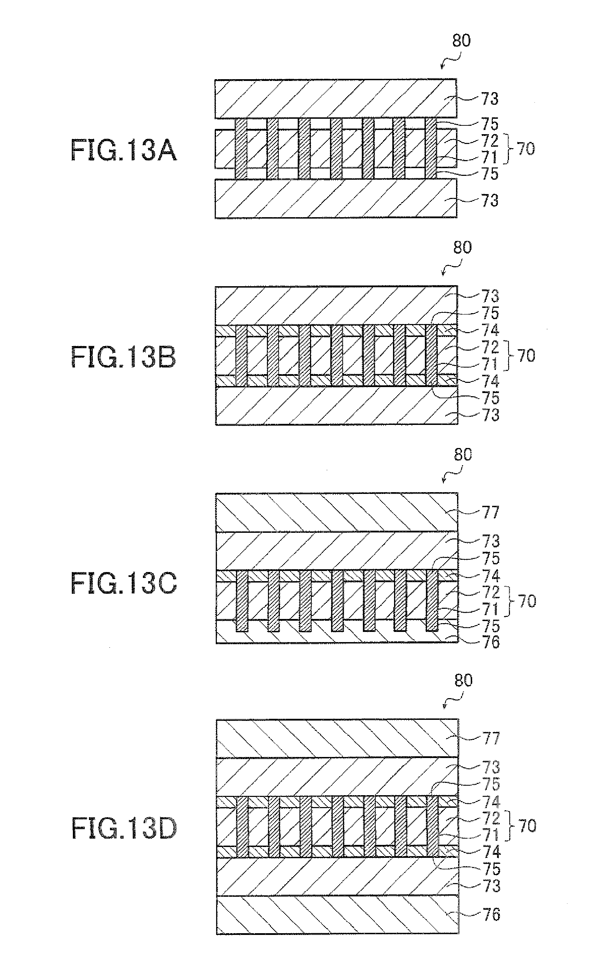

In addition, a photosensitive resin layer 77 may be formed on the conductive layer 73 as shown in FIG. 13C and the conductive member 80 may optionally include appropriately selected other layers. Each of the layers may be a monolayer or a layer composed of two or more sublayers. Unless otherwise specified, the terms are as defined by JISC-5603-1987 (Terminology of Printed Circuit Board).

(1) Conductive Layer

The conductive layer is a layer made of a conductive material. The conductive material is a material having a high electric conductivity (conductivity) and is also called a "good conductor" and simply a "conductor." The electric conductivity is a physical value which varies from substance to substance in a wide range and spans a wide range from metals to ceramics. In general, a material whose conductivity is equal to or larger than that of graphite (with an electric conductivity of $10^6$ S/m) is called a "conductor." The electric conductivity of $10^6$ S/m indicates the ease of flow of electricity in which a conductor with a sectional area of 1 mm$^2$ and a length of 1 m takes a resistance of 1 $\Omega$.

More specifically, typical conductive materials such as Au, Ag, Cu and Al are known. Use may be made of alloys consisting primarily of these metals and high melting point metals such as Ti, Mo, Ta and W.

Exemplary methods of forming the conductive layer include diffusion bonding by means of thermocompression, application of a conductive adhesive layer, electron beam evaporation, sputtering and DVD.

In addition, graphite sheets and conductive resin sheets are also included.

The multilayered conductive member of the present invention having a low-k film (SiO$_2$, SiN) formed on the conductive layer made of Cu or the like can be used as a multilayer circuit board.

(2) Method of Forming Conductive Layer

An exemplary method of forming the conductive layer by direct connection to the anisotropic conductive structure includes forming the conductive layer after the surface of the anisotropic conductive structure has been polished. Metal foils such as gold, copper and aluminum can be joined by thermocompression making use of diffusion bonding. Desirable conditions of the thermocompression bonding include a temperature of 200°C to 350°C and a pressure of 0.4 to 0.8 MPa.

Another method that may be used is to apply conductive foil to the anisotropic conductive structure. In terms of the electric conductivity and the price, copper foil is the most preferred conductive foil, and use of copper enables the anisotropic conductive structure to be employed as a copper-clad laminate. Aluminum foil, copper foil and aluminum alloy foil may be appropriately used.

According to another method, an Invar alloy with a low coefficient of thermal expansion or titanium having excellent corrosion resistance may also be deposited by vacuum evaporation, sputtering or CVD. When formed by sputtering, the metal vapor-deposited film has high adhesion and is preferred. In cases where copper foil or the like is used for the conductive layer, corrosion-resistant metals such as gold and titanium may also be further vapor-deposited to prevent oxidation of the copper foil or the like.

It is also possible to use a commercially available graphite sheet for the conductive layer. Of those metals, metals which are not liable to diffusion bonding, including high melting point metals such as tungsten (W), hard metals such as Ni and Cr and a graphite sheet are not easily connected by thermocompression bonding. An anisotropic conductive adhesive may be used for adhesion. A method in which the anisotropic conductive structure is coated with an adhesive and pasted by a laminator is preferred because the adhesive layer can have a uniform thickness.

In the conductive member of the present invention, the conductive layer may be formed on one or both sides of the anisotropic conductive structure. The type of the conductive layers used on the front and back sides may be appropriately changed. Metal foil may be applied to both the surfaces. If there is only a small amount of laser absorption, it is also possible to directly perform patterning by ablation through exposure to high power laser light.

(3) Conductive Adhesive Layer

The conductive adhesive layer is a layer which is made of a mixture of a resin used for adhesion and a metal used for electrical conduction (conductive filler) and has electrical conductivity and the property of adhering the substances to each other. In general, a combination of an epoxy resin and silver (Ag) is often used.

In a mode of use of the adhesive, the anisotropic conductive adhesive is applied to the surface of the conductive layer and/or the anisotropic conductive structure, the adhesion surfaces are joined together and the adhesive is cured by application of heat as in screen printing. The surfaces can be joined together by application of heat at around +150°C for about 30 minutes. Anisotropic conductive adhesives exhibiting electric conductivity in areas deformed by application of pressure are also commercially available and may be used depending on the intended use.

More specifically, commercially available anisotropic conductive adhesives illustrated below may be used.

- DOHDENT NH-070A(L) available from Nihon Handa Co., Ltd.;
- 3300 Series available from ThreeBond Co., Ltd.;
- 3380B: two-component epoxy conductive adhesive
- 3303N: SMD silicone anisotropic conductive adhesive for use in quartz oscillators
- 3305C: adhesive for use in hard disk drive magnetic heads.

When an adhesive is used, a thermocompression device of a type in which pressure is applied with a flat plate may be used for the adhesion device in cases where the solvent content is low or the adhesive is of a high viscosity. In cases where a conductive member having a length exceeding 3 m or the number of lamination is one, a commercially available laminator may be used. In this case, it is preferred to use a low-viscosity adhesive containing a large amount of solvent in terms of flatness.

The conductive layer can be adhered to the anisotropic conductive structure by appropriately setting the viscosity of the adhesive, and the flatness and the pressure of the roll of the laminator.

(4) Anisotropic Conductive Structure

The anisotropic conductive structure and its manufacturing method are described below in detail.
The anisotropic conductive structure has an insulating base and a plurality of conductive paths made of a conductive material, insulated from one another, and extending through the insulating base in the thickness direction of the insulating base, one end of each of the conductive paths being exposed on one side of the insulating base, and the other end of each of the conductive paths being exposed on the other side thereof.
Next, the anisotropic conductive structure is described by reference to FIG. 2.

FIG. 2 shows simplified views of a preferred embodiment of the anisotropic conductive member (structure); FIG. 2A being a front view and FIG. 2B being a cross-sectional view taken along the line IB-IB of FIG. 2A.
The anisotropic conductive structure 6 includes the insulating base 7 and the plurality of conductive paths 8 made of a conductive material.
The conductive paths 8 preferably extends through the insulating base 7 in a mutually insulated state and the length in the axial direction of the conductive paths 8 is equal to or larger than the length (thickness) in the thickness direction Z of the insulating base 7 and the density is from $1 \times 10^6$ to $1000 \times 10^6$ conductive paths/$\mu m^2$ and more preferably from $3 \times 10^6$ to $300 \times 10^6$ conductive paths /$\mu m^2$.
Each conductive path 8 is formed with one end exposed on one side of the insulating base 7 and the other end exposed on the other side thereof. However, each conductive path 8 is preferably formed with one end protruding from the surface 7a of the insulating base 7 and the other end protruding from the surface 7b of the insulating base 7 as shown in FIG. 2B. In other words, both the ends of each conductive path 8 preferably have the protrusions 10a and 10b protruding from the main surfaces 7a and 7b of the insulating base, respectively.
In addition, each conductive path 8 is preferably formed so that at least the portion within the insulating base 7 (hereinafter also referred to as "conductive portion 11 within the base") is substantially parallel (parallel in FIG. 2) to the thickness direction Z of the insulating base 7.

Next, the materials and sizes of the insulating base and the conductive paths and their forming methods are described.

[Insulating Base]

The insulating base making up the anisotropic conductive structure is a structure composed of an anodized aluminum film having micropores therein. Alumina has an electric resistivity of about $10^{14}\Omega\cdot$cm as in the insulating base making up a conventionally known anisotropic conductive film (e.g., thermoelastic elastomer).

The porous alumina film is also called an alumite film and refers to an oxide film obtained by anodizing aluminum in an acidic aqueous solution. The oxide film is called an anodized film. The shape of the aluminum oxide film formed varies with the type of electrolytic solution, and various electrolytic solutions are used depending on the purpose and intended use. The most popular anodizing method uses an electrolytic solution containing dilute sulfuric acid. The resulting alumite film is a porous film including a barrier layer and countless micropores and is of a hexagonal prism cell assembly such as a honeycomb. Each cell has in its center a micropore, which reaches the barrier layer formed at the interface with the substrate. In the present invention, the aluminum substrate and the barrier layer are removed to obtain a membrane (film) and the micropores are filled with a conductive material.

In the present invention, the insulating base preferably has a thickness (as shown by reference symbol 12 in FIG. 2B) of from 10 to 200 $\mu$m, more preferably from 20 to 150 $\mu$m and even more preferably from 30 to 100 $\mu$m. At an insulating base thickness within the foregoing range, the insulating base can be handled with ease.

In the present invention, the width between neighboring conductive paths (the portion represented by reference symbol 13 in FIG. 2B) in the insulating base is preferably at least 10 nm, more preferably from 20 to 500 nm, and even more preferably from 30 to 450 nm. At a width between neighboring conductive paths of the insulating base within the foregoing range, the insulating base functions fully as an insulating barrier.

In the present invention, the insulating base has micropores arrayed so as to have a degree of ordering as defined by formula (i) of preferably at least 10%, more preferably at least 30% and even more preferably at least 50%.

$$\text{Degree of ordering (\%) = B/A} \times 100 \quad (i)$$

In formula (i), A represents the total number of micropores in a measurement region, and B represents the number of specific micropores in the measurement region for which, when a circle is drawn so as to be centered on the center of gravity of a specific micropore and so as to be of the smallest radius that is internally tangent to the edge of another micropore, the circle includes centers of gravity of six micropores other than the specific micropore. The degree of ordering is described in detail in JP 2007-332437 A.

In the present invention, the insulating base can be manufactured by anodizing the aluminum substrate and perforating the micropores formed by anodization. The anodizing treatment step and the perforating treatment step will be described in detail in connection with the anisotropic conductive structure-manufacturing method to be referred to later.

[Conductive path]

The conductive paths making up the anisotropic conductive structure are made of a conductive material. The conductive material is not particularly limited as long as the material used has an electric resistivity of not more than $10^3 \Omega\cdot$cm. Illustrative examples of the conductive material that may be preferably used include metals such as gold (Au), silver (Ag), copper (Cu), aluminum (Al), magnesium (Mg) and nickel (Ni); low melting point metals (solders and other alloys, Ga), conductive polymers and so-called organic materials such as carbon nanotubes.

A method in which a low melting point conductive substance or a low melting point metal (solder or other alloy) is melted and filled under application of pressure, a method in which a high molecular weight conductive monomer is filled and polymerized, a method in which a high molecular weight monomer is filled and polymerized and the polymer is burnt in the absence of oxygen to obtain a carbon material are described in Examples of JP 2-68812 A.

In addition, JP 4-126307 A discloses a method of electrolytic deposition of Au or Ni, and a method of filling a conductive material by application of a metal paste, electroless plating, vapor deposition, sputtering, CVD or other dry plating process.

Of these, metals are preferred, copper, gold, aluminum and nickel are more preferred, and copper and gold are most preferred in terms of electric conductivity.

In terms of cost, it is more preferred to use gold for only forming the surfaces of the conductive paths exposed at or protruding from both the surfaces of the insulating base (hereinafter also referred to as "end faces").

In the present invention, the conductive paths are columnar and have a diameter (as shown by reference symbol 14 in FIG. 2B) of preferably at least 15 nm, more preferably from 20 to 350 nm, and even more preferably from 50 to 300 nm.

At a conductive path diameter within the above-defined range, when electrical signals are passed through, sufficient responses can be obtained, thus enabling the conductive member of the present invention to be more advantageously used as a testing connector for electronic components.

In the present invention, when both the ends of the conductive path protrude from both the surfaces of the insulating base, the protrusions (in FIG. 2B, the portions represented by reference symbols 10a and 10b; also referred to below as "bumps") have a height of preferably from 5 to 500 nm, and more preferably from 10 to 200 nm. At a bump height in this range, connectivity with the electrode (pads) on an electronic component improves.

In the present invention, the conductive paths are mutually insulated by the insulating base and their density is preferably from $1 \times 10^6$ to $1000 \times 10^6$ conductive paths/$\mu m^2$, and more preferably from $3 \times 10^6$ to $300 \times 10^6$ conductive paths/$\mu m^2$.

At a conductive path density within the above-defined range, the conductive member of the present invention can be used as a testing connector for electronic components such as semiconductor devices even today when still higher levels of integration have been achieved.

In the present invention, the center-to-center distance between neighboring conductive paths (the portion represented by reference symbol 9 in FIG. 2; also referred to below as "pitch") is preferably from 50 to 600 nm, more preferably from 90 to 550 nm, and even more preferably from 190 to 520 nm. At a pitch within the above-defined range, a balance is easily struck between the diameter of the conductive paths and the width between the conductive paths (insulating barrier thickness).

In the present invention, the conductive paths can be formed by filling a conductive material into the through micropores in the insulating base.

The conductive material filling treatment step will be described in detail in connection with the anisotropic conductive structure-manufacturing method to be referred to later.

As described above, the anisotropic conductive structure preferably has an insulating base thickness of from 30 to 100 $\mu m$ and a conductive path diameter of from 50 to 350 nm, because electrical conduction can be confirmed at a high density while maintaining high insulating properties.

The method of manufacturing the anisotropic conductive structure includes at least:

(1) an anodizing treatment step in which an aluminum substrate is anodized to form an anodized aluminum film having micropores therein;
(2) a perforating treatment step in which micropores formed by anodization are perforated after the anodizing treatment step to obtain an insulating base; and
(3) a conductive material filling step in which a conductive material is filled into through micropores in the resulting insulating base after the perforating treatment step to obtain the anisotropic conductive structure.

Next, an aluminum substrate that may be used, and each treatment step carried out on the aluminum substrate are described in detail.

[Aluminum Substrate]

The aluminum substrate that may be used in the anisotropic conductive structure-manufacturing method is not subject to any particular limitation. Illustrative examples include pure aluminum plate; alloy plates composed primarily of aluminum and containing trace amounts of other elements; substrates made of low-purity aluminum (e.g., recycled material) on which high-purity aluminum has been vapor-deposited; substrates such as silicon wafers, quartz or glass whose surface has been covered with high-purity aluminum by a process such as vapor deposition or sputtering; and resin substrates on which aluminum has been laminated.

Of the aluminum substrate used in the anisotropic conductive structure-manufacturing method, the surface on which an anodized film is to be formed by the anodizing treatment step to be described below has an aluminum purity of preferably at least 95.0 wt%, more preferably at least 99.5 wt% and even more preferably at least 99.99 wt%. It is preferable for the aluminum purity to fall within the above range, because the orderliness of the micropore array is improved.

In the aluminum substrate used in the anisotropic conductive structure-manufacturing method, the surface of the aluminum substrate on which the subsequently described anodizing treatment step is to be carried out is preferably subjected beforehand to degreasing treatment and mirror-like finishing treatment.

<Heat Treatment>

Heat treatment is preferably carried out at a temperature of from 200 to 350°C for a period of about 30 seconds to about 2 minutes. Such heat treatment improves the orderliness of the array of micropores formed by the subsequently described anodizing treatment step.
Following heat treatment, it is preferable to rapidly cool the aluminum substrate. The method of cooling is exemplified by a method involving direct immersion of the aluminum substrate in water or the like.

<Degreasing Treatment>

Degreasing treatment is carried out with a suitable substance such as an acid, alkali or organic solvent so as to dissolve and remove organic substances, including dust, grease and resins, adhering to the aluminum substrate surface, and thereby prevent defects due to organic substances from arising in each of the subsequent treatments.
Illustrative examples of degreasing treatment include: a method in which an organic solvent such as an alcohol (e.g., methanol), ketone (e.g., methyl ethyl ketone), petroleum benzin or volatile oil is contacted with the surface of the aluminum substrate at ambient temperature (organic solvent method); a method in which a liquid containing a surfactant such as soap or a neutral detergent is contacted with the surface of the aluminum substrate at a temperature of from ambient temperature to 80°C, after which the surface is rinsed with water (surfactant method); a method in which an aqueous sulfuric acid solution having a concentration of 10 to 200 g/L is contacted with the surface of the aluminum substrate at a temperature of from ambient temperature to 70°C for a period of 30 to 80 seconds, following which the surface is rinsed with water; a method in which an aqueous solution of sodium hydroxide having a concentration of 5 to 20 g/L is contacted with the surface of the aluminum substrate at ambient temperature for about 30 seconds while electrolysis is carried out by passing a direct current through the aluminum substrate surface as the cathode at a current density of 1 to 10 A/dm$^2$, following which the surface is contacted with an aqueous solution of nitric acid having a concentration of 100 to 500 g/L and thereby neutralized; a method in which any of various known anodizing electrolytic solutions is contacted with the surface of the aluminum substrate at ambient temperature while electrolysis is carried out by passing a direct current at a current density of 1 to 10 A/dm$^2$ through the aluminum substrate surface as the cathode or by passing an alternating current through the aluminum substrate surface as the cathode; a method in which an aqueous alkali solution having a concentration of 10 to 200 g/L is contacted with the surface of the aluminum substrate at 40 to 50°C for 15 to 60 seconds, following which an aqueous solution of nitric acid having a concentration of 100 to 500 g/L is contacted with the surface and thereby neutralized; a method in which an emulsion prepared by mixing a surfactant, water and the like into an oil such as gas oil or kerosene is contacted with the surface of the aluminum substrate at a temperature of from ambient temperature to 50°C, following which the surface is rinsed with water (emulsion degreasing method); and a method in which a mixed solution of, for example, sodium carbonate, phosphates and surfactant is contacted with the surface of the aluminum substrate at a temperature of from ambient temperature to 50°C for 30 to 180 seconds, following which the surface is rinsed with water (phosphate method).
Of these, the organic solvent method, surfactant method, emulsion degreasing method and phosphate method are preferred from the standpoint of removing grease from the aluminum surface while causing substantially no aluminum dissolution.
Known degreasers may be used in degreasing treatment. For example, degreasing treatment may be carried out using any of various commercially available degreasers by the prescribed method.

<Mirror-Like Finishing Treatment>

Mirror-like finishing treatment is carried out to eliminate surface asperities of the aluminum substrate and improve the uniformity and reproducibility of particle-forming treatment using, for example, electrodeposition. Exemplary surface asperities of the aluminum substrate include rolling streaks formed during rolling of the aluminum substrate which requires a rolling step for its manufacture.
In the present invention, mirror-like finishing treatment is not subject to any particular limitation, and may be carried out using any suitable method known in the art. Examples of suitable methods include mechanical polishing, chemical polishing, and electrolytic polishing.
Illustrative examples of suitable mechanical polishing methods include polishing with various commercial abrasive cloths, and methods that combine the use of various commercial abrasives (e.g., diamond, alumina) with buffing. More specifically, a method which is carried out with an abrasive while changing over time the abrasive used from one having coarser particles to one having finer particles is appropriately illustrated. In such a case, the final abrasive used is preferably one having a grit size of 1500. In this way, a glossiness of at least 50% (in the case of rolled aluminum, at least 50% in both the rolling direction and the transverse direction) can be achieved.
Examples of chemical polishing methods include various methods mentioned in the 6th edition of Aluminum Handbook (Japan Aluminum Association, 2001), pp. 164-165.

Preferred examples include phosphoric acid/nitric acid method, Alupol I method, Alupol V method, Alcoa R5 method, $H_3PO_4$-$CH_3COOH$-Cu method and $H_3PO_4$-$HNO_3$-$CH_3COOH$ method. Of these, the phosphoric acid/nitric acid method, the $H_3$-$PO_4$-$CH_3COOH$-Cu method and the $H_3PC_4$-$HNO_3$-$CH_3COOH$ method are especially preferred.

With chemical polishing, a glossiness of at least 70% (in the case of rolled aluminum, at least 70% in both the rolling direction and the transverse direction) can be achieved.

Examples of electrolytic polishing methods include various methods mentioned in the 6th edition of Aluminum Handbook (Japan Aluminum Association, 2001), pp. 164-165; the method described in US 2,708,655; and the method described in Jitsumu Hyomen Gijutsu (Practice of Surface Technology), Vol. 33, No. 3, pp. 32-38 (1986).

With electrolytic polishing, a glossiness of at least 70% (in the case of rolled aluminum, at least 70% in both the rolling direction and the transverse direction) can be achieved.

These methods may be suitably combined and used. In an illustrative method that may be preferably used, mechanical polishing which is carried out by changing the abrasive over time from one having coarser particles to one having finer particles is followed by electrolytic polishing.

Mirror-like finishing treatment enables a surface having, for example, a mean surface roughness $R_a$ of 0.1 $\mu$m or less and a glossiness of at least 50% to be obtained. The mean surface roughness $R_a$ is preferably up to 0.03 $\mu$m and more preferably up to 0.02 $\mu$m. The glossiness is preferably at least 70%, and more preferably at least 80%.

The glossiness is the specular reflectance which can be determined in accordance with JIS Z8741-1997 (Method 3: 60° Specular Gloss) in a direction perpendicular to the rolling direction. Specifically, measurement is carried out using a variable-angle glossmeter (e.g., VG-1D, manufactured by Nippon Denshoku Industries Co., Ltd.) at an angle of incidence/reflection of 60° when the specular reflectance is 70% or less, and at an angle of incidence/reflection of 20° when the specular reflectance is more than 70%.

[(1) Anodizing Treatment Step]

The anodizing treatment step is a step for anodizing the aluminum substrate to form a micropore-bearing oxide film at the surface of the aluminum substrate.

Conventionally known methods may be used for anodizing treatment in the present invention, but a self-ordering method to be described below is preferably used because the insulating base comprises an anodized film obtained from an aluminum substrate, the anodized film having micropores arrayed so as to have a good degree of ordering as defined by formula (i) of preferably at least 50%.

Anodizing treatment is preferably carried out by a constant voltage process.

The self-ordering method is a method which enhances the orderliness by using the regularly arranging nature of micropores in an anodized film and eliminating factors that may disturb an orderly arrangement. Specifically, an anodized film is formed on high-purity aluminum at a voltage appropriate for the type of electrolytic solution and at a low speed over an extended period of time (e.g., from several hours to well over ten hours).

In this method, because the pore size depends on the voltage, a desired pore size can be obtained to some extent by controlling the voltage.

In order to form micropores by the self-ordering method, at least the subsequently described anodizing treatment (A) should be carried out. However, micropores are preferably formed by the self-ordering method I or self-ordering method II.

Next, the self-ordering methods I and II in the preferred embodiments are described in detail.

[(1-a) Self-Ordering Method I]

According to the self-ordering method I, anodization (anodizing treatment (A)) is followed by complete dissolution of the anodized film using an acid or alkali that may dissolve the anodized film (i.e., film removal treatment (B)), which is followed by re-anodization (re-anodizing treatment (C)).

Next, the respective treatments of the self-ordering method I are described in detail.

<Anodizing Treatment (A)>

The average flow velocity of electrolytic solution in anodizing treatment (A) is preferably from 0.5 to 20.0 m/min, more preferably from 1.0 to 15.0 m/min, and even more preferably from 2.0 to 10.0 m/min. By carrying out anodizing treatment (A) at the foregoing flow velocity, a uniform and high degree of ordering can be achieved.

The method for causing the electrolytic solution to flow under the above conditions is not subject to any particular limitation. For example, a method involving the use of a common agitator such as a stirrer may be employed. The use of a stirrer in which the stirring speed can be controlled with a digital display is particularly desirable because it enables the average flow velocity to be regulated. An example of such a stirrer is the Magnetic Stirrer HS-50D (manufactured by As One Corporation).

Anodizing treatment (A) may be carried out by, for example, a method in which current is passed through the aluminum substrate as the anode in a solution having an acid concentration of from 1 to 10 wt%.

The solution used in anodizing treatment (A) is preferably an acid solution. A solution of sulfuric acid, phosphoric acid, chromic acid, oxalic acid, sulfamic acid, benzenesulfonic acid, amidosulfonic acid, glycolic acid, tartaric acid, malic acid or citric acid is more preferred. Of these, a solution of sulfuric acid, phosphoric acid, or oxalic acid is especially preferred. These acids may be used singly or in combination of two or more thereof.

The anodizing treatment (A) conditions vary depending on the electrolytic solution employed, and thus cannot be strictly specified. However, the following conditions are generally preferred: an electrolyte concentration of from 0.1 to 20 wt%, a solution temperature of from -10 to 30°C, a current density of from 0.01 to 20 A/dm$^2$, a voltage of from 3 to 300 V, and an electrolysis time of from 0.5 to 30 hours. An electrolyte concentration of from 0.5 to 15 wt%, a solution temperature of from -5 to 25°C, a current density of from 0.05 to 15 A/dm$^2$, a voltage of from 5 to 250 V, and an electrolysis time of from 1 to 25 hours are more preferred. An electrolyte concentration of from 1 to 10 wt%, a solution temperature of from 0 to 20°C, a current density of from 0.1 to 10 A/dm$^2$, a voltage of from 10 to 200 V, and an electrolysis time of from 2 to 20 hours are even more preferred.

The treatment time in anodizing treatment (A) is preferably from 0.5 minute to 16 hours, more preferably from 1 minute to 12 hours, and even more preferably from 2 minutes to 8 hours.

Aside from being carried out at a constant voltage, anodizing treatment (A) may be carried out using a method in which the voltage is intermittently or continuously varied. In such cases, it is preferable to have the voltage gradually decrease. It is possible in this way to lower the resistance of the anodized film, bringing about the formation of small micropores in the anodized film. As a result, this approach is preferable for improving uniformity, particularly when sealing is subsequently carried out by electrodeposition treatment.

In the anisotropic conductive structure-manufacturing method, the anodized film formed by such anodizing treatment (A) preferably has a thickness of 1 to 300 $\mu$m, more preferably 5 to 150 $\mu$m, and even more preferably 10 to 100 $\mu$m.

In the anisotropic conductive structure-manufacturing method, the anodized film formed by such anodizing treatment (A) has an average micropore density of preferably $1 \times 10^6$ to $1000 \times 10^6$ micropores/$\mu$m$^2$ and more preferably $3 \times 10^6$ to $300 \times 10^6$ micropores/$\mu$m$^2$.

It is preferable for the micropores to have a surface coverage of from 20 to 50%.

The surface coverage of the micropores is defined here as the ratio of the total surface area of the micropore openings to the surface area of the aluminum surface.

<Film Removal Treatment (B)>

In film removal treatment (B), the anodized film formed at the surface of the aluminum substrate by the above-described anodizing treatment (A) is dissolved and removed.

The subsequently described perforating treatment step may be carried out immediately after forming an anodized film at the surface of the aluminum substrate by the above-described anodizing treatment (A). However, it is preferred to additionally carry out after the above-described anodizing treatment (A), film removal treatment (B) and the subsequently described re-anodizing treatment (C) in this order, followed by the subsequently described perforating treatment step.

Given that the orderliness of the anodized film increases as the aluminum substrate is approached, by using this film removal treatment (B) to remove the anodized film that has been formed in (A), the lower portion of the anodized film remaining at the surface of the aluminum substrate emerges at the surface, affording an orderly array of pits. Therefore, in film removal treatment (B), aluminum is not dissolved; only the anodized film made of alumina (aluminum oxide) is dissolved.

Any conventionally known solution may be used without particular limitation for the alumina dissolving solution but the alumina dissolving solution is preferably an aqueous solution containing at least one substance selected from the group consisting of chromium compounds, nitric acid, phosphoric acid, zirconium compounds, titanium compounds, lithium salts, cerium salts, magnesium salts, sodium hexafluorosilicate, zinc fluoride, manganese compounds, molybdenum compounds, magnesium compounds, barium compounds, and uncombined halogens.

Illustrative examples of chromium compounds include chromium (III) oxide and chromium (VI) oxide.

Examples of zirconium compounds include zirconium ammonium fluoride, zirconium fluoride and zirconium chloride.

Examples of titanium compounds include titanium oxide and titanium sulfide.

Examples of lithium salts include lithium fluoride and lithium chloride.

Examples of cerium salts include cerium fluoride and cerium chloride.

Examples of magnesium salts include magnesium sulfide.

Examples of manganese compounds include sodium permanganate and calcium permanganate.

Examples of molybdenum compounds include sodium molybdate.

Examples of magnesium compounds include magnesium fluoride pentahydrate.

Examples of barium compounds include barium oxide, barium acetate, barium carbonate, barium chlorate, barium chloride, barium fluoride, barium iodide, barium lactate, barium oxalate, barium perchlorate, barium selenate, barium selenite, barium stearate, barium sulfite, barium titanate, barium hydroxide, barium nitrate, and hydrates thereof.

Of the above barium compounds, barium oxide, barium acetate and barium carbonate are preferred. Barium oxide is especially preferred.

Examples of uncombined halogens include chlorine, fluorine and bromine.

Of the above, the alumina dissolving solution is preferably an acid-containing aqueous solution. Examples of the acid include sulfuric acid, phosphoric acid, nitric acid and hydrochloric acid. A mixture of two or more acids is also acceptable.

The acid concentration is preferably at least 0.01 mol/L, more preferably at least 0.05 mol/L, and even more preferably at least 0.1 mol/L. Although there is no particular upper limit in the acid concentration, in general, the concentration is preferably 10 mol/L or less, and more preferably 5 mol/L or less. A needlessly high concentration is uneconomical, in addition to which higher concentrations may result in dissolution of the aluminum substrate.

The alumina dissolving solution has a temperature of preferably -10°C or higher, more preferably -5°C or higher, and even more preferably 0°C or higher. Carrying out treatment using a boiling alumina dissolving solution destroys or disrupts the starting points for ordering. Hence, the alumina dissolving solution is preferably used without being boiled.

The alumina dissolving solution dissolves alumina, but does not dissolve aluminum. Here, the alumina dissolving solution may dissolve a very small amount of aluminum, so long as it does not dissolve a substantial amount of aluminum.

Film removal treatment (B) is carried out by bringing an aluminum substrate at which an anodized film has been formed into contact with the above-described alumina dissolving solution. Examples of the contacting method include, but are not limited to, immersion and spraying. Of these, immersion is preferred.

Immersion is a treatment in which the aluminum substrate at which an anodized film has been formed is immersed in the alumina dissolving solution. To achieve uniform treatment, it is desirable to carry out stirring at the time of immersion treatment.

The immersion treatment time is preferably at least 10 minutes, more preferably at least 1 hour, even more preferably at least 3 hours, and most preferably at least 5 hours.

<Re-Anodizing Treatment (C)>

An anodized film having micropores with an even higher degree of ordering can be formed by carrying out anodizing treatment once again after the anodized film is removed by the above-described film removal treatment (B) to form well-ordered pits at the surface of the aluminum substrate.

Re-anodizing treatment (C) may be carried out using a method known in the art, although it is preferably carried out under the same conditions as the above-described anodizing treatment (A).

Alternatively, suitable use may be made of a method in which the current is repeatedly turned on and off while keeping the dc voltage constant, or a method in which the current is repeatedly turned on and off while intermittently varying the dc voltage. Because these methods result in the formation of small micropores in the anodized film, they are preferable for improving uniformity, particularly when sealing is to be carried out by electrodeposition treatment.

When re-anodizing treatment (C) is carried out at a low temperature, the array of micropores is well-ordered and the pore size is uniform.

On the other hand, by carrying out re-anodizing treatment (C) at a relatively high temperature, the micropore array may be disrupted or the variance in pore size may be set within a given range. The variance in pore size may also be controlled by the treatment time.

In the anisotropic conductive structure-manufacturing method, the anodized film formed by such re-anodizing treatment (C) preferably has a thickness of 10 to 200 $\mu$m, more preferably 20 to 150 $\mu$m, and even more preferably 30 to 100 $\mu$m.

In the anisotropic conductive structure-manufacturing method, the anodized film formed by such anodizing treatment (C) has micropores with a pore size of preferably 20 to 200 nm, more preferably 30 to 190 nm, and even more preferably 60 to 180 nm. It is further preferred to enlarge the pore size by chemical dissolution treatment so that the conductive paths may have a preferred size.

The average micropore density is preferably $1 \times 10^6$ to $1000 \times 10^6$ micropores/$\mu$m$^2$ and more preferably $3 \times 10^6$ to $300 \times 10^6$ micropores/$\mu$m$^2$.

[(1-b) Self-Ordering Method II]

According to the self-ordering method II, the surface of the aluminum substrate is anodized (anodizing treatment (D)), the anodized film is partially dissolved by using an acid or alkali (oxide film dissolution treatment (E)) and re-anodizing treatment is carried out to make the micropores grow in the depth direction, after which the anodized film above the inflection points in the cross-sectional shape of the micropores is removed.

Next, the respective treatments of the self-ordering method II are described in detail.

<Anodizing Treatment (D)>

Conventionally known electrolytic solutions may be used in anodizing treatment (D) but the orderliness of the pore array can be considerably improved by carrying out, under conditions of direct current and constant voltage, anodization using an electrolytic solution in which the parameter R represented by general formula (ii) wherein A is the film-forming rate during application of current and B is the film dissolution rate during non-application of current satisfies $160 \leq R \leq 200$, preferably $170 \leq R \leq 190$ and most particularly $175 \leq R \leq 185$.

$$R = A \text{ [nm/s]} / (B \text{ [nm/s]} \times \text{voltage applied [V]}) \quad \cdots \text{(ii)}$$

As in the above-described anodizing treatment (A), the average flow velocity of electrolytic solution in anodizing treatment (D) is preferably from 0.5 to 20.0 m/min, more preferably from 1.0 to 15.0 m/min, and even more preferably from 2.0 to 10.0 m/min. By carrying out anodizing treatment (D) at the flow velocity within the above-defined range, a uniform and high degree of ordering can be achieved.

As in the above-described anodizing treatment (A), the method for causing the electrolytic solution to flow under the above conditions is not subject to any particular limitation. For example, a method involving the use of a common agitator such as a stirrer may be employed. The use of a stirrer in which the stirring speed can be controlled with a digital display is particularly desirable because it enables the average flow velocity to be regulated. An example of such a stirrer is the Magnetic Stirrer HS-50D (manufactured by As One Corporation).

The anodizing treatment solution preferably has a viscosity at 25°C and 1 atm of 0.0001 to 100.0 Pa·s and more preferably 0.0005 to 80.0 Pa·s. By carrying out anodizing treatment (D) using the electrolytic solution having the viscosity within the above-defined range, a uniform and high degree of ordering can be achieved.

The electrolytic solution used in anodizing treatment (D) may be an acidic solution or an alkaline solution, but an acidic electrolytic solution is advantageously used in terms of improving the circularity of the pores.

More specifically, as in the above-described anodizing treatment (A), a solution of hydrochloric acid, sulfuric acid, phosphoric acid, chromic acid, oxalic acid, glycolic acid, tartaric acid, malic acid, citric acid, sulfamic acid, benzenesulfonic acid, amidosulfonic acid, glycolic acid, tartaric acid, malic acid, or citric acid is more preferred. Of these, a solution of sulfuric acid, phosphoric acid or oxalic acid is especially preferred. These acids may be used singly or in combination of two or more thereof by adjusting as desired the parameter in the calculating formula represented by general formula (ii).

The anodizing treatment (D) conditions vary depending on the electrolytic solution employed, and thus cannot be strictly specified. However, as in the above-described anodizing treatment (A), the following conditions are generally preferred: an electrolyte concentration of from 0.1 to 20 wt%, a solution temperature of from -10 to 30°C, a current density of from 0.01 to 20 A/dm$^2$, a voltage of from 3 to 500 V, and an electrolysis time of from 0.5 to 30 hours. An electrolyte concentration of from 0.5 to 15 wt%, a solution temperature of from -5 to 25°C, a current density of from 0.05 to 15 A/dm$^2$, a voltage of from 5 to 250 V, and an electrolysis time of from 1 to 25 hours are more preferred. An electrolyte concentration of from 1 to 10 wt%, a solution temperature of from 0 to 20°C, a current density of from 0.1 to 10 A/dm$^2$, a voltage of from 10 to 200 V, and an electrolysis time of from 2 to 20 hours are even more preferred.

As shown in FIG. 6A, as a result of anodizing treatment (D), an anodized film 34a bearing micropores 36a is formed at a surface of an aluminum substrate 32. A barrier layer 38a is present on the aluminum substrate 32 side of the anodized film 34a.

<Oxide Film Dissolution Treatment (E)>

Oxide film dissolution treatment (E) is a treatment for enlarging the diameter (pore size) of the micropores present in the anodized film formed by the above-described anodizing treatment (D) (pore size enlarging treatment).

Oxide film dissolution treatment (E) is carried out by bringing the aluminum substrate having undergone the above-described anodizing treatment (D) into contact with an aqueous acid or alkali solution. Examples of the contacting method include, but are not limited to, immersion and spraying. Of these, immersion is preferred.

When oxide film dissolution treatment (E) is to be carried out with an aqueous acid solution, it is preferable to use an aqueous solution of an inorganic acid such as sulfuric acid, phosphoric acid, nitric acid or hydrochloric acid, or a mixture thereof. It is particularly preferable to use an aqueous solution containing no chromic acid in terms of its high degree of safety. The aqueous acid solution preferably has a concentration of 1 to 10 wt%. The aqueous acid solution preferably has a temperature of 25 to 60°C.

When oxide film dissolution treatment (E) is to be carried out with an aqueous alkali solution, it is preferable to use an aqueous solution of at least one alkali selected from the group consisting of sodium hydroxide, potassium hydroxide and lithium hydroxide. The aqueous alkali solution preferably has a concentration of 0.1 to 5 wt%. The aqueous alkali solution preferably has a temperature of 20 to 35°C.

Specific examples of preferred solutions include a 40°C aqueous solution containing 50 g/L of phosphoric acid, a 30°C aqueous solution containing 0.5 g/L of sodium hydroxide, and a 30°C aqueous solution containing 0.5 g/L of potassium hydroxide.

The time of immersion in the aqueous acid solution or aqueous alkali solution is preferably from 8 to 120 minutes, more preferably from 10 to 90 minutes and even more preferably from 15 to 60 minutes.

In oxide film dissolution treatment (E), the degree of enlargement of the pore size varies with the conditions of anodizing treatment (D) but the ratio of after to before the treatment is preferably 1.05 to 100, more preferably 1.1 to 75 and even more preferably 1.2 to 50.

Oxide film dissolution treatment (E) dissolves the surface of the anodized film 34a and the interiors of the micropores 36a (barrier layer 38a and the porous layer) as shown in FIG. 6A to obtain an aluminum member having a micropore 36b-bearing anodized film 34b on the aluminum substrate 32 as shown in FIG. 6B. As in FIG. 6A, a barrier layer 38b is present on the aluminum substrate 32 side of the anodized film 34b.

In the self-ordering method II, it is preferred to carry out the above-described anodizing treatment (D) again after the above-described oxide film dissolution treatment (E).

By carrying out anodizing treatment (D) again, oxidation reaction of the aluminum substrate 32 shown in FIG. 6B proceeds to obtain, as shown in FIG. 6C, an aluminum member which has an anodized film 34c formed on the aluminum substrate 32, the anodized film 34c bearing micropores 36c having a larger depth than the micropores 36b. As in FIG. 6A, a barrier layer 38c is present on the aluminum substrate 32 side of the anodized film 34c.

In the self-ordering method II, it is preferred to further carry out the above-described oxide film dissolution treatment (E) after the above-described anodizing treatment (D), oxide film dissolution treatment (E) and anodizing treatment (D) have been carried out in this order.

This treatment enables the treatment solution to enter the micropores to dissolve all the anodized film formed by re-anodizing treatment (D), whereby the micropores formed by re-anodizing treatment (D) may have enlarged diameters.

More specifically, oxide film dissolution treatment (E) carried out again dissolves the interiors of the micropores 36c on the surface side from inflection points in the anodized film 34c shown in FIG. 6C, that is, removes the anodized film 34c above the inflection points in the cross-sectional shape of the micropores 36c to obtain an aluminum member having an anodized film 34d bearing straight tube-shaped micropores 36d on the aluminum substrate 32 as shown in FIG. 6D. As in FIG. 6A, a barrier layer 38d is present on the aluminum substrate 32 side of the anodized film 34d.

The degree of enlargement of the pore size varies with the conditions of re-anodizing treatment (D) but the ratio of after to before the treatment is preferably 1.05 to 100, more preferably 1.1 to 75 and even more preferably 1.2 to 50.

The self-ordering method II involves at least one cycle of the above-described anodizing treatment (D) and oxide film dissolution treatment (E). The larger the number of repetitions is, the more the degree of ordering of the pore array is increased.

The circularity of the micropores seen from the film surface side is dramatically improved by dissolving in oxide film dissolution treatment (E) all the anodized film formed by the preceding anodizing treatment (D). Therefore, this cycle is preferably repeated at least twice, more preferably at least three times and even more preferably at least four times.

In cases where this cycle is repeated at least twice, the conditions in each cycle of oxide film dissolution treatment and anodizing treatment may be the same or different. Alternatively, the treatment may be terminated by anodizing treatment.

A method using imprinting to be described later may be preferably used for anodizing treatment in the anisotropic conductive structure-manufacturing method.

[(1-c): Method Using Imprinting]

According to the method using imprinting, a plurality of pits as starting points for micropore formation in anodizing treatment are formed at the surface of the aluminum substrate at predetermined spacings in a predetermined array before performing anodizing treatment for forming a micropore-bearing anodized film on the surface of the aluminum substrate. Formation of such pits facilitates controlling the micropore array and the pore circularity in desired ranges.

The process of forming pits is not particularly limited and exemplary processes include a physical process including an imprinting (transfer) process, a particle beam process, a block copolymer process and a resist patterning/exposure/etching process. In imprinting, pits are formed without using electrochemical methods including a procedure used in the self-ordering method (I) in which the anodizing treatment step (A) and film removal treatment (B) are carried out in this order, and a procedure in which pits are formed by electrochemical graining treatment.

By forming a plurality of pits as starting points for micropore formation in anodizing treatment at predetermined spacings in a predetermined array, the starting points of micropores formed by anodization can be disposed in a desired array and the resulting structure can have a higher circularity.

<Physical Process>

Physical processes are exemplified by processes which use imprinting (transfer processes and press patterning processes in which a plate or roll having projections thereon is pressed against the aluminum substrate to form pits in the substrate). A specific example is a process in which a plate having numerous projections on a surface thereof is pressed against the aluminum substrate surface, thereby forming pits. For example, the process described in JP 10-121292 A may be used.

Another example is a process in which polystyrene spheres are densely arranged on the surface of the aluminum, $SiO_2$ is vapor-deposited onto the spheres, then the polystyrene spheres are removed and the substrate is etched using the vapor-deposited $SiO_2$ as the mask, thereby forming pits.

<Particle Beam Process>

In a particle beam process, pits are formed by irradiating the surface of the aluminum substrate with a particle beam. This process has the advantage that the positions of the pits can be freely controlled.

Examples of the particle beam include a charged particle beam, a focused ion beam (FIB), and an electron beam.

For example, the process described in JP 2001-105400 A may be used as the particle beam process.

<Block Copolymer Process>

The block copolymer process involves forming a block copolymer layer on the surface of the aluminum substrate, forming an islands-in-the-sea structure in the block copolymer layer by thermal annealing, then removing the island components to form pits.

For example, the process described in JP 2003-129288 A may be used as the block copolymer method.

<Resist Patterning/Exposure/Etching Process>

In a resist patterning/exposure/etching process, a resist film formed on the surface of the aluminum substrate is exposed and developed by photolithography or electron-beam lithography to form a resist pattern. The resist is then etched, forming pits which pass entirely through the resist to the surface of the aluminum substrate.

Of the above-described various processes for forming pits, a physical process, an FIB process and a resist patterning/exposure/etching process are desired.

In imprinting, in cases where a plurality of pits are formed at the surface of an aluminum substrate at predetermined spacings in a predetermined array, and particularly in cases where small pits are formed at spacings of around 0.1 $\mu$m, it is not economical to apply every time high-resolution microfabrication technology using electron beam lithography or X-ray lithography to form small pits at the aluminum plate surface artificially and orderly and therefore an imprinting (transfer) process in which a substrate having a plurality of projections on the surface is pressed against the surface of the aluminum substrate to be anodized is preferred.

More specifically, the imprinting process can be performed by closely attaching a substrate or a roll having projections to the aluminum substrate surface and applying pressure thereto using a hydraulic press. The projections should be formed on the substrate in an array (pattern) corresponding to the array of micropores in the anodized film to be formed by anodizing treatment. The pits may be formed in a periodic array of a regular hexagonal shape or any other pattern such as a partly missing periodic array. It is desirable for the substrate on which the projections are to be formed to have a mirror-finished surface and to have sufficient strength and hardness to prevent breakage or deformation of the projections due to the pressure applied. To this end, substrates of metals such as aluminum and tantalum as well as versatile silicon substrates which are easy in microfabrication can be used but substrates made up of high-strength diamond and silicon carbide can be repeatedly used an increased number of times and is therefore more desired. Once a substrate or a roll having projections is thus fabricated, it can be repeatedly used to efficiently form an ordered array of pits in a large number of aluminum plates.

In the case of using the imprinting process, the pressure depends on the type of substrate but is preferably from 0.001 to 100 t/cm$^2$, more preferably from 0.01 to 75 t/cm$^2$ and most preferably from 0.1 to 50 t/cm$^2$.

The pressing temperature is preferably from 0 to 300°C, more preferably from 5 to 200°C and most preferably from 10 to 100°C. The pressing time is preferably from 2 seconds to 30 minutes, more preferably from 5 seconds to 15 minutes and most preferably from 10 seconds to 5 minutes.

In terms of fixing the surface profile after pressing, a step of cooling the surface of the aluminum substrate may be added as a post-treatment.

In the method using imprinting, pits are formed at the surface of the aluminum substrate as described above, after which the aluminum substrate surface is anodized.

Conventionally known methods may be used for anodizing treatment and a method in which treatment is carried out at a constant voltage, a method in which the current is repeatedly turned on and off while keeping the dc voltage constant, and a method in which the current is repeatedly turned on and off while intermittently varying the dc voltage may also be advantageously used.

When anodizing treatment is carried out at a low temperature, the array of micropores is well-ordered and the pore size is uniform.

On the other hand, by carrying out anodizing treatment at a relatively high temperature, the micropore array may be disrupted or the variance in pore size may be set within a given range. The variance in pore size may also be controlled by the treatment time.

In the anisotropic conductive structure-manufacturing method, the anodizing treatment step is preferably carried out by any of the treatments (1-a) to (1-c).

[(2) Perforating Treatment Step]

The perforating treatment step is a step in which micropores formed by anodization are perforated after the above-described anodizing treatment step to obtain the insulating base.

In the perforating treatment step, the treatment (2-a) or (2-b) is preferably carried out.

(2-a) Treatment (chemical dissolution treatment) in which an acid or an alkali is used to dissolve the anodized film-bearing aluminum substrate to make the micropores extend through the anodized film.

(2-b) Treatment (mechanical polishing treatment) in which the anodized film-bearing aluminum substrate is mechanically polished to make the micropores extend through the anodized film.

The treatments (2-a) and (2-b) are described below in detail.

[(2-a) Chemical Dissolution Treatment]

More specifically, chemical dissolution treatment which follows the anodizing treatment step involves, for example, dissolving the aluminum substrate (portion represented by reference symbol 32 in FIG. 6D) and further removing the bottom of the anodized film (portion represented by reference symbol 38d in FIG. 6D) to make the micropores extend through the anodized film.

<Dissolution of Aluminum Substrate>

A treatment solution which does not readily dissolve the anodized film (alumina) but readily dissolves aluminum is used for dissolution of the aluminum substrate after the anodizing treatment step.

That is, use is made of a treatment solution which has an aluminum dissolution rate of at least 1 $\mu$m/min, preferably at least 3 $\mu$m/min, and more preferably at least 5 $\mu$m/min, and has an anodized film dissolution rate of 0.1 nm/min or less, preferably 0.05 nm/min or less, and more preferably 0.01 nm/min or less.

Specifically, a treatment solution which includes at least one metal compound having a lower ionization tendency than aluminum, and which has a pH of 4 or less or 8 or more, preferably 3 or less or 9 or more, and more preferably 2 or less or 10 or more is used for immersion treatment.

Preferred examples of such treatment solutions include solutions which are composed of, as the base, an aqueous solution of an acid or an alkali and which have blended therein a compound of, for example, manganese, zinc, chromium, iron, cadmium, cobalt, nickel, tin, lead, antimony, bismuth, copper, mercury, silver, palladium, platinum or gold (e.g., chloroplatinic acid), or a fluoride or chloride of any of these metals.

Of the above, it is preferable for the treatment solution to be based on an aqueous solution of an acid and to have blended therein a chloride compound.

Treatment solutions of an aqueous solution of hydrochloric acid in which mercury chloride has been blended (hydrochloric acid/mercury chloride), and treatment solutions of an aqueous solution of hydrochloric acid in which copper chloride has been blended (hydrochloric acid/copper chloride) are especially preferred from the standpoint of the treatment latitude.

There is no particular limitation on the composition of such treatment solutions. Illustrative examples of the treatment solutions include a bromine/methanol mixture, a bromine/ethanol mixture, and aqua regia.

Such a treatment solution preferably has an acid or alkali concentration of 0.01 to 10 mol/L and more preferably 0.05 to 5 mol/L.

In addition, such a treatment solution is used at a treatment temperature of preferably -10°C to 80°C and more preferably 0 to 60°C.

In the anisotropic conductive structure-manufacturing method, dissolution of the aluminum substrate is carried out by bringing the aluminum substrate having undergone the anodizing treatment step into contact with the above-described treatment solution. Examples of the contacting method include, but are not limited to, immersion and spraying. Of these, immersion is preferred. The period of contact at this time is preferably from 10 seconds to 5 hours, and more preferably from 1 minute to 3 hours.

<Removal of Bottom of Anodized Film>

The bottom of the anodized film after the dissolution of the aluminum substrate is removed by immersion in an aqueous acid or alkali solution. Removal of the bottom of the oxide film causes the micropores to extend therethrough.

The bottom of the anodized film is preferably removed by the method that involves previously immersing the anodized film in a pH buffer solution to fill the micropores with the pH buffer solution from the micropore opening side, and bringing the surface opposite from the openings (i.e., the bottom of the anodized film) into contact with an aqueous acid solution or aqueous alkali solution.

when this treatment is to be carried out with an aqueous acid solution, it is preferable to use an aqueous solution of an inorganic acid such as sulfuric acid, phosphoric acid, nitric acid or hydrochloric acid, or a mixture thereof. The aqueous acid solution preferably has a concentration of 1 to 10 wt%. The aqueous acid solution preferably has a temperature of 25 to 40°C.

When this treatment is to be carried out with an aqueous alkali solution, it is preferable to use an aqueous solution of at least one alkali selected from the group consisting of sodium hydroxide, potassium hydroxide and lithium hydroxide. The aqueous alkali solution preferably has a concentration of 0.1 to 5 wt%. The aqueous alkali solution preferably has a temperature of 20 to 35°C.

Specific examples of preferred solutions include a 40°C aqueous solution containing 50 g/L of phosphoric acid, a 30°C aqueous solution containing 0.5 g/L of sodium hydroxide, and a 30°C aqueous solution containing 0.5 g/L of potassium hydroxide.

The time of immersion in the aqueous acid solution or aqueous alkali solution is preferably from 8 to 120 minutes, more preferably from 10 to 90 minutes and even more preferably from 15 to 60 minutes.

In cases where the film is previously immersed in a pH buffer solution, a buffer solution suitable to the foregoing acids/alkalis is used.

[(2-b) Mechanical Polishing Treatment]

More specifically, mechanical polishing treatment which follows the anodizing treatment step involves, for example, mechanically polishing and removing the aluminum substrate (portion represented by reference symbol 32 in FIG. 6D) and the anodized film in the vicinity of the aluminum substrate (portion represented by reference symbol 38d in FIG. 6D) to make the micropores extend through the anodized film.

A wide variety of known mechanical polishing treatment methods may be used for mechanical polishing treatment and, for example, mechanical polishing illustrated for mirror-like finishing treatment may be used. However, chemical mechanical polishing (CMP) is preferably carried out owing to its high fine polishing rate. CMP treatment may be carried out using a CMP slurry such as PNANERLITE-7000 available from Fujimi Inc., GPX HSC800 available from Hitachi Chemical Co., Ltd., or C-1000 available from AGC Seimi Chemical Co., Ltd.

These perforating treatment steps yield a structure shown in FIG. 6D after removal of the aluminum substrate 32 and the barrier layer 38d, that is, an insulating base 40 as shown in FIG. 7A.

Anodisc commercially available from Whatman Japan KK may be appropriately used instead of carrying out (1) anodizing treatment step and (2) perforating treatment step.

[(3) Conductive Material Filling Step]

The conductive material filling step is a step in which a conductive material is filled into the through micropores in the resulting insulating base after the perforating treatment step to obtain an anisotropic conductive member.

In the conductive material filling step, one of the following treatments (3-a) to (3-c) is preferably carried out.

(3-a) Treatment (immersion treatment) in which the insulating base having the through micropores is immersed in a solution containing a conductive material to fill the conductive material into the micropores.

(3-b) Treatment (electrolytic plating treatment) in which the conductive material is filled into the through micropores by electrolytic plating.

(3-c) Treatment (vapor deposition treatment) in which the conductive material is filled into the through micropores by vapor deposition.

The conductive material to be filled makes up the conductive paths of the anisotropic conductive structure as described in connection with the anisotropic conductive structure.

The treatments (3-a) to (3-c) are described below in detail.

[(3-a) Immersion Treatment]

Known methods such as electroless plating treatment, high viscosity molten metal immersion treatment and conductive polymer solution immersion treatment may be used for the treatment in which through micropore-bearing insulating base is immersed in a solution containing a conductive material to fill the through micropores with the conductive material. However, metals are preferred conductive materials and therefore electroless plating treatment and molten metal immersion treatment are preferred and electroless plating treatment is preferred in terms of ease of handling.

In electroless plating, known methods and treatment solutions may be used without particular limitation. However, it is preferred to use a method in which nuclei of a metal to be deposited are provided in advance, a compound which may dissolve in a solvent containing the metal and a reducing agent are dissolved in a solution and the insulating base is immersed in the solution to fill the through micropores with the metal.

This treatment can be performed in combination with electrolytic plating to be described below.

[(3-b) Electrolytic Plating Treatment]

In cases where the through micropores are filled with the conductive material by electrolytic plating in the anisotropic conductive structure-manufacturing method, ultrasonic application is also desired to promote agitation of the electrolytic solution.

In addition, the electrolysis voltage is usually up to -20 V and desirably up to -10 V. When carrying out controlled-potential electrolysis or potential scanning electrolysis, it is desirable to use also cyclic voltammetry. To this end, use may be made of potentiostats such as those available from Solartron, BAS Inc., Hokuto Denko Corporation and Ivium Technologies.

A preferred electrolysis method is potential scanning in which the potential is increased or decreased with time at a constant rate, and constant current electrolysis in which electrolysis is performed at a constant current irrespective of the time elapsed is also preferred. In the case of potential scanning, it is preferred to set the potential scanning start point to 0 V and scan at a scanning rate of 0.1 to 50 mV/s and more preferably 0.3 to 30 mV/s. Even more preferably, scanning is performed on the negative side at a scanning rate of 0.5 to 5 mV/s. The preferred amount of electricity varies with the pore size, pore density, metal type and thickness of the anodized film. In the case of copper plating, the amount of deposition required W [g] can be calculated by the following formula: Pore area [$\mu$m2] $\times$ height of metal to be filled [$\mu$m] $\times$ electrolysis area [cm$^2$] $\times$ pore density Lpores/$\mu$m$^2$] $\times$ metal density [g/cm$^3$] = W $\times$ 10$^{-4}$ [g]

The amount of deposition W is represented in terms of the number of moles. The necessary number of coulombs can be calculated by multiplying the amount of deposition by the Faraday constant.

The amount of electricity is measured by a coulomb meter and electrolysis is stopped when a necessary number of coulombs has been reached. In this way, a material can be filled to a necessary and sufficient height.

The preferred range of the current density in constant current electrolysis varies with the electrolyte concentration, pore size, pore density and metal type. In the case of copper plating, the current density is preferably from 0.5 to 10 A/dm$^2$ and more preferably from 1 to 5 A/dm$^2$ In the case of gold plating, the current density is preferably from 0.05 to 3 A/dm$^2$ and more preferably from 0.22 to 1 A/dm$^2$. In the case of nickel plating, the current density is preferably from 0.05 to 5 A/dm$^2$ and more preferably from 0.2 to 1.5 A/dm$^2$.

Electrolytic plating can be stopped by measuring the number of coulombs.

In the case of copper for example, assuming that the current efficiency is 100%, the number of coulombs that can be calculated as the amount of electricity per micrometer of anodized film is 46 C/dm$^2$/$\mu$m.

When filling to a height of 50 $\mu$m, electrolysis is stopped at 2300 C/dm$^2$ and the filling height can be determined by SEM or an optical microscope from the fracture surface direction.

A conventionally known plating solution may be used.

More specifically, in cases where copper is to be deposited, an aqueous copper sulfate solution is generally used, but the copper sulfate concentration is preferably at least 0.1 mol/L and more preferably at least 0.4 mol/L. A saturated solution may also be advantageously used. In cases where copper pyrophosphate is used, its concentration is preferably from 0.05 mol/L to 1 mol/L and more preferably from 0.1 mol/L to 0.5 mol/L. It is preferred to add an excess amount of potassium pyrophosphate. The content of the potassium pyrophosphate is preferably at least 0.5 mol/L and more preferably at least 0.7 mol/L. Deposition can be promoted by adding hydrochloric acid to the electrolytic solution. In such a case, the concentration of hydrochloric acid is preferably from 10 to 20 g/L.

In cases where gold is to be deposited, tetrachloroaurate is preferably used in an amount of 0.0005 wt% to 1 w%, and potassium carbonate and hydrochloric acid may be appropriately added. The pH is preferably in a range of 0.1 to 10 and may be adjusted by the amount of additive added.

In cases where nickel is to be deposited, use may be made of known electrolytic solutions as in a sulfuric acid bath, a Watts bath, a chloride bath and a nickel sulfamate bath. The solution temperature is preferably in a range of 25°C to 95°C and more preferably 30°C to 70°C. The current density is preferably in a range of 0.5 to 10 A/dm$^2$ and more preferably 0.8 to 8 A/dm$^2$.

[(3-c) Vapor Deposition Treatment]

In cases where the conductive material is filled into the through micropores by vapor deposition, known vapor deposition processes such as physical vapor deposition (PVD) and chemical vapor deposition (CVD) may be used. The conditions of vapor deposition treatment vary with the object to be treated but a temperature of -40°C to 80°C and a degree of vacuum of not more than 10$^{-3}$ Pa are preferred in terms of the vapor deposition rate and a temperature of -20°C to 60°C and a degree of vacuum of not more than 10$^{-4}$ Pa are more preferred.

For the purpose of uniform filling, a method may also be advantageously used in which the surface of the insulating substrate is appropriately inclined with respect to the direction of vapor deposition and vapor deposition is carried out from an oblique direction.

This conductive material filling step yields an anisotropic conductive structure 41 shown in FIG. 7B.

[(4) Surface Planarization Step]

In the anisotropic conductive structure-manufacturing method, the conductive material filling step is preferably followed by the surface planarization step for planarizing the front surface and the back surface of the insulating base. By carrying out the surface planarization step, the front surface and the back surface of the insulating base after the conductive material has been filled can be planarized while removing excess conductive material adhering to the front and back surfaces.

In the surface planarization step, one of the following treatments (4-a) to (4-c) is preferably carried out.

The treatments (4-a) to (4-c) are described below in detail.

(4-a) Treatment by chemical mechanical polishing (CMP).

(4-b) Electrolytic polishing treatment.

(4-c) Ion milling treatment.

[(4-a) Treatment by Chemical Mechanical Polishing (CMP)]

CMP treatment may be carried out using a CMP slurry such as PNANERLITE-7000 available from Fujimi Inc., GPX HSC800 available from Hitachi Chemical Co., Ltd., or CL-1000 available from AGC Seimi Chemical Co., Ltd.

Common mechanical polishing which uses no chemical polishing solution is also suitable. In this case, the structure is lapped with an abrasive cloth with a grit size of 800 to 1500 to adjust the thickness, then polished with a slurry of diamond with a particle size of 1 to 3 $\mu$m, and further polished with a slurry of diamond with a particle size of 0.1 to 0.5 $\mu$m. The structure can be thus mirror finished. The electrode surface is preferably polished to a thickness of 0 $\mu$m to 20 $\mu$m whereas the opening surface is preferably polished to a thickness of 10 $\mu$m to 50 $\mu$m.

Polishing conditions: The rotation speed is preferably from 10 to 100 rpm and more preferably from 20 to 60 rpm. The load is preferably from 0.01 to 0.1 kgf/cm$^2$ and more preferably from 0.02 to 0.08 kgf/cm$^2$.

Typical polishing conditions:

| Polishing | Abrasive cloth | Average particle size of abrasive | Polishing load [kgf/cm$^2$] |
|---|---|---|---|
| Lapping | SiC cloth | 800 to 1500 | 0.04 to 0.1 |
| Polishing | Buff | 0.1 to 2 $\mu$m | 0.01 to 0.08 |

[(4-b) Electrolytic Polishing Treatment]

Examples of electrolytic polishing methods include various methods mentioned in the 6th edition of Aluminum Handbook (Japan Aluminum Association, 2001), pp. 164-165; the method described in US 2,708,655; and the method described in Jitsumu Hyomen Gijutsu (Practice of Surface Technology), Vol. 33, No. 3, pp. 32-38 (1986).

[(4-c) Ion milling treatment]

Ion milling treatment is carried out when more precise polishing than the above-described CMP treatment and electrolytic polishing treatment is necessary and any known technique may be used. Argon ion which is one of general ion species is preferably used.

[(5) Conductive Path-Protruding Step]

In the anisotropic conductive structure-manufacturing method, the surface planarization step is preferably followed by a conductive path-protruding step for forming a structure in which the conductive members protrude from the front surface and back surface of the insulating base.

In the conductive path-protruding step, one of the treatments (5-a) and (5-b) is preferably carried out.

(5-a) Part of the front surface and back surface of the insulating base is removed to form the structure in which the conductive members protrude from the front surface and back surface of the insulating base.

(5-b) A conductive material is deposited on the surfaces of the conductive paths to form the structure in which the conductive members protrude from the front surface and back surface of the insulating base.

In treatment (5-a), the anisotropic conductive structure after the surface planarization step is brought into contact with an aqueous acid solution or an aqueous alkaline solution to dissolve and remove only part of the insulating base at the surfaces of the anisotropic conductive structure to protrude the conductive paths (FIG. 7C).

Treatment (5-a) can be carried out under the same treatment conditions as those of the above-described oxide film dissolution treatment (E) provided the conductive material making up the conductive paths is not dissolved. It is preferred to use an aqueous acid solution or an aqueous alkali solution with which the dissolution rate is readily controlled.

In treatment (5-b), the conductive material is only deposited on the surfaces of the conductive paths 8 shown in FIG. 7B to protrude the conductive paths (FIG. 7D). The conductive material can be deposited by electroless plating or electrodeposition. The conductive material to be deposited may be the same as or different from the one filled in the conductive material filling step.

[Protective Film-Forming Treatment]

In the anisotropic conductive structure-manufacturing method, the micropore size in the insulating base made of alumina changes with time by the hydration with moisture in the air and therefore protective film-forming treatment is preferably carried out before the conductive material filling step.

Illustrative examples of protective films include inorganic protective films containing elemental zirconium and/or elemental silicon, and organic protective films containing a water-insoluble polymer.

The method of forming an elemental zirconium-containing protective film is not subject to any particular limitation, although a commonly used method of treatment involves direct immersion in an aqueous solution in which a zirconium compound is dissolved. From the standpoint of the strength and stability of the protective film, the use of an aqueous solution in which a phosphorus compound has also been dissolved is preferred.

Illustrative examples of the zirconium compound that may be used include zirconium, zirconium fluoride, sodium hexafluorozirconate, calcium hexafluorozirconate, zirconium fluoride, zirconium chloride, zirconium oxychloride, zirconium oxynitrate, zirconium sulfate, zirconium ethoxide, zirconium propoxide, zirconium butoxide, zirconium acetylacetonate, tetrachlorobis(tetrahydrofuran)zirconium, bis(methylcyclopentadienyl)zirconium dichloride, dicyclopentadienylzirconium dichloride and ethylenebis(indenyl)zirconium (IV) dichloride. Of these, sodium hexafluorozirconate is preferred. From the standpoint of the uniformity of the protective film thickness, the concentration of the zirconium compound in the aqueous solution is preferably from 0.01 to 10 wt%, and more preferably from 0.05 to 5 wt%.

Illustrative examples of the phosphorus compound that may be used include phosphoric acid, sodium phosphate, calcium phosphate, sodium hydrogen phosphate and calcium hydrogen phosphate. Of these, sodium hydrogen phosphate is preferred.

From the standpoint of the uniformity of the protective film thickness, the concentration of the zirconium compound in the aqueous solution is preferably from 0.1 to 20 wt%, and more preferably from 0.5 to 10 wt%. The treatment temperature is preferably from 0 to 120°C, and more preferably from 20 to 100°C.

The method of forming a protective film containing elemental silicon is not subject to any particular limitation, although a commonly used method of treatment involves direct immersion in an aqueous solution in which an alkali metal silicate is dissolved.

The thickness of the protective film can be adjusted by varying the ratio between the silicate ingredients silicon dioxide

$SiO_2$ and alkali metal oxide $M_2O$ (generally represented as the molar ratio [$SiO_2$]/[$M_2O$]) and the concentrations thereof in the aqueous solution of an alkali metal silicate.

It is especially preferable here to use sodium or potassium as M.

The molar ratio [$SiO_2$]/[$M_2O$] is preferably from 0.1 to 5.0, and more preferably from 0.5 to 3.0.

The $SiO_2$ content is preferably from 0.1 to 20 wt%, and more preferably from 0.5 to 10 wt%.

The organic protective film is preferably obtained by a method which involves direct immersion in an organic solvent in which a water-insoluble polymer is dissolved, followed by heating treatment to evaporate off only the solvent. Illustrative examples of the water-insoluble polymer include polyvinylidene chloride, poly(meth)acrylonitrile, polysulfone, polyvinyl chloride, polyethylene, polycarbonate, polystyrene, polyamide and cellophane.

Illustrative examples of the organic solvent include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone and toluene.

The concentration is preferably from 0.1 to 50 wt%, and more preferably from 1 to 30 wt%.

The heating temperature during solvent volatilization is preferably from 30 to 300°C, and more preferably from 50 to 200°C.

Following protective film-forming treatment, the anodized film including the protective film has a thickness of preferably from 0.1 to 1000 μm, and more preferably from 1 to 500 μm.

(5) Protective Layer

The conductive member of the present invention may optionally further include a protective layer 76 shown in FIG. 13C. Exemplary protective layers include the bump protective layer 76 for protecting the bumps of the anisotropic conductive structure and a protective layer for protecting the surface of the conductive layer 73.

Commercially available films may be appropriately used as exemplified by an easy release film Cerapeel from Toray Advanced Film Co., Ltd. for use as a commercial protective release sheet and TOYOFLON from Toray Advanced Film Co., Ltd. for use in a printed board. In cases where a photosensitive resin layer is provided, simultaneous laminating is also possible.

(6) Photosensitive Resin Layer

The photosensitive resin layer contains a binder, a polymerizable compound, a photopolymerization initiator, a sensitizer and optionally other components. The photosensitive resin layer may contain at least two sensitizers having maximum absorption wavelengths of 340 to 500 nm.

In the photosensitive resin layer, at least one sensitizer preferably has a maximum absorption wavelength in a wavelength range of less than 405 nm and at least one sensitizer except the above sensitizer preferably has a maximum absorption wavelength in a wavelength range of 405 nm or more.

The photosensitive resin layer preferably contains at least two sensitizers including one having a maximum absorption wavelength in a wavelength range of at least 340 nm but less than 405 nm and one having a maximum absorption wavelength in a wavelength range of at least 405 nm but not more than 500 nm.

In the photosensitive resin layer, the spectral sensitivity attains a maximum value in a wavelength range of 380 to 420 nm, the minimum amount of exposure S capable of pattern formation in a range of 400 to 410 nm is up to 50 $mJ/cm^2$, and the maximum value Smax of the minimum amount of exposure and the minimum value Smin of the minimum amount of exposure in the above wavelength range preferably satisfy the expression Smax / Smin ≤ 1.2 and more preferably satisfy the expression Smax / Smin ≤ 1.1.

At a ratio of Smax/Smin in excess of 1.2, when an exposure device using a plurality of semiconductor elements are employed, a uniform pattern may not be obtained because of sensitivity variations due to differences in the wavelength of the individual semiconductor elements.

The minimum amount of exposure S capable of pattern formation in the range of 400 to 410 nm is preferably up to 50 $mJ/cm^2$, more preferably 30 $mJ/cm^2$, and most preferably 20$mJ/cm^2$.

At a minimum amount of exposure S capable of pattern formation in excess of 50 $mJ/cm^2$, exposure requires more time, which may reduce the productivity.

The photosensitive composition of a photosensitive laminate body in which pattern forming materials are laminated on a substrate to be treated is subjected to measurement of the spectral sensitivity using a spectral sensitivity measuring device according to the method described in Photopolymer Technology (Tsuguo Yamaoka, The Nikkan Kogyo Shinbun, Ltd., 1988, page 262). More specifically, the photosensitive laminate body is irradiated with spectral light from light sources such as a xenon lamp and a tungsten lamp under such settings that the exposure wavelength changes linearly in the direction of horizontal axis and the exposure intensity changes logarithmically in the direction of vertical axis. Then, the photosensitive laminate body is exposed and developed to form a pattern for the sensitivity at each exposure wavelength. The exposure energy capable of pattern formation is calculated from the height of the resulting pattern and a spectral sensitivity curve is prepared by the reciprocal plot of the exposure energy in the vertical axis with respect to the wavelength in the horizontal axis. The maximum peak of the thus prepared spectral sensitivity curve represents the spectral sensitivity.

The minimum amount of exposure capable of pattern formation is determined as exposure energy capable of image formation as calculated from the height of the pattern formed in the above-described spectral sensitivity measurement. The minimum amount of exposure capable of pattern formation means the one capable of forming a pattern under the optimal development conditions determined by changing the development conditions such as the type of developer, development temperature and development time.

The optimal development conditions may be appropriately selected according to the intended use without particular limitation. For example, the condition that a developer at a pH of 8 to 12 is sprayed at a temperature of 25 to 40°C and a pressure of 0.05 to 0.5 MPa to completely remove uncured regions is applied.

(7) Method of Forming Photosensitive Resin Layer

In cases where the photosensitive layer is provided, its type is not particularly limited and a dry film which is easier in handling than a liquid type can be used because of its good flatness. There are negative resists and positive resists, but in general commercially available negative resists are preferred.

In the present invention, a photosensitive composition containing a binder, a polymerizable compound, a photopolymerization initiator and at least two sensitizers having maximum absorption wavelengths in the range of 340 to 500 nm and optionally selected other components may be used to obtain the photosensitive layer on the conductive layer or the anisotropic conductive structure.

The solution of the photosensitive composition is prepared by dissolving, emulsifying or dispersing the materials to be contained in the photosensitive resin layer in water or a solvent.

The solution of the photosensitive composition may be appropriately selected according to the intended use without particular limitation. Examples thereof include alcohols such as methanol, ethanol, n-propanol, isopropanol, n-butanol, sec-butanol and n-hexanol; ketones such as acetone, methyl ethyl ketone, methyl isobutyl ketone, cyclohexanone and diisobutyl ketone; esters such as ethyl acetate, butyl acetate, n-amyl acetate, methyl sulfate, ethyl propionate, dimethyl phthalate, ethyl benzoate and methoxypropyl acetate; aromatic hydrocarbons such as toluene, xylene, benzene and ethylbenzene; halogenated hydrocarbons such as carbon tetrachloride, trichloroethylene, chloroform, 1,1,1-trichloroethane, methylene chloride and monochlorobenzene; ethers such as tetrahydrofuran, diethyl ether, ethylene glycol monomethyl ether, ethylene glycol monoethyl ether and 1-methoxy-2-propanol; dimethylformamide, dimethylacetamide, dimethyl sulfoxide and sulfolane. These may be used singly or in combination of two or more. A known surfactant may be added thereto.

The solution of the photosensitive composition is then applied to the conductive layer or the anisotropic conductive structure and dried to form the photosensitive resin layer, thus enabling the conductive member of the present invention to be prepared.

The coating method used to apply the solution of the photosensitive composition may be appropriately selected according to the intended use without particular limitation and various coating methods may be used as exemplified by spray coating, roll coating, spin coating, slit coating, extrusion coating, curtain coating, die coating, gravure coating, wire bar coating and knife coating.

The drying conditions vary with the respective components contained, and the type and amount of solvent used but the solution of the photosensitive composition is dried at a temperature of 60 to 110°C for about 30 seconds to about 15 minutes.

Since the sensitivity distribution is substantially constant in a wavelength range of 400 to 410 nm, the photosensitive resin layer can be advantageously used to form various patterns by exposure to light in the range of 400 to 410 nm and to form wiring pattern or other permanent pattern. The photosensitive resin layer may be advantageously used particularly to form a circuit board for use in semiconductor testing probe cards.

In another method, the photosensitive resin layer in film form may be laminated on the conductive layer by at least one of application of heat and application of pressure. The heating temperature and the pressure to be applied may be appropriately selected according to the intended use without any particular limitation and, for example, the heating temperature is preferably from 15 to 180°C and more preferably from 60 to 140°C. The pressure to be applied may be appropriately selected according to the intended use without any particular limitation and, for example, the pressure is preferably from 0.1 to 1.0 MPa and more preferably from 0.2 to 0.8 MPa.

There is no particular limitation on the device used to perform at least one of application of heat and application of pressure, and the device may be appropriately selected according to the intended use. An exemplary device that may be preferably used includes a laminator VP-II available from Taisei Laminator Co., Ltd.

(8) Method of Preparing Wiring Circuit by Forming Pattern on Conductive Layer

In patterning by laser ablation, the anisotropic conductive film (ACF) can also be provided with topographic features by the following process: The anisotropic conductive film is stained with alizalin red before filling the micropores with a metal, and subsequent laser irradiation causes the anodized film itself to generate heat to remove part of the anodized film near the surface in an ablative manner. The conductive layer can be thoroughly and uniformly removed by making the laser absorption rate higher than that of the conductive layer.

In patterning by exposure and development, a pattern can be formed by appropriately using conditions recommended by the photosensitive resin manufacturer. A pitch conversion connector of any pitch may be prepared by changing the wiring pattern on both sides. An example of a pattern forming method is described below.

The pattern forming method includes at least an exposure step and appropriately selected other steps. The exposure step is a step in which the photosensitive resin layer in the conductive member of the present invention is exposed to light. Exemplary processes that may be used include digital exposure and analog exposure. Of these, digital exposure is preferred.

There is no particular limitation on the digital exposure and a suitable means may be selected according to the intended use. For example, digital exposure is preferably performed by using light modulated according to control signals generated based on pattern forming information on a pattern to be formed.

Exemplary means that may be used for digital exposure include a light emission means for emitting light, and a light modulation means for modulating light emitted from the light emission means based on information on a pattern to be formed.

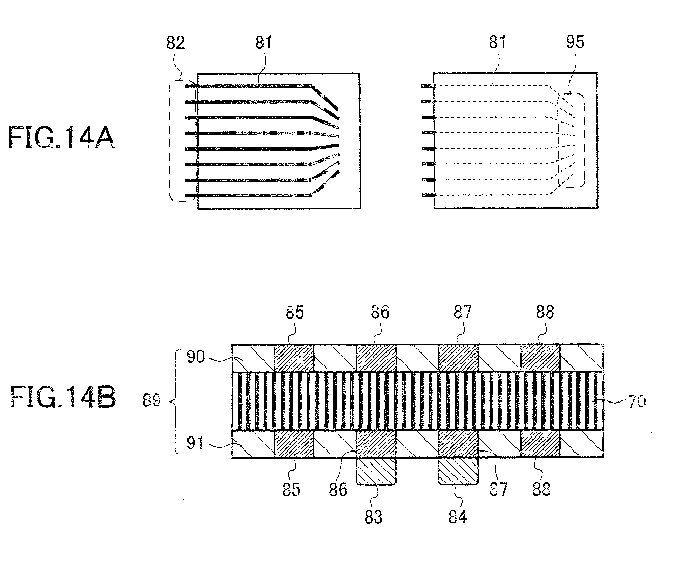

After the pattern formation, a second patterning step which includes further applying a photosensitive resin, exposing in a different pattern and developing is carried out, and contacts with the electrodes formed on the conductive layer can be formed by a known method such as electrolytic deposition or electroless plating. The conductive member of the present invention having such contacts can be utilized as the probe card of the present invention having a circuit board 89 as shown in FIG. 14B. The circuit board for use in a semiconductor testing probe card of the present invention is not limited to the illustrated example.

[Method of Forming Contacts]

Contacts 83 and 84 shown in FIG. 14B are made of conductive materials such as single-metal materials and alloys and can also serve as the electrodes. The contacts can be laminated or coated with a different material to enhance the functionality.

As described in "Handbook of Electrical and Electronic Materials" (first edition, 1987, Asakura Publishing Co., Ltd., pp. 634 to 637), the contact materials are deemed to be consumed at the contacts or transferred to the test object. In general, a material having a higher mechanical strength, a higher boiling point and a lower vapor pressure is less consumed. In consideration of the relation with the minimum arc voltage and the minimum arc current, Fe, Ni, Cu, Zn, Mo, Pb, Ag, W, Pt, Au or alloys thereof are preferred.

Exemplary Pt and Au materials that may be preferably used include Pt, Au-Ag-Pt alloys and Pt-Ir alloys. Exemplary tungsten contact materials that may be preferably used include Ag or Cu sintered alloys and AgWC sintered alloys. Carbon nanotube needles and carbon fiber needles have electrical conductivity and flexibility and are therefore more preferred.

Carbon fiber electrodes are commercially available from, for example, BAS Inc. Kits are also commercially available and electrodes can be easily formed.

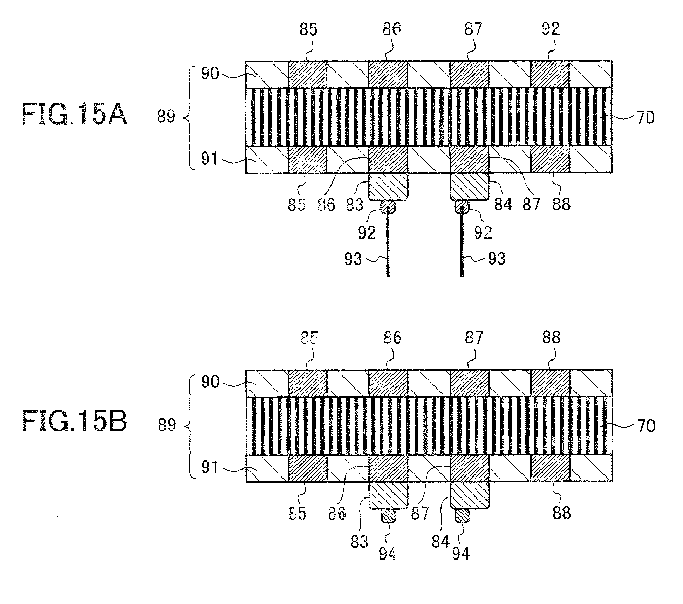

Patterned conductive layers 90, 91 can be obtained, as shown in FIG. 15A, by forming a conductive layer on each surface of the anisotropic conductive structure 70, further forming, for example, the photosensitive resin layer thereon and patterning the photosensitive resin layer by the above-described method. Such a multilayer body can be used as a signal output wiring circuit 89. For example, carbon fiber serving as a carbon fiber electrode 93 can be fixed onto a contact 83 with a conductive adhesive 92. Metals which have high oxidation resistance may also be used as the material of the contact 83. It is also preferred for the Cu contact to be covered with materials having high oxidation resistance such as Ni, Au, W, Pt, Au-Ag-Pt alloys, Pt-Ir alloys, Ag or Cu alloys and AgWC.

Although carbon fibers also have elasticity, the elastic materials used may be rubber materials as described in "Handbook of Electrical and Electronic Materials" (first edition, 1987, Asakura Publishing Co., Ltd., pp. 115 to 129). Of these, silicon rubbers and fluorocarbon rubbers having excellent heat resistance are preferred.

Electric conductivity may be imparted to these elastic materials by dispersing conductive fine particles or a filler therein to obtain a structure of pressure sensitive conductor or coating the surface with a conductive material.

A contact 94 made of a conductive elastic material may also be formed on the contact 83 as shown in FIG. 15B.

Signal output electrodes 85, 86, 87 and 88 and wiring may also be provided at the same positions on the opposite side from the contacts with the test object in the laminate having a circuit pattern formed therein and the resulting conductive member may be used as a probe card.

<Probe Card>

In a wafer test, a chip is connected to a tester (prober, also called "TEG") and voltage is applied to terminals (electrode pads, bonding pads) on the chip according to the test pattern and the output values are measured and compared with the expected value to determine whether the chip is good or not. In this process, it is necessary for the needle called probe to correctly touch the terminal on the chip. The terminal size and spacing are several tens to a hundred of micrometers and one chip has several to several hundreds of terminals. Much more needles are necessary to test a plurality of chips at the same time in order to reduce the testing time. In order for these needles to touch the chips promptly and correctly, the necessary needles are disposed according to the terminal pattern on the chips to obtain a probe card as a set of easy handling. Along with the miniaturization of integrated circuits, the terminal size and spacing tend to decrease (to a minimum of 30 to 50 $\mu$m) and the number of terminals tends to increase. The number of needles in early probe cards had been several to about a hundred, but increased to a thousand and often 5000 or more in around 2000.

Many cards are of a circular shape (there are also rectangular or other shapes). A card has connecting terminals to a tester on the periphery thereof and needles connecting to chips in the center thereof.

There are two needle structures including a structure called a cantilever type (or horizontal type) in which needles are attached horizontally (obliquely downward) from the periphery toward the center and a structure called a vertical type (or spring type; the center of the needle is in a spring shape to generate pressure upon contact) in which needles are attached vertically from the top toward the bottom. The vertical type is more advantageous than the cantilever type in that the former has higher flexibility in the needle layout and can dispose needles not in line but in an array form.

The probe card is attached to a tester called a prober (or a probe tester) and used. In the case of using as the probe card, the contacts are preferably in the shape of a needle and needle tips are preferably coated with a noble metal or a noble metal alloy, or have a hard metal joined thereto.

Conductive polymer materials and pressure sensitive conductive rubbers may also be used for the contacts.

Dense carbon nanotubes may be formed into probe needles.

Method of forming dense carbon nanotubes (described in JP 2000-31462 A).

According to the probe card using the signal output wiring circuit 81 and the probe tester, the conductive member 80 of the present invention as shown in FIG. 10 to FIG. 13 can be used to electrically connect the testing circuit board to the probe needles each of which serves as the carbon fiber electrode 93.

Therefore, electric connection between the testing electrodes of the testing circuit board and the probe needles are reliably achieved by application of low pressure.

In this way, it is not necessary to use a large-sized pressure application means. Since the distance between the testing circuit board and the probe needles is small, the probe tester can be downsized in the height direction. Therefore, the whole of the probe tester can be miniaturized.

Since the pressure applied to the testing electrodes of the testing circuit board is low, the testing electrodes are not damaged, nor is the service life of the testing circuit board shortened. The specified conductive member 80 electrically connects the testing electrodes of the testing circuit board to each other and the testing electrodes can be thus disposed at a high density. Therefore, a large number of testing electrodes can be formed to enable a large number of test electrodes to be collectively tested.

Electric connection through the conductive member has small contact resistance and enables a stable connection state to be achieved to obtain good electrical properties.

The testing electrodes of the testing circuit board are electrically connected to the probe needles through the conductive member and hence the signal transmission system has a small distance. Therefore, a sophisticated integrated circuit requiring high-speed processing can also be subjected to electrical testing.

[Testing Needle]

In general, commercially available probe needles may be appropriately used. For example, probe pins available from Nihon Denshin Co., Ltd. and Tulip Co., Ltd. may be used. In addition, a micro contact probe formed by a LIGA process is described in SEI Technical Review, No. 161, pp. 87-90.

A rod-shaped single crystal probe pin prepared by a VLS process is described in JP 11-190748 A.

A large number of rod-shaped single crystals can be grown by the VLS process on a contact in a substantially vertical direction under position control to form them into a probe pin.

In other words, for example, gold bumps are formed as the contacts. Then, silicon is supplied, for example, by a method of introducing silicon tetrachloride and a gas such as hydrogen under heating conditions, and the rod-shaped silicon single crystals are grown at the positions of the gold bumps in the substantially vertical direction. In other words, contacts having rod-shaped single crystals are formed by the VLS process.

Then, the rod-shaped single crystals are polished so as to have the same length. Electrical conduction is established by a method in which the respective surfaces of the rod-shaped single crystals and the single crystal circuit are coated with a conductive material, thereby obtaining testing needles. The testing needle obtained by the above method has high positional accuracy when used as a probe pin and is made of a silicon single crystal which has the same properties (e.g., coefficient of thermal expansion) as the semiconductor devices, and is suitable for use as a testing needle in a probe card for use in high-density and high-integration semiconductor devices.

EXAMPLES

[Manufacture of Anisotropic Conductive Member]

(A) Mirror-Like Finishing Treatment (Electrolytic Polishing)

A high-purity aluminum substrate (Sumitomo Light Metal Industries, Ltd.; purity, 99.99 wt%; thickness, 0.4 mm) was cut to a size of 10 cm square that allows it to be anodized, then subjected to electrolytic polishing using an electrolytic polishing solution of the composition indicated below at a voltage of 25 V, a solution temperature of 65°C, and a solution flow velocity of 3.0 m/min.
A carbon electrode was used as the cathode, and a GP0110-30R unit (Takasago, Ltd.) was used as the power supply. In addition, the flow velocity of the electrolytic solution was measured using the vortex flow monitor FLM22-10PCW manufactured by As One Corporation.
| | |
|---|---|
| (Electrolytic Polishing Solution Composition) 85 wt% Phosphoric acid (Wako Pure Chemical Industries, Ltd.) | 660 mL |
| Pure water | 160 mL |
| Sulfuric acid | 150 mL |
| Ethylene glycol | 30 mL |

(B) Anodizing Treatment Step (Self-Ordering Method I)

The aluminum substrate having undergone electrolytic polishing was then subjected to 10 hours of preliminary anodizing treatment with an electrolytic solution of 0.5 mol/L oxalic acid under the following conditions: voltage, 40 V; solution temperature, 15°C; solution flow velocity, 3.0 m/min.
After preliminary anodizing treatment, the aluminum substrate was subjected to film removal treatment in which it was immersed for 12 hours in a mixed aqueous solution (solution temperature, 50°C) of 0.2 mol/L chromic anhydride and 0.6 mol/L phosphoric acid.
Next, the aluminum substrate was subjected to 15 hours of re-anodizing treatment with an electrolytic solution of 0.5 mol/L oxalic acid under the following conditions: voltage, 40 V; solution temperature, 15°C; solution flow velocity, 3.0 m/min.
Preliminary anodizing treatment and re-anodizing treatment were both carried out using a stainless steel electrode as the cathode and using a GP0110-30R unit (Takasago, Ltd.) as the power supply. Use was made of NeoCool BD36 (Yamato Scientific Co., Ltd.) as the cooling system, and Pairstirrer PS-100 (Tokyo Rikakikai Co., Ltd.) as the stirring and warming unit. In addition, the flow velocity of the electrolytic solution was measured using the vortex flow monitor FLM22-10PCW (As One Corporation).

(C) Perforating treatment step

Then, the aluminum substrate was dissolved by immersion in a 20% aqueous hydrochloric acid solution with containing a 0.1 mol/L copper chloride, until removal of aluminum was visually confirmed at 15°C. The anodized film was further immersed in 5 wt% phosphoric acid at 30°C for 30 minutes to remove the bottom of the anodized film to thereby prepare a structure (insulating base) made up of an anodized film having micropores with enlarged diameters. The structure having undergone perforating treatment had a thickness of 120 μm.

(D) Heating treatment

Then, the structure obtained as above was subjected to one hour of heating treatment at a temperature of 400°C.

(E) Metal filling treatment step

Then, gold was vapor-deposited on one surface of the heat-treated structure to a thickness of 0.1 $\mu$m to form a gold electrode. Electrolytic plating was carried out by using the gold electrode as the cathode and copper as the anode. Direct current electrolysis was carried out by using as the electrolytic solution a saturated solution containing 600 g/L of copper sulfate kept at 60°C to prepare a structure having micropores filled with copper. Direct current electrolysis was carried out by using a plating device available from YAMAMOTO-MS Co., Ltd. and a potentiostat/galvanostat (Model 7060) available from AMEL. The standard electrode used was of Ag/AgCl type. Electrolysis was carried out at the following condition. Sweep the anode (Cu) potential 0V (vs Ag/Agcl) to negative side, with sweep rate: 1 mV/sec, until the total amount of electricity was 4000 c/dm$^2$.
The fracture surface of the structure having undergone metal filling treatment was observed with an optical microscope and copper was found to be filled into the micropores to an amount corresponding to a height from the gold electrode side of about 70 $\mu$m.

(F) Surface Planarization Treatment

Then, surface planarization treatment was carried out to polish the surface on the gold electrode side of the structure having undergone metal filling treatment to a depth of 10 $\mu$m and the other surface to a depth of 60 $\mu$m. More specifically, the structure was lapped with a silicon carbide sheet (having a grit size of 1200) as the abrasive, then polished with a slurry of diamond having a particle size of 2 $\mu$m and further polished with a slurry of diamond having a particle size of 0.25 $\mu$m to be mirror finished.
The fracture surface of the structure having undergone surface planarization treatment was observed with an optical microscope and the structure was found to be smooth and to have conductive paths (copper) and the insulating base (anodized film) each having a thickness of 50 $\mu$m.

(G)Protrusion-Forming Step

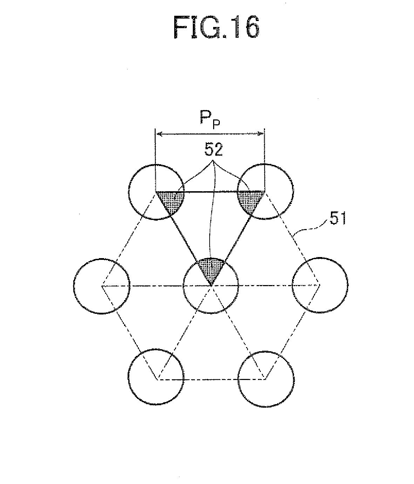

Then, the structure having undergone surface planarization treatment was trimmed for 10 minutes with a 5% aqueous phosphoric acid solution at 40°C.
Thereafter, the structure was rinsed with water and electrolyzed with a mixed aqueous solution of 0.9 mol/L nickel sulfate, 0.99 mol/L nickel chloride and 0.5 mol/L boric acid under the conditions of 40°C, 5 A/dm$^2$ and an amount of electricity of 2C. The fracture surface of the structure after these treatments was observed by FE-SEM and it was found that nickel was deposited on copper to a thickness of 0.1 $\mu$m and the structure was an anisotropic conductive member having protruded conductive paths made of nickel.
A one-minute immersion treatment was carried out at a solution temperature of 80°C by using an electroless plating solution of rhodium (RH-1 available from Okuno Chemical Industries Co., Ltd.). The results of ESCA analysis after the treatment revealed that the deposited nickel was covered with rhodium.
The treatments from the metal filling treatment step (E) to the protrusion-forming step (G) were carried out without bringing the plated portions into contact with air from the start of plating with copper to the end of plating with rhodium. The treatments were carried out continuously.
Then, the structure was rinsed with water, dried and observed by FE-SEM.
As a result, as also shown in Table 1, it was confirmed that the protrusions of the conductive paths had a height of 0.1 $\mu$m, the electrode portion size, that is, the conductive path diameter was 60 nm, and the member had a thickness of 50 $\mu$m. The ratio of the length of the center line of each conductive path to the thickness of the member (length/thickness) was found to be 1.01.
The shape of the resulting anisotropic conductive member is shown in Table 1 below.
A surface image (magnification: 20,000X) of the resulting anisotropic copper conductive member was taken by FE-SEM, and the degree of ordering of micropores, as defined by above formula (i), was measured in a 2 $\mu$m $\times$ 2 $\mu$m field. The degree of ordering was measured in ten places, and the average of the measurements was calculated.
The period refers to the center to center distance between neighboring conductive paths. A surface image (magnification: 50,000X) of the resulting anisotropic copper conductive member (film) was taken by FE-SEM, and measurements were taken at 50 points. The average of those measurements was given as the pitch.
The density was determined according to the formula shown below, which assumes that, as shown in FIG. 16, one-half of a conductive electrode portion 52 lies within a unit lattice 51 of micropores arranged so that the degree of ordering, as defined by above formula (i), is 50% or more. In the following formula, Pp represents the period in micrometers.
$$\text{Density [conductive paths/}\mu\text{m}^2] = (1/2)/\{P_p\ (\mu\text{m}) \times P_p\ (\mu\text{m})$$

$$\times \sqrt{3} \times (1/2)\}$$

Table 1

| Degree of ordering (%) | Period (nm) | Density (conductive paths/mm²) | Electrode portion size | Protrusion height | Thickness (μm) | Length/ thickness |
|---|---|---|---|---|---|---|
| 92 | 63 | about $1.5 \times 10^8$ | Diameter: 60 nm | 0.1 μm | 50 | 1.01 |

(Examples 1-1 to 1-12)

A thermocompression bonding device (MODEL6000 manufactured by HiSOL Inc.) was used to bond the anisotropic conductive member obtained above to the testing circuit board shown in Table 2 below by thermocompression at a temperature of 300°C and a pressure of 0.6 MPa.
Then, probe needles (number of needles: 50; region 10 cm; pitch between neighboring tips: 2 mm, proximal end surface size: 500 μmø) fixed by the fixing holder shown in Table 2 was brought into contact with the anisotropic conductive member to prepare a probe card.

(Comparative Examples 1-1 to 1-4)

A thermocompression bonding device (MODEL6000 manufactured by HiSOL Inc.) was used to bond a commercially available anisotropic conductive member (ANISOLM AC-4000 from Hitachi Chemical Co., Ltd.) to the testing circuit board shown in Table 2 below by thermocompression at a temperature of 180°C and a pressure of 0.4 MPa.
Then, probe needles (number of needles: 50; region: 10 cm; pitch between neighboring tips: 2 mm, proximal end surface size: 500 μmø) fixed by the fixing holder shown in Table 2 was brought into contact with the anisotropic conductive member to prepare a probe card.
The anisotropic conductive member (ANISOLM AC-4000 available from Hitachi Chemical Co., Ltd.) used in Comparative Examples 1-1 to 1-4 had conductive portions obtained by filling an insulating elastic polymer material with conductive particles and electrical conduction could be established when the conductive portions were compressed vertically.

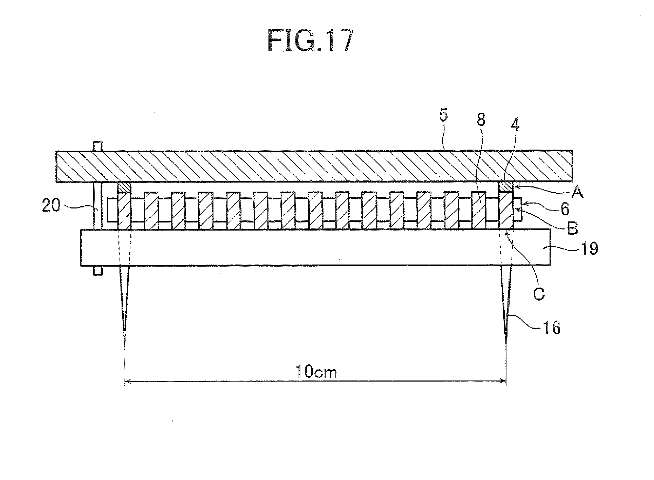

FIG. 17 is a schematic cross-sectional view illustrating how the testing electrodes, the anisotropic conductive member and the probe needles of the probe card used in Examples and Comparative Examples are in contact with (are joined to) each other.
In Examples and Comparative Examples, the probe card as shown in FIG. 17 was used in which 50 probe needles were fixed by the fixing holder 19 connected on one side to the testing circuit board 5 via the fixing member 20 and were spaced uniformly so that the distance between the outermost probe needles was 10 cm.

<Conductivity>

The conductivity of each probe card prepared was determined before testing the electrical properties of the test object.
More specifically, a conductivity test was conducted by bringing the tips of the needles of each probe card prepared into contact with a gold ribbon (AU-170324; size: 0.10 mm $\times$ 2.0 mm $\times$ 500 mm; purity: 99.95%; The Nilaco Corporation).
The conductivity was determined as follows: The electrical resistance was measured with a milliohm meter by the four-terminal method and the specific resistance was determined from the size of the gold ribbon and the distance between the outermost probe needles (10 cm).
According to "Handbook of Electrical and Electronic Materials" (first edition, 1987, Asakura Publishing Co., Ltd., page 597), the specific resistance (ρ) of gold is as follows:

$$\rho = 2.21 \times 10^{-8}\ [\Omega \cdot m]\ (20°C)$$

$$\rho = 3.57 \times 10^{-8} \; [\Omega \cdot m] \; (150°C)$$

A sample having specific resistance values from one to five times those of the literature was rated "good", a sample having specific resistance values from exceeding five times to ten times those of the literature was rated "fair" and a sample having specific resistance values exceeding ten times those of the literature was rated "poor." The results are shown in Table 2.

<Positional Displacement>

In the respective probe cards prepared, the positional displacements between the testing electrodes and the conductive paths of the anisotropic conductive member (between A and B in FIG. 17) and the positional displacements between the conductive paths of the anisotropic conductive member and the probe needles (between B and C in FIG. 17) were checked.

More specifically, each probe card was put on a hot plate (HTP452AA available from AS ONE Corporation). The contact spacing dr [$\mu$m] before heating (25°C) and the contact spacing dh [$\mu$m] upon heating (125°C) were measured and the contact displacement was calculated from the difference therebetween.

$$\text{Contact displacement [mm]} = dh - dr$$

The contact spacing was measured with a digital scanning microscope (NRM-D-2XZ, measurement range: X-axis: 0 to 200 mm; Z-axis: 0 to 150 mm; minimum readings: liquid-crystal digital 0.01 mm).
Table 2

| | | Testing circuit board | Anisotropic conductive member | Fixing holder | Conductivity test | | Positional displacement of probe needle ($\mu$m) | |
|---|---|---|---|---|---|---|---|---|
| | | | | | Room temperature | 150°C | Between A and B | Between B and C |
| Example | 1-1 | Si wafer | Prepared in Example | A-479 | Good | Good | 0 | 0 |
| | 1-2 | SC-211 | | A-479 | Good | Good | 0 | 0 |
| | 1-3 | A-479 | | A-479 | Good | Good | 0 | 0 |
| | 1-4 | FR-4 | | A-479 | Good | Good | 10 | 0 |
| | 1-5 | Si wafer | | SC211 | Good | Good | 0 | 0 |
| | 1-6 | SC-211 | | SC211 | Good | Good | 0 | 0 |
| | 1-7 | A-479 | | SC211 | Good | Good | 0 | 0 |
| | 1-8 | FR-4 | | SC211 | Good | Good | 10 | 0 |
| | 1-9 | Si wafer | | KM2000 | Good | Good | 0 | 10 |
| | 1-10 | SC-211 | | KM2000 | Good | Good | 0 | 10 |
| | 1-11 | A-479 | | KM2000 | Good | Good | 0 | 10 |
| | 1-12 | FR-4 | | KM2000 | Good | Good | 0 | 10 |
| Comparative Example | 1-1 | Si wafer | Commercially available | A-479 | Fair | Poor | 20 | 10 |
| | 1-2 | SC-211 | | A-479 | Fair | Poor | 20 | 10 |
| | 1-3 | A-479 | | A-479 | Fair | Poor | 20 | 10 |
| | 1-4 | FR-4 | | A-479 | Good | Poor | 10 | 10 |

The materials used for the testing circuit boards and fixing holders in Table 2 and their coefficients of thermal expansion are shown in Table 3 below.
Table 3

| Type | Material | coefficient of thermal expansion [$10^{-6}K^{-1}$] |
|---|---|---|
| Si wafer | Silicon | 2.6 to 3.5 |
| SC-211 from KYOCERA Corp. | Ceramic | 4 |
| A-479 from KYOCERA Corp. | Alumina ceramic | 7.5 |
| FR-4 | Glass cloth, epoxy resin | 13 to 16 |
| KM2000 from KYOCERA Corp. | Phenol resin | 2 |

The probe cards prepared in Example 1-1 and Comparative Example 1-4 were subjected to a heat cycle test at temperatures of -40°C and 125°C (186 cycles over 125 hours).

As a result, in the probe card of Example 1-1, the specific resistance increased at a rate of only 10%, whereas in the probe card of Comparative Example 1-4, the specific resistance increased at a rate of 80%.

These results revealed that, by using as the anisotropic conductive member a specific member which has an insulating base made of an anodized aluminum film having micropores therein and a plurality of conductive paths made up of a conductive material, insulated from one another, and extending through the insulating base in the thickness direction of the insulating base, one end of each of the conductive paths protruding from one side of the insulating base, and the other end of each of the conductive paths protruding from the other side thereof, the probe card has good stability of the connection between the testing electrodes and the test electrodes even after exposure to high temperatures in the burn-in test, and is less susceptible to displacements in the positions of contact between the testing electrodes and the conductive portions or between the conductive portions and the probe needles even after repeated use of the probe card.

The probe card prepared in Example 1-1 was subjected to a heat cycle test at temperatures of -40°C and 125°C (186 cycles over 125 hours).

The resistance values before and after the heat cycle test were measured by the conductivity test. As a result, the resistance value after the heat cycle test was larger by 10% than that before the heat cycle test.

Then, the probe needles of the probe card after the heat cycle test were brought into contact with a chemical absorbent (sheet type (P-110) available from 3M) impregnated with 0.1 N aqueous potassium hydroxide at 25°C for 5 minutes.

The specific resistance after the contact was measured by the above-described conductivity test. As a result, it was found that the rate of increase of the resistance after the heat cycle test was reduced to 5% and the electric activity of the probe needles was restored.

<u>1. Manufacture of Anisotropic Conductive Structure</u>

(Anisotropic Conductive Structure 1)

(A) Mirror-Like Finishing Treatment (Electrolytic Polishing)

A high-purity aluminum substrate (Sumitomo Light Metal Industries, Ltd.; purity, 99.99 wt%; thickness, 0.4 mm) was cut to a size of 10 cm square that allows it to be anodized, then subjected to electrolytic polishing using an electrolytic polishing solution of the composition indicated below at a voltage of 25 V, a solution temperature of 65°C, and a solution flow velocity of 3.0 m/min.

A carbon electrode was used as the cathode, and a GP0110-30R unit (Takasago, Ltd.) was used as the power supply. In addition, the flow velocity of the electrolytic solution was measured using the vortex flow monitor FLM22-10PCN manufactured by As One Corporation.

| | |
|---|---|
| (Electrolytic Polishing Solution Composition) 85 wt% Phosphoric acid (Wako Pure Chemical Industries, Ltd.) | 660 mL |
| Pure water | 160 mL |
| Sulfuric acid | 150 mL |
| Ethylene glycol | 30 mL |

(B) Anodizing Treatment Step (Self-Ordering Method I)

The aluminum substrate having undergone electrolytic polishing was then subjected to 12 hours of preliminary anodizing treatment with 0.3 mol/L of sulfuric acid under the following conditions: voltage, 25 V; solution temperature, 16°C; solution flow velocity, 3.0 m/min.
After preliminary anodizing treatment, the aluminum substrate was subjected to film removal treatment in which it was immersed for 12 hours in a mixed aqueous solution (solution temperature, 50°C) of 0.2 mol/L chromic anhydride and 0.6 mol/L phosphoric acid.
Next, the aluminum substrate was subjected to 10 hours of re-anodizing treatment with 0.3 mol/L of sulfuric acid under the following conditions: voltage, 25 V; solution temperature, 16°C; solution flow velocity, 3.0 m/min.
Preliminary anodizing treatment and re-anodizing treatment were both carried out using a stainless steel electrode as the cathode and using a GP0110-30R unit (Takasago, Ltd.) as the power supply. Use was made of NeoCool BD36 (Yamato Scientific Co., Ltd.) as the cooling system, and Pairstirrer PS-100 (Tokyo Rikakikai Co., Ltd.) as the stirring and warming unit. In addition, the flow velocity of the electrolytic solution was measured using the vortex flow monitor FLM22-10PCW (As One Corporation).

(C) Perforating treatment step

Then, the aluminum substrate was dissolved by immersion in 0.1 M copper chloride + 20% hydrochloric acid at a temperature of 15°C until removal of aluminum was visually confirmed. The anodized film was further immersed in 5 wt% phosphoric acid at 30°C for 30 minutes to remove the bottom of the anodized film and the micropores were simultaneously enlarged to prepare a structure (insulating base) comprising a micropore-bearing anodized film.

(D) Heating treatment

Then, the structure obtained as above was subjected to one hour of heating treatment at a temperature of 400°C.

(E) Conductive material filling step

Then, a gold electrode formed by electroless plating was closely attached to one surface of the structure after the above-described heating treatment and electrolytic plating was carried out using the gold electrode as the cathode and the copper plate as the anode.
A mixed solution containing 600 g/L of copper sulfate was kept at 60°C and used as an electrolytic solution. Electrolysis was carried out at the following condition. Sweep the anode (Cu) potential 0.377 V (vs standard electrode) to negative side, with sweep rate: 1 mV/sec, until the total amount of electricity was 4000 c/dm$^2$. An anisotropic conductive structure comprising an anodized film having conductive paths formed by filling micropores with copper was prepared. The fracture surface was observed with an optical microscope and the micropores were found to be filled to a height of about 70 $\mu$m. The electrolysis device used was a potentiostat/galvanostat Model 7060 available from AMEL. The standard electrode used was of Ag/AgCl type.
The surface of the structure filled with copper was observed with an optical microscope and the copper was found to partially protrude from the surface of the insulating base (anodized film).

(F) Surface planarization step

Then, polishing treatment was carried out on the front and back surfaces of the copper-filled structure.
Polishing condition: rotation speed of 50 rpm.
The structure was lapped, then polished with an abrasive having a grit size of 2 $\mu$m and further polished with an abrasive cloth having a grit size of 0.25 $\mu$m.
| Polishing | Polishing process | Average particle size of abrasive | Polishing load [kgf/cm$^2$] |
|---|---|---|---|
| Lapping | SiC cloth | 1200 | 0.08 |
| Polishing | Buff | 2 $\mu$m $\rightarrow$ 0.25 $\mu$m | 0.02 |

Then, the structure was rinsed with water, dried and observed by FE-SEM. As a result, it was confirmed that the electrode portion size, that is, the conductive path diameter was 60 nm, and the member had a thickness of 50 $\mu$m.

(Anisotropic Conductive Structure 2)

The same method as in the anisotropic conductive structure 1 was repeated except that copper filling was replaced by nickel filling, thereby obtaining the anisotropic conductive structure after the conductive path-protruding step. The thus obtained structure was rinsed with water, dried and observed by FE-SEM.

As a result, it was confirmed that the electrode portion size, that is, the conductive path diameter was 60 nm and the member had a thickness of 50 $\mu$m.

Plating cathodes were formed by Au sputtering on one side of the anisotropic conductive structure and a sulfuric acid bath (containing 0.99 M nickel sulfate and 0.5 M boric acid) was used to fill nickel under the conditions of a temperature of 30°C, a current density of 0.3 A/dm$^2$ and a coulomb number of 4000 C/dm$^2$.

(Anisotropic Conductive Structure 3)

Preliminary anodizing treatment and re-anodizing treatment in the anodizing treatment step B (self-ordering method I) were carried out by using 0.5 mol/L of oxalic acid under the following conditions: voltage, 40V; solution temperature, 16°C; solution flow velocity, 3.0 m/min, and the structure after surface planarization treatment was immersed in 0.1 N KOH for 1 minute to selectively dissolve the anodized film, thereby protruding copper cylinders serving as the conductive paths (conductive path-protruding step).

The structure was rinsed with water, dried and observed by FE-SEM and as a result it was confirmed that the bump height was 40 nm, the electrode portion size, that is, the conductive path diameter was 60 nm and the member had a thickness of 50 $\mu$m.

(Anisotropic Conductive Structure 4)

The same method as in the anisotropic conductive structure 3 was repeated except that the conductive path-protruding step (G) was performed for 1 minute and both surfaces of the anodized film were further treated to protrude the conductive paths from both the surfaces thereof.

The structure was observed by FE-SEM and as a result it was confirmed that the bump height was 40 nm on both sides, the electrode portion size, that is, the conductive path diameter was 60 nm and the member had a thickness of 50 $\mu$m.

2. Formation of Conductive Layer

(Example 2-1-1)

The anisotropic conductive structure 1 was used to vapor-deposit gold by sputtering to form the conductive layer 73, thereby preparing a sample of the conductive member of the present invention as shown in FIG. 10A. A piece of gold wire with a diameter of 0.5 mm and a length of 6 cm was put in a tungsten boat and totally vapor-deposited. More specifically, current was applied from 0 A to 40 A at a rising rate of 1 A/s and held at 40 A for 10 seconds. A commercially available instant adhesive was dropped to peel part of the film and the height of bumps caused by peeling was measured by a commercial roughness meter to determine the thickness of the vapor-deposited film. The thickness was 0.13 $\mu$m.

(Example 2-1-2)

The anisotropic conductive structure 2 was used to vapor-deposit gold as in Example 2-1-1 to prepare a conductive material shown in FIG. 10A.

(Examples 2-2)

The anisotropic conductive structure 1 was bonded to a graphite sheet with an anisotropic conductive adhesive 74 to prepare a sample of the conductive member 80 of the present invention shown in FIG. 10B. A commercially available anisotropic conductive adhesive 3373C from ThreeBond Co., Ltd. was used. An anisotropic conductive adhesive layer was formed on the anisotropic conductive structure 1 by screen printing. Mesh type: stainless screen 80 mesh; emulsifier thickness: 10 $\mu$m; squeegee made of urethane rubber, angle: 60°; drying at 100°C for 15 minutes. The graphite sheet used was PERMA-FOIL[(R)]PF-UHP available from Toyo Tanso Co., Ltd.

(Example 2-3)

A copper foil sheet was bonded by thermocompression to the surfaces of the conductive paths protruding from the anisotropic conductive structure 3 to prepare a sample of the conductive member 80 of the present invention having conductive bumps 75 as shown in FIG. 10C which had conductive bumps 75. Copper foil with a purity of 99.9% and a thickness of 30 μm was used to bond the conductive layer 73 by thermocompression (heat resistant applications, narrow pitch is possible) in a test press (trade name: 300 × 300 available from Kitagawa Seiki Co., Ltd.). The conditions included thermocompression bonding at a temperature of 300°C for 5 minutes. The anisotropic conductive structure 3 was for use in heat resistant applications, had a narrow pitch and sufficiently bonded by thermocompression.

(Example 2-4)

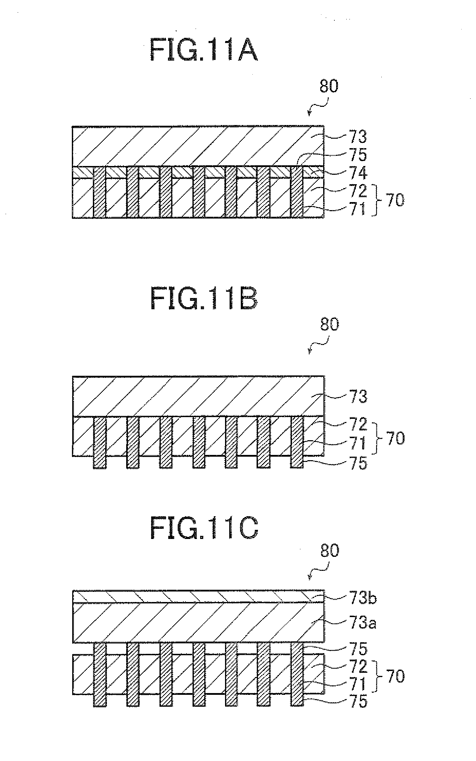

Aluminum foil was bonded with an anisotropic conductive adhesive to the surfaces of the conductive paths protruding from the anisotropic conductive structure 3 to prepare a sample of the conductive member 80 having the conductive bumps 75 as shown in FIG. 11A.
The adhesive used was DOHDENT NH-070A(L) available from Nihon Handa Co., Ltd. A laminator was used to laminate aluminum foil (available from The Nilaco Corporation) on the anisotropic conductive structure 3. Aluminum foil A-013261 with a purity of 99+% available from The Nilaco Corporation was used so as to have a layer thickness of 50 μm.

(Examples 2-5)

The anisotropic conductive structure 3 was used to vapor-deposit copper on the opposite surface from the side on which the conductive path-protruding step had been carried out to thereby form the conductive layer 73, thus preparing a sample of the conductive member of the present invention as shown in FIG. 11B. A piece of gold wire with a diameter of 0.5 mm and a length of 6 cm was put in a tungsten boat and totally vapor-deposited.
More specifically, current was applied from 0 A to 40 A at a rising rate of 1 A/s and held at 40 A for 10 seconds.
A commercially available instant adhesive was dropped to peel part of the film and the height of bumps caused by peeling was measured by a commercial roughness meter to determine the thickness of the vapor-deposited film. The thickness was 0.13 μm.

(Example 2-6)

The anisotropic conductive structure 4 was used to form an underlayer 73a by vapor deposition of nickel and the underlayer 73a was used as the product nucleus to perform substitution plating with a commercially available gold solution to form a gold-plated layer 73b. A sample of the conductive member 80 of the present invention shown in FIG. 11C which had two conductive layers (73a, 73b) was prepared.
A piece of nickel wire with a diameter of 0.5 mm and a length of 6 cm was put in a tungsten boat and totally vapor-deposited. More specifically, current was applied from 0 A to 40 A at a rising rate of 1 A/s and held at 40 A for 10 seconds. A commercially available instant adhesive was dropped to peel part of the film and the height of bumps caused by peeling was measured by a commercial roughness meter to determine the thickness of the vapor-deposited film. The thickness was 0.13 μm.
Gold plating treatment was carried out by a substitution reaction on nickel. Melplate AU-6630 with a thickness of 40 nm available from Meltex Inc. was used.

(Example 2-7)

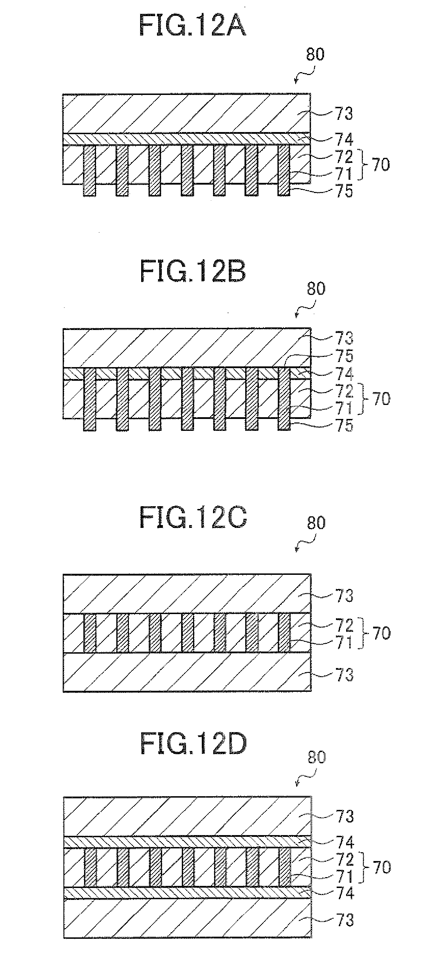

The anisotropic conductive structure 3 was used to bond tungsten foil with the anisotropic conductive adhesive 74 on the opposite surface from the side on which the conductive path-protruding step had been carried out to thereby prepare a sample of the conductive member of the present invention as shown in FIG. 12A. The same type of adhesive as in Example 2-4 was used as the anisotropic conductive adhesive. Tungsten foil W-463261 with a purity of 99.95% available from The Nilaco Corporation was used so as to have a layer thickness of 50 μm.

(Example 2-8)

The anisotropic conductive structure 4 was used to bond copper foil as the conductive layer 73 with the anisotropic conductive adhesive used in Example 2-4, thereby preparing a sample of the conductive member 80 of the present invention as shown in FIG. 12B. The copper foil was the same as used in Example 2-3.

(Example 2-9)

The anisotropic conductive structure 1 was used to vapor-deposit copper to form the conductive layers 73 on both sides, thereby preparing a sample of the conductive member of the present invention as shown in FIG. 12C. Copper was vapor-deposited as in Example 2-5 to a thickness of 0.13 μm.

(Example 2-10)

The anisotropic conductive structure 1 was used and the graphite sheet as the conductive layer 73 was bonded to both surfaces of the anisotropic conductive structure with the same type of anisotropic conductive adhesive as in Example 2-2 to prepare a sample of the conductive member 80 of the present invention shown in FIG. 12D. The graphite sheet was the same type as used in Example 2-2.

(Example 2-11)

The anisotropic conductive structure 4 was used to vapor-deposit copper to form the conductive layers 73 on both sides, thereby preparing a sample of the conductive member of the present invention as shown in FIG. 13A. Copper was vapor-deposited as in Example 2-5 to a thickness of 0.13 μm.

(Example 2-12)

The anisotropic conductive structure 4 was used and the graphite sheet as the conductive layer 73 was bonded to both surfaces of the anisotropic conductive structure with the same type of anisotropic conductive adhesive as in Example 2-2 to prepare a sample of the conductive member 80 of the present invention shown in FIG. 13B. The graphite sheet was the same type as used in Example 2-2.

(Example 2-13)

The anisotropic conductive structure 4 was used but the anodized alumina film was immersed in an aqueous alkali metal silicate solution before the conductive material filling step to thereby perform protective film-forming treatment. As shown in FIG. 13C, the graphite sheet as the conductive layer 73 was bonded to one surface of the anisotropic conductive structure with the anisotropic conductive adhesive 74 as in Example 2-2. A film of photosensitive resin layer 77 was formed thereon.
The photosensitive resin layer was a photosensitive film FRA063 available from DuPont MRC DryFilm Ltd.
On the other hand, a film of bump protective layer 76 was laminated to the other surface of the anisotropic conductive structure by the same process as the photosensitive resin layer. Cerapeel MD (#38, thickness: 50 μm) available from Toray Advanced Film Co., Ltd. was used for the protective layer 76.
A laminator TOLAMI DX-700 was used for lamination and the laminating conditions included a temperature of 100°C and a rate of 0.6 m/min.

(Example 2-14)

Example 2-13 was repeated except that a graphite sheet as the conductive layer 73 was bonded to both surfaces of the anisotropic conductive structure 4 with the anisotropic conductive adhesive 74 as in Example 2-12 to thereby prepare a sample of the conductive member of the present invention having the conductive layers 73 and the photosensitive resin layer 77 as shown in FIG. 13D.

(Example 2-15) Preparation of Probe Card Circuit Board

A 200 μm period, 70μm-square dot pattern mask corresponding to the positions of the probe needles was formed in the photosensitive resin layer 77 of the conductive member of the present invention prepared in Example 2-14. Both surfaces of the anisotropic conductive printed circuit board having the photosensitive resin prepared in Example 2-14 were exposed by a mercury lamp and developed under conditions recommended by the manufacturer.
A 200 μm period, 70 μm-square dot pattern could be formed on both surfaces of the anisotropic conductive structure.
A wire bonding device (model 7400D ultrasonic/thermosonic wedge wire bonder available from HiSOL Inc.) was used to join copper wiring to prepare a wiring circuit on the surface. Signal output lines 81 were formed at the end portion as shown in FIG. 14A. Signal output portions 82 and contact connection portions 95 were prepared at pitches of 500 μm and 200 μm, respectively. FIG. 14B shows a cross-sectional view of the probe card of the present invention. The contacts 83 and 84 show the positions of the probe needles. The signal output wiring circuit 89 having the pattern corresponding to the positions of the probe needles which includes the signal output electrodes 85, 86, 87 and 88 are formed on both surfaces of the anisotropic conductive structure 70.

Industrial Applicability

In the present invention, the above-described probe needle is described as an electric contact connecting the test electrode with the anisotropic conductive member. However, in cases where the probe needle is used, for example, in an embodiment of the probe pin in the probe structure for testing semiconductor devices as described in JP 2002-257898 A, the anisotropic conductive member can also be used as a contact between the test electrode and the probe pin in an embodiment included in the probe card of claim 1.

In cases where the above-described probe needle is used, for example, in an embodiment of the probe pin in the probe card described in JP 11-190748 A, the anisotropic conductive member can also be used as a connector connecting the circuit on the contactor with the wiring circuit on the board (FPC) in an embodiment included in the probe card of claim 1.

**Claims**

1. A probe card which is brought into contact with test electrodes of a test object to test electrical properties of the test object, the probe card comprising:

   a testing circuit board having testing electrodes formed so as to correspond to the test electrodes; and
   an anisotropic conductive member electrically connecting the test electrodes with the testing electrodes,
   wherein the testing electrodes are formed so that at least ends of the testing electrodes protrude from a surface of the testing circuit board, and
   wherein the anisotropic conductive member is a member having an insulating base and a plurality of conductive paths made of a conductive material, insulated from one another, and extending through the insulating base in a thickness direction of the insulating base, one end of each of the conductive paths protruding from one side of the insulating base, and the other end of each of the conductive paths protruding from the other side of the insulating base, and
   wherein the insulating base is a structure composed of an anodized aluminum film having micropores therein.

2. The probe card according to claim 1, further comprising electric contacts for electrically contacting the test electrodes, connection between the test electrodes and the anisotropic conductive member being made via the electric contacts.

3. The probe card according to claim 1, wherein the anisotropic conductive member is formed by using a conductive member in which an anisotropic conductive structure including the anodized film of aluminum and the conductive paths extending through the anodized film in its thickness direction and a conductive layer are laminated and the anisotropic conductive structure and the conductive layer are electrically connected to each other.

4. The probe card according to claims 3 further comprising a photosensitive resin layer on the conductive layer and/or the anisotropic conductive structure.

5. The probe card according to claim 3, wherein the conductive layer has a wiring circuit pattern.

6. The probe card according to claim 2, wherein the electric contacts are probe needles.

7. The probe card according to claim 6, wherein a fixing holder for fixing the probe needles is provided so that both tips of the probe needles protrude from surfaces of the fixing holder.

8. The probe card according to claim 1, wherein the testing circuit board is made of a material with a coefficient of thermal expansion of $2.5 \times 10^{-6}$ to $10 \times 10^{-6} K^{-1}$.

9. The probe card according to claim 1, which is used in the test object made of a material with a coefficient of thermal expansion of $2.5 \times 10^{-6}$ to $10 \times 10^{-6} K^{-1}$.

10. The probe card according to claim 7, wherein the fixing holder is made of a material with a coefficient of thermal expansion of $2.5 \times 10^{-6}$ to $10 \times 10^{-6}K^{-1}$.

11. A testing method using the probe card according to claim 1, comprising:

> a pretreatment step in which protrusions of the conductive paths on a side of contact with the test electrodes are brought into contact with an alkaline aqueous solution or an acidic aqueous solution before testing the electrical properties of the test object; and
> a testing step in which the protrusions after the pretreatment step are brought into contact with the test electrodes to test the electrical properties of the test object.

12. A testing method using the probe card according to claim 2, comprising:

> a pretreatment step in which the electric contacts are brought into contact with an alkaline aqueous solution or an acidic aqueous solution before testing the electrical properties of the test object; and
> a testing step in which the electric contacts after the pretreatment step are brought into contact with the test electrodes to test the electrical properties of the test object.

FIG.1

# FIG.2A

# FIG.2B

# FIG.3A

# FIG.3B

# FIG.4

# FIG.5

FIG.6A

FIG.6B

FIG.6C

FIG.6D

FIG.7A

FIG.7B

FIG.7C

FIG.7D

# FIG.8A

# FIG.8B

# FIG.8C

# FIG.9

FIG.10A

FIG.10B

FIG.10C

# FIG.11A

# FIG.11B

# FIG.11C

## FIG.12A

## FIG.12B

## FIG.12C

## FIG.12D

80

73

FIG.13A

75
72
71 } 70
75
73

80

FIG.13B

73
75
74
72
71 } 70
74
75
73

80

FIG.13C

77

73
75
74
72
71 } 70
75
76

80

FIG.13D

77

73
75
74
72
71 } 70
74
75
73
76

FIG.14A

FIG.14B

FIG.15A

FIG.15B

# FIG.16

# FIG.17

## INTERNATIONAL SEARCH REPORT

| International application No. |
|---|
| PCT/JP2009/054408 |

A. CLASSIFICATION OF SUBJECT MATTER
*G01R1/073*(2006.01)i, *H01R11/01*(2006.01)i

According to International Patent Classification (IPC) or to both national classification and IPC

B. FIELDS SEARCHED

Minimum documentation searched (classification system followed by classification symbols)
G01R1/06-1/073, H01L21/66, H01R11/01

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2000-258495 A (Oki Electric Industry Co., Ltd.), 22 September, 2000 (22.09.00), Par. Nos. [0122] to [0133]; Fig. 25 & JP 2001-015457 A & US 2001/0053170 A1 & US 2002/0030501 A1 & US 2003/0076128 A1 & US 2007/0194802 A1 & TW 449847 B & SG 146414 A | 1-12 |
| Y | JP 4-126307 A (Ricoh Co., Ltd.), 27 April, 1992 (27.04.92), Full text; all drawings & US 5262226 A | 1-12 |

☒ Further documents are listed in the continuation of Box C.     ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 11 June, 2009 (11.06.09) | 23 June, 2009 (23.06.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

## INTERNATIONAL SEARCH REPORT

International application No.

PCT/JP2009/054408

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2000-3741 A (JSR Corp.), 07 January, 2000 (07.01.00), Full text; all drawings (Family: none) | 3-5 |
| Y | JP 2006-349671 A (JSR Corp.), 28 December, 2006 (28.12.06), Par. Nos. [0002], [0019], [0042] & US 2009/0072844 A & EP 1882952 A1 & WO 2006/123772 A1 & KR 10-2008-0015828 A & CN 101180545 A | 8-10 |
| Y | JP 2007-240240 A (Hoya Corp.), 20 September, 2007 (20.09.07), Full text; all drawings (Family: none) | 11-12 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2007225501 A
- JP 2008039768 A
- JP 2000031621 A
- JP 2090622 A
- JP 2098139 A
- JP 5175200 A
- JP 2004289135 A
- JP 3169853 A
- JP 11190748 A
- JP 4126307 A
- US 2708655 A
- JP 10121292 A
- JP 2001105400 A
- JP 2003129288 A
- JP 3266306 A
- JP 4170036 A
- JP 2007332437 A
- JP 2068812 A
- JP 2000031462 A
- JP 2002257898 A

### Non-patent literature cited in the description

- Title: Manufacture of Printed Circuit Board Making Use of Anodization of Aluminum. **Hyomen Kagaku.** Journal of The Surface Science Society of Japan. Takahashi, 2001, vol. 22, 370-375
- Introduction to Manufacture of Printed Circuit Board. The Nikkan Kogyo Shinbun, Ltd, 2004, 151-157
- Aluminum Handbook. Japan Aluminum Association, 2001, 164-165
- *Jitsumu Hyomen Gijutsu,* 1986, vol. 33 (3), 32-38
- Handbook of Electrical and Electronic Materials. Asakura Publishing Co., Ltd, 1987, 634-637
- Handbook of Electrical and Electronic Materials. Asakura Publishing Co., Ltd, 1987, 115-129
- *SEI Technical Review,* 87-90